# EUROPEAN PATENT APPLICATION

(11) **EP 4 395 520 A2**
(43) Date of publication of application: **03.07.2024**
(21) Application number: 23219185.8
(22) Date of filing: 21.12.2023
(51) Int. Cl.: H10K 85/30, H10K 85/60, H10K 50/11, H10K 50/16

(54) **LIGHT-EMITTING DEVICE, ELECTRONIC DEVICE INCLUDING THE SAME, AND ELECTRONIC APPARATUS INCLUDING THE SAME**

(30) Priority: 29.12.2022 KR 20220189634
(71) Applicant: Samsung Display Co., Ltd., Yongin-si, Gyeonggi-do 17113 (KR)
(72) Inventor: Kim, Hoilim, 17113 Yongin-si, Gyeonggi-do (KR); Jung, Hyojoo, 17113 Yongin-si, Gyeonggi-do (KR); Kim, Jihye, 17113 Yongin-si, Gyeonggi-do (KR); Park, Saerom, 17113 Yongin-si, Gyeonggi-do (KR); Yoo, Dongsun, 17113 Yongin-si, Gyeonggi-do (KR); Han, Younho, 17113 Yongin-si, Gyeonggi-do (KR)
(74) Representative: Gulde & Partner

(57) **Abstract**

Provided are a light-emitting device (10), an electronic device including the light-emitting device, and a consumer product including the light-emitting device. The light-emitting device includes a first electrode (110), a second electrode (150) facing the first electrode, and an interlayer (130) disposed between the first electrode and the second electrode, wherein the interlayer includes an emission layer and an electron transport region, wherein the electron transport region is disposed between the emission layer and the second electrode, and the emission layer includes a first emitter, and the electron transport region includes a heterocyclic compound. The descriptions of the first emitter and the heterocyclic compound are the same as described in the present specification.

## Description

### BACKGROUND

### 1. Field

One or more embodiments relate to a light-emitting device, an electronic device including the same, and an electronic apparatus including the same.

### 2. Description of the Related Art

Self-emissive devices (for example, organic light-emitting devices) in light-emitting devices have wide viewing angles, high contrast ratios, short response times, and excellent characteristics in terms of luminance, driving voltage, and response speed.

In a light-emitting device, a first electrode is disposed on a substrate, and a hole transport region, an emission layer, an electron transport region, and a second electrode are sequentially disposed on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. These excitons are transitioned from an excited state to a ground state to thereby generate light.

### SUMMARY

The invention is defined by the appended claims. The description that follows is subjected to this limitation. Any disclosure lying outside the scope of said claims is only intended for illustrative as well as comparative purposes. One or more embodiments include a light-emitting device having a low driving voltage and high power efficiency, an electronic device including the same, and an electronic apparatus including the same.

Additional aspects will be set forth in part in the description which follows and, in part, will be apparent from the description, or may be learned by practice of the presented embodiments of the disclosure.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic view of a light-emitting device according to an embodiment;
FIGS. 2 and 3 are views each schematically showing a structure of a light-emitting electronic device, which is one of electronic devices according to an embodiment; and
FIGS. 4, 5, 6A, 6B, and 6C are diagrams each schematically showing the structure of an electronic apparatus according to an embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

A light-emitting device according to an embodiment includes: a first electrode; a second electrode facing the first electrode; and an interlayer disposed between the first electrode and the second electrode.

The interlayer may include an emission layer and an electron transport region.

The electron transport region may be disposed between the emission layer and the second electrode.

The emission layer may include a first emitter. The first emitter may emit first light having a first emission spectrum.

The emission peak wavelength of the first light (maximum emission wavelength, or maximum emission peak wavelength) may be about 510 nm to about 570 nm.

For example, the emission peak wavelength of the first light may be about 510 nm to about 565 nm, about 510 nm to about 560 nm, about 510 nm to about 555 nm, about 510 nm to about 550 nm, about 510 nm to about 545 nm, about 510 nm to about 540 nm, about 515 nm to about 570 nm, about 515 nm to about 565 nm, about 515 nm to about 560 nm, about 515 nm to about 555 nm, about 515 nm to about 550 nm, about 515 nm to about 545 nm, about 515 nm to about 540 nm, about 520 nm to about 570 nm, about 520 nm to about 565 nm, about 520 nm to about 560 nm, about 520 nm to about 555 nm, about 520 nm to about 550 nm, about 520 nm to about 545 nm, about 520 nm to about 540 nm, about 525 nm to about 570 nm, about 525 nm to about 565 nm, about 525 nm to about 560 nm, about 525 nm to about 555 nm, about 525 nm to about 550 nm, about 525 nm to about 545 nm, or about 525 nm to about 540 nm.

The full width at half maximum (FWHM) of the first light may be 15 nm to 85 nm.

For example, the FWHM of the first light may be about 20 nm to about 85 nm, about 25 nm to about 85 nm, about 30 nm to about 85 nm, about 35 nm to about 85 nm, about 40 nm to about 85 nm, about 45 nm to about 85 nm, about 50 nm to about 85 nm, about 15 nm to about 80 nm, about 20 nm to about 80 nm, about 25 nm to about 80 nm, about 30 nm to about 80 nm, about 35 nm to about 80 nm, about 40 nm to about 80 nm, about 45 nm to about 80 nm, about 50 nm to about 80 nm, about 15 nm to about 75 nm, about 20 nm to about 75 nm, about 25 nm to about 75 nm, about 30 nm to about 75 nm, about 35 nm to about 75 nm, about 40 nm to about 75 nm, about 45 nm to about 75 nm, about 50 nm to about 75 nm, about 15 nm to about 70 nm, about 20 nm to about 70 nm, about 25 nm to about 70 nm, about 30 nm to about 70 nm, about 35 nm to about 70 nm, about 40 nm to about 70 nm, about 45 nm to about 70 nm, about 50 nm to about 70 nm, about 15 nm to about 65 nm, about 20 nm to about 65 nm, about 25 nm to about 65 nm, about 30 nm to about 65 nm, about 35 nm to about 65 nm, about 40 nm to about 65 nm, about 45 nm to about 65 nm, about 50 nm to about 65 nm, about 15 nm to about 60 nm, about 20 nm to about 60 nm, about 25 nm to about 60 nm, about 60 nm to about 60 nm, about 35 nm to about 60 nm, about 40 nm to about 60 nm, about 45 nm to about 60 nm, or about 50 nm to about 60 nm.

The emission peak wavelength (or maximum emission wavelength) and FWHM of the first light described in the present specification may be evaluated from the emission spectrum of a film including the first emitter (for example, see Evaluation Example 2). The emission peak wavelength in the present specification refers to the peak wavelength having the maximum emission intensity in the emission spectrum or electroluminescence spectrum.

The first light may be green light.

The first emitter may include iridium.

In an embodiment, the first emitter may be an organometallic compound containing iridium. The first emitter may be neutral, may include one iridium, and may not include transition metals other than iridium.

In an embodiment, the first emitter may include, in addition to the iridium, a first ligand, a second ligand, and a third ligand, each of which is coupled to the iridium. In this regard, the first ligand may be a bidentate ligand including a Y₁-containing ring B₁ and a Y₂-containing ring B₂, the second ligand may be a bidentate ligand including a Y₃-containing ring B₃ and a Y₄-containing ring B₄, and the third ligand may be a bidentate ligand including a Y₅-containing ring B₅ and a Y₆-containing ring B₆, wherein each of Y₁, Y₃, and Y₅ is nitrogen (N), and each of Y₂, Y₄, and Y₆ is carbon (C).

In an embodiment, the Y₂-containing ring B₂ and the Y4-containing ring B₄ may be different from each other.

In various embodiments, the Y₂-containing ring B₂ may be a polycyclic group. For example, the Y₂-containing ring B₂ may be a polycyclic group in which three or more a monocyclic groups (for example, 3 to 15 a monocyclic groups) are condensed with each other. The monocyclic group may be, for example, a furan group, a thiophene group, a selenophene group, a pyrrole group, a cyclopentadiene group, a silole group, a benzene group, a pyridine group, a pyrimidine group, a pyrazine group, or a pyridazine group. In an embodiment, the Y₂-containing ring B₂ may be a monocyclic group as described above.

In an embodiment, the Y₂-containing ring B₂ may be a polycyclic group in which one 5-membered monocyclic group (for example, a furan group, a thiophene group, a selenophene group, a pyrrole group, a cyclopentadiene group, a silole group, etc.) and at least two 6-membered monocyclic groups (for example, a benzene group, a pyridine group, a pyrimidine group, a pyrazine group, a pyridazine group, etc.) are condensed with each other.

In an embodiment, the Y₄-containing ring B₄ may be a monocyclic group. For example, the Y₄-containing ring B₄ may be a 6-membered monocyclic group (for example, a benzene group, a pyridine group, a pyrimidine group, a pyrazine group, a pyridazine group, a triazine group, etc.).

In an embodiment, the Y₄-containing ring B₄ may be a naphthalene group, a phenanthrene group, or an anthracene group.

In an embodiment, the first emitter may be a homoleptic complex. For example, the first ligand, second ligand and third ligand may be the same as each other.

In an embodiment, the first emitter may be a heteroleptic complex.

In one or more embodiments, two of the ligands may be the same. For example, the third ligand may be identical to the second ligand.

In one or more embodiments, the third ligand may be identical to the first ligand.

In one or more embodiments, the third ligand may be different from each of the first ligand and the second ligand.

More details for the first emitter are as described herein.

The electron transport region may include a heterocyclic compound.

The heterocyclic compound may include:
a first moiety including a group represented by one of Formulae 8-1 to 8-4; and
a second moiety including a diazine group (i.e. a pyrimidine group, a pyrazine group, or a pyridazine group), a triazine group, or a combination thereof.

The first moiety and the second moiety may be linked to each other through a single bond or a first linking group. The description of the first linking group may be the same as provided in connection with *-(Ar₃)ₓ₃-*' in Formula 8 below.

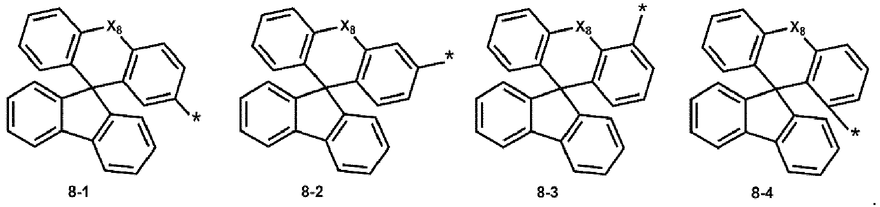

In Formulae 8-1 to 8-4,
X₈ may be O, S, or Se, and
* indicates a binding site to a single bond bonded to the second moiety or a first linking group bonded to the second moiety.

More details for the heterocyclic compound are as described herein.

The light-emitting device may include 1) an emission layer including the first emitter and 2) an electron transport region including the heterocyclic compound, and thus, electrons may be efficiently transferred to the emission layer so that the recombination balance of electrons and holes in the emission layer may be increased. As a result, the light-emitting device has a low driving voltage and high power efficiency. Accordingly, the light-emitting device may enable the manufacture of a high-quality electronic device and a high-quality electronic apparatus.

In an embodiment, from among the color coordinates of light emitted from the light-emitting device, CIEx may be 0.25 to 0.55, 0.30 to 0.49, or 0.31 to 0.49.

In an embodiment, from among the color coordinates of the light emitted from the light-emitting device, ClEy may be 0.45 to 0.70, 0.47 to 0.65, or 0.51 to 0.61.

In an embodiment, the first emitter may include at least one deuterium.

In an embodiment, the first emitter may include a deuterated C₁-C₂₀ alkyl group, a deuterated C₃-C₁₀ cycloalkyl group, or a combination thereof.

In an embodiment, at least one of the first ligand, the second ligand, and the third ligand may include at least one deuterium.

In an embodiment, at least one of the first ligand, the second ligand, and the third ligand may include a deuterated C₁-C₂₀ alkyl group, a deuterated C₃-C₁₀ cycloalkyl group, or a combination thereof.

In an embodiment, the highest occupied molecular orbital (HOMO) energy level of the first emitter may be -5.70 eV to -4.70 eV or -5.52 eV to -4.81 eV.

In an embodiment, the lowest unoccupied molecular orbital (LUMO) energy level of the first emitter may be -2.70 eV to -1.70 eV or -2.68 eV to -1.84 eV.

The HOMO and LUMO energy levels may be evaluated through cyclic voltammetry analysis of the organometallic compound (for example, Evaluation Example 1).

In an embodiment, the percentage of triplet metal-to-ligand charge transfer state (³MLCT) of the total intramolecular charge transfer of the first emitter may be 15% to 40%, or 18.6% to 37.8%.

The percentage of ³MLCT of the first emitter may be evaluated by quantum chemical calculation (for example, see Evaluation Example 1 of the present application).

The emission layer may further include, in addition to the first emitter, a host, an auxiliary dopant, a sensitizer, a delayed fluorescence material, or a combination thereof. Each of the host, the auxiliary dopant, the sensitizer, the delayed fluorescence material, or a combination thereof may include at least one deuterium.

For example, the emission layer may include the first emitter and the host. The host may be different from the first emitter, and the host may include an electron-transporting compound, a hole-transporting compound, a bipolar compound, or a combination thereof. The host may not include metal. The electron-transporting compound, the hole-transporting compound, and the bipolar compound are different from each other.

In an embodiment, the emission layer includes the first emitter and a host, and the host may include an electron-transporting compound and a hole-transporting compound. The electron-transporting compound and the hole-transporting compound may form an exciplex.

For example, the electron-transporting compound may include at least one π electron-deficient nitrogen-containing C₁-C₆₀ cyclic group. For example, the electron-transporting compound may include a pyridine group, a pyrimidine group, a pyrazine group, a pyridazine group, a triazine group, or a combination thereof.

In an embodiment, the hole-transporting compound may include at least one π electron-rich C₃-C₆₀ cyclic group, a pyridine group, or a combination thereof, and may not include an electron-transporting group (for example, a π electron-deficient nitrogen-containing C₁-C₆₀ cyclic group, a cyano group, a sulfoxide group, and a phosphine oxide group, not a pyridine group).

In an embodiment, the following compounds may be excluded from the hole-transporting compound:

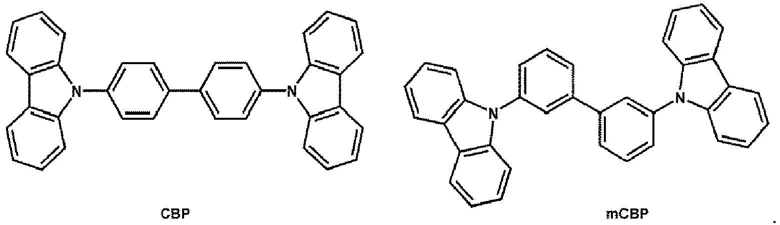

In an embodiment, the electron-transporting compound may include a compound represented by Formula 2-1 or a compound represented by Formula 2-2: 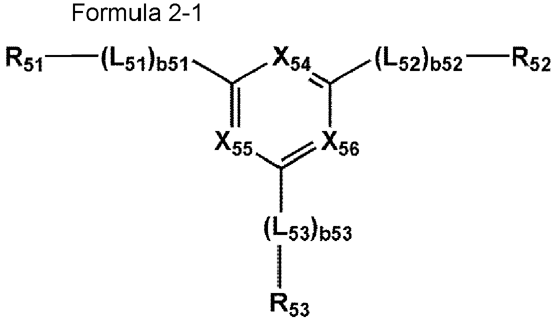 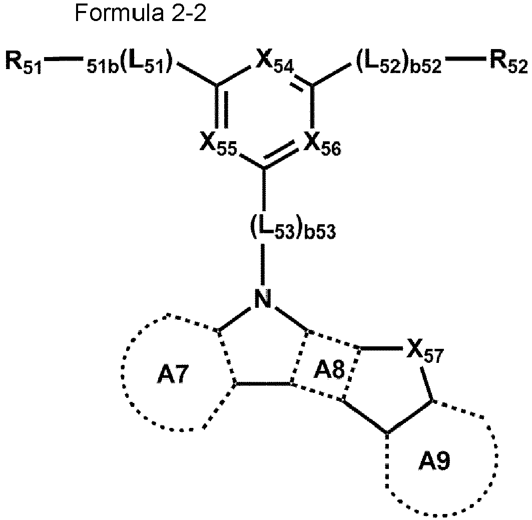
wherein, in Formulae 2-1 and 2-2,
L₅₁ to L₅₃ may each independently be a single bond, a C₃-C₆₀ carbocyclic group unsubstituted or substituted with at least one R₁₀ₐ, or a C₁-C₆₀ heterocyclic group unsubstituted or substituted with at least one R₁₀ₐ,
b51 to b53 may each independently be an integer from 1 to 5,
A7 to A9 may each independently be a C₃-C₆₀ carbocyclic group unsubstituted or substituted with at least one R₁₀ₐ or a C₁-C₆₀ heterocyclic group unsubstituted or substituted with at least one R₁₀ₐ (for example, a benzene group or a naphthalene group, each unsubstituted or substituted with at least one R₁₀ₐ),
X₅₄ may be N or C(R₅₄), X₅₅ may be N or C(R₅₅), X₅₆ may be N or C(R₅₆), and at least one of X₅₄ to X₅₆ may be N,
X₅₇ may be O, S, N(R₅₇), C(R₅₇ₐ)(R_{57b}), or Si(R₅₇ₐ)(R_{57b}), and
R₅₁ to R₅₇, R₅₇ₐ, R_{57b}, and R₁₀ₐ are each the same as described herein.

In an embodiment, the hole-transporting compound may include a compound represented by Formula 3-1, a compound represented by Formula 3-2, a compound represented by Formula 3-3, a compound represented by Formula 3-4, a compound represented by Formula 3-5, or a combination thereof: 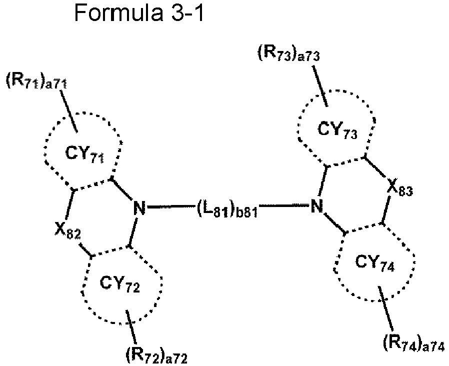 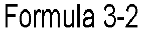 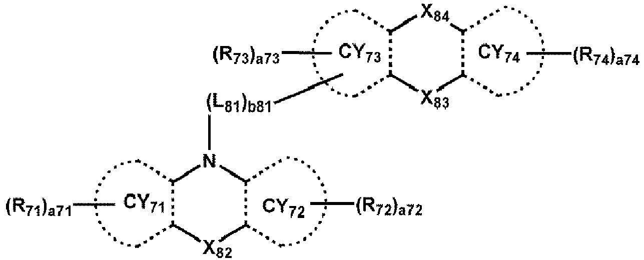 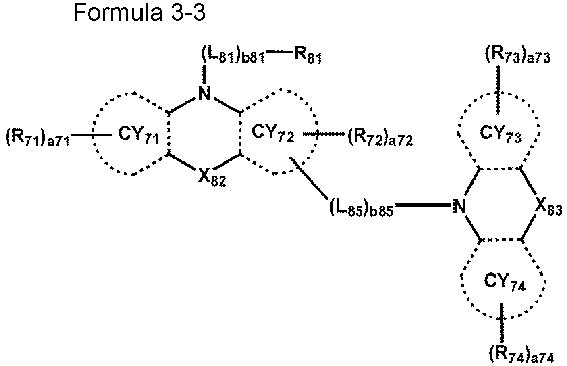 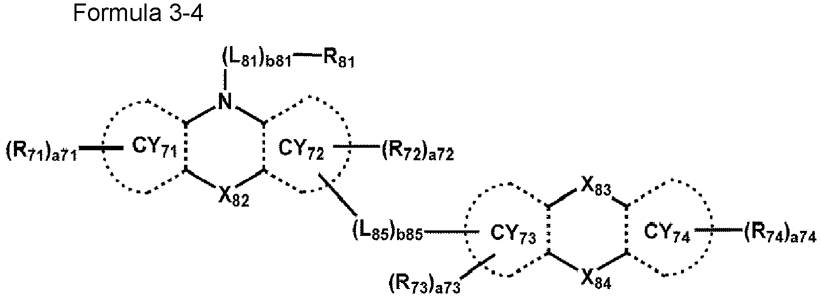 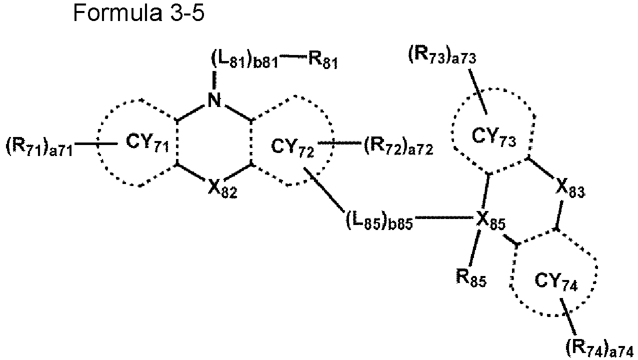
wherein, in Formulae 3-1 to 3-5,
ring CY₇₁ to ring CY₇₄ may each independently be a π electron-rich C₃-C₆₀ cyclic group (for example, a benzene group, a naphthalene group, a fluorene group, an anthracene group, a carbazole group, a dibenzofuran group, or a dibenzothiophene group), or a pyridine group,
X₈₂ may be a single bond, O, S, N-[(L₈₂)_{b82}-R₈₂], C(R₈₂ₐ)(R_{82b}), or Si(R₈₂ₐ)(R_{82b}),
X₈₃ may be a single bond, O, S, N-[(L₈₃)_{b83}-R₈₃], C(R₈₃ₐ)(R_{83b}), or Si(R₈₃ₐ)(R_{83b}),
X₈₄ may be O, S, N-[(L₈₄)_{b84}-R₈₄], C(R₈₄ₐ)(R_{84b}), or Si(R₈₄ₐ)(R_{84b}),
X₈₅ may be C or Si,
L₈₁ to L₈₅ may each independently be a single bond, *-C(Q₄)(Q₅)-*', *-Si(Q₄)(Q₅)-*', a π electron-rich C₃-C₆₀ cyclic group unsubstituted or substituted with at least one R₁₀ₐ (for example, a benzene group, a naphthalene group, a fluorene group, an anthracene group, a carbazole group, a dibenzofuran group, or a dibenzothiophene group, each unsubstituted or substituted with at least one R₁₀ₐ), or a pyridine group unsubstituted or substituted with at least one R₁₀ₐ, wherein Q₄ and Q₅ are the same as described in connection with Q₁,
b81 to b85 may each independently be an integer from 1 to 5,
R₇₁ to R₇₄, R₈₁ to R₈₅, R₈₂ₐ, R_{82b}, R₈₃ₐ, R_{83b}, R₈₄ₐ, and R_{84b} are each the same as described in the present specification,
a71 to a74 may each independently be an integer from 0 to 20, and
R₁₀ₐ may be the same as described herein.

The electron transport region may include a hole-blocking layer, a buffer layer, an electron transport layer, an electron injection layer, or a combination thereof.

In an embodiment, the electron transport region may include an electron transport layer, and the heterocyclic compound may be included in the electron transport layer. The electron transport layer may further include a metal-containing material in addition to the heterocyclic compound. The metal-containing material may be understood by referring to the description provided herein.

In an embodiment, the electron transport layer including the heterocyclic compound may be in direct contact with the emission layer.

In an embodiment, the electron transport region may include a hole-blocking layer and an electron transport layer, the hole-blocking layer may be disposed between the emission layer and the electron transport layer, the hole-blocking layer may not include the heterocyclic compound, and the electron transport layer may include the heterocyclic compound.

The wording "the interlayer (or the electron transport region) includes a first emitter (or includes the heterocyclic compound)" can be interpreted as "the interlayer (or the electron transport region) may include one type of compound belonging to the category of the first emitter or two or more different compounds belonging to the category of the first emitter (or one type of compound belonging to the category of the heterocyclic compound or two or more different compounds belonging to the category of the heterocyclic compound).

The term "interlayer" as used herein refers to a single layer and/or all of a plurality of layers between the first electrode and the second electrode of the light-emitting device.

Another aspect provides an electronic device including the light-emitting device. The electronic device may further include a thin-film transistor. For example, the electronic device may further include a thin-film transistor including a source electrode and a drain electrode, wherein the first electrode of the light-emitting device may be electrically connected to the source electrode or the drain electrode. In an embodiment, the electronic device may further include a color filter, a color conversion layer, a touch screen layer, a polarizing layer, or a combination thereof. For more details on the electronic device, related descriptions provided herein may be referred to.

Another aspect provides an electronic apparatus including the light-emitting device. By using the light-emitting device having an emission layer including the first emitter and an electron transport region including the heterocyclic compound as described in the present specification, the display quality, power consumption, or durability of the electronic apparatus may be improved.

For example, the consumer product may be one of a flat panel display, a curved display, a computer monitor, a medical monitor, a TV, a billboard, indoor or outdoor illuminations and/or signal light, a head-up display, a fully or partially transparent display, a flexible display, a rollable display, a foldable display, a stretchable display, a laser printer, a phone, a cell phone, a tablet, a phablet, a personal digital assistant (PDA), a wearable device, laptop computers, digital cameras, camcorders, viewfinders, micro displays, 3D displays, virtual or augmented reality displays, vehicles, a video wall including multiple displays tiled together, a theater or stadium screen, a phototherapy device, and a signage.

### Description of formulae

The first emitter may be, for example, an organometallic compound represented by Formula 1. In an embodiment, the heterocyclic compound may be, for example, a compound represented by Formula 8:

Formula 1 Ir(L₁)(L₂)(L₃)

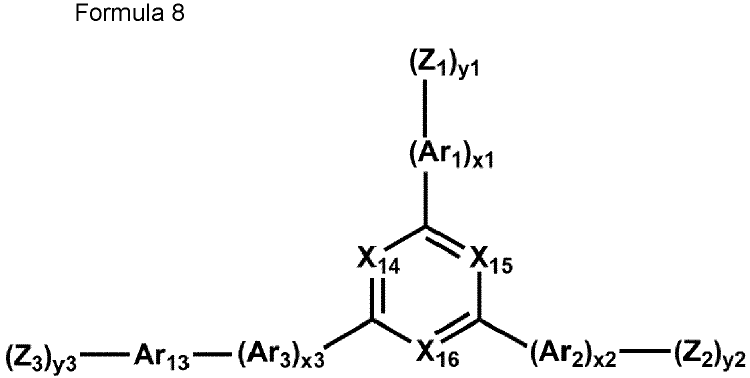

wherein in Formula 1,
L₁ may be a first ligand which is bonded to Ir of Formula 1 and represented by Formula 1-1,
L₂ may be a second ligand which is bonded to Ir in Formula 1 and represented by Formula 1-2, and
L₃ may be a third ligand which is bonded to Ir in Formula 1 and represented by Formula 1-3: 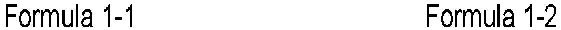 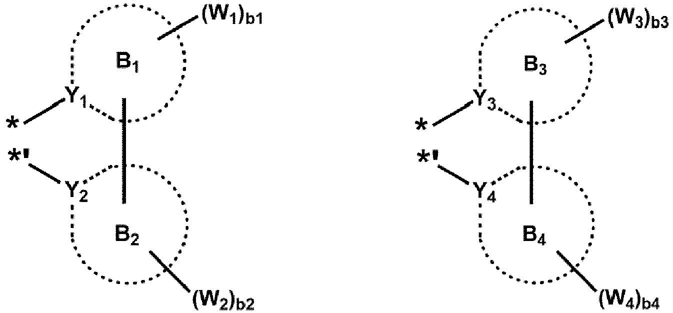 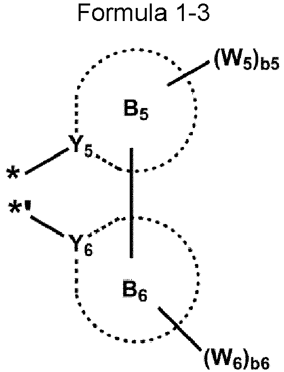
wherein, in Formulae 1-1 to 1-3, and 8,
X₁₄ may be N or C(Z₄), X₁₅ may be N or C(Z₅), and X₁₆ may be N or C(Z₆),
two or more of X₁₄ to X₁₆ may each be N,
each of Y₁, Y₃, and Y₅ may be nitrogen (N),
each of Y₂, Y₄, and Y₆ may be carbon (C),
ring B₁ to ring B₆ may each independently be a C₃-C₆₀ carbocyclic group or a C₁-C₆₀ heterocyclic group,
Ar₁ to Ar₃ may each independently be a C₃-C₆₀ carbocyclic group unsubstituted or substituted with R₁₀ₐ, or a C₁-C₆₀ heterocyclic group unsubstituted or substituted with R₁₀ₐ,
x1 to x3 may each independently be an integer from 0 to 10,
i) when x1 is 0, *-(Ar₁)ₓ₁-*' may be a single bond, ii) when x2 is 0, *-(Ar₂)ₓ₂-*' may be a single bond, and iii) when x3 is 0, *-(Ar₃)ₓ₃-*' may be a single bond, each of * and *' indicates a binding site to a neighboring atom,
Ar₁₃ may be a group represented by one of Formulae 8-1 to 8-4,
W₁ to W₆ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂),
b1 to b6 may each independently be an integer from 0 to 20,
y1 to y3 may each independently be an integer from 0 to 5,
* and *' in Formulae 1-1 to 1-3 may each indicate a binding site to Ir in Formula 1,
i) two groups of W₁(s) in the number of b1, ii) two groups of W₂(s) in the number of b2, iii) two groups of W₃(s) in the number of b3, iv) two groups of W₄(s) in the number of b4, v) two groups of W₃(s) in the number of b5, and vi) two groups of W₆(s) in the number of b6 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, and
R₁₀ₐ may be:
   deuterium, -F, -Cl, -Br, -I, a hydroxyl group, a cyano group, or a nitro group;
   a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), -P(=O)(Q₁₁)(Q₁₂), or a combination thereof;
   a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or a combination thereof; or
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
   wherein Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or a combination thereof: 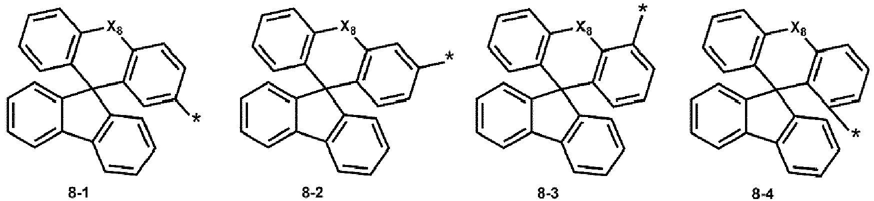
   wherein, in Formulae 8-1 to 8-4,
   X₈ may be O, S, or Se, and
   * indicates a binding site to Ar₃ in Formula 8.
   In an embodiment, the organometallic compound represented by Formula 1 may be a heteroleptic complex.

In one or more embodiments, in Formula 1,
i) L₃ may be identical to L₂,
ii) L₃ may be identical to L₁, or
iii) L₃ may be different from each of L₁ and L₂, or
iv) L₁, L₂ and L₃ may all be identical to each other.

In an embodiment, ring B₁, ring B₃, and ring B₅ may each independently be:
a pyridine group, a pyrimidine group, a pyrazine group, a pyridazine group, or a triazine group; or
a pyridine group, a pyrimidine group, a pyrazine group, a pyridazine group, or a triazine group, to which a cyclopentane group, a cyclohexane group, a norbornane group, a benzene group, a pyridine group, a pyrimidine group, a pyrazine group, a pyridazine group, a triazine group, a furan group, a thiophene group, a selenophene group, a pyrrole group, a cyclopentadiene group, a silole group, or a combination thereof is condensed.

In an embodiment, ring B₁, ring B₃, and ring B₅ may each be a pyridine group.

In an embodiment, ring B₁, ring B₃, and ring B₅ may each independently be:
a benzene group, a pyridine group, a pyrimidine group, a pyrazine group, or a pyridazine group; or
a benzene group, a pyridine group, a pyrimidine group, a pyrazine group, or a pyridazine group, to which a cyclopentane group, a cyclohexane group, a norbornane group, a benzene group, a pyridine group, a pyrimidine group, a pyrazine group, a pyridazine group, a furan group, a thiophene group, a selenophene group, a pyrrole group, a cyclopentadiene group, a silole group, or a combination thereof is condensed.

In an embodiment, ring B₂ may be a benzene group, a pyridine group, a pyrimidine group, a pyrazine group, or a pyridazine group, to which a cyclopentane group, a cyclohexane group, a norbornane group, a benzene group, a pyridine group, a pyrimidine group, a pyrazine group, a pyridazine group, a furan group, a thiophene group, a selenophene group, a pyrrole group, a cyclopentadiene group, a silole group, or a combination thereof is condensed.

In an embodiment, ring B₂ may be a polycyclic group in which one of a furan group, thiophene group, a selenophene group, a pyrrole group, a cyclopentadiene group, and a silole group is condensed with at least two of a benzene group, a pyridine group, a pyrimidine group, a pyrazine group, and a pyridazine group.

In an embodiment, ring B₂ may be a dibenzofuran group, a dibenzothiophene group, a dibenzoselenophene group, a carbazole group, a fluorene group, a dibenzosilole group, a naphthobenzofuran group, a naphthobenzothiophene group, a naphthobenzoselenophene group, a benzocarbazole group, a benzofluorene group, a benzodibenzosilole group, a dinaphthofuran group, a dinaphthothiophene group, a dinaphthoselenophene group, a dibenzocarbazole group, a dibenzofluorene group, a dinaphthosilole group, a phenanthrenonbenzofuran group, a phenanthrenonbenzothiophene group, a phenanthrenobenzoselenophene group, a naphthocarbazole group, a naphthofluorene group, a phenanthrenobenzosilole group, an azadibenzofuran group, an azadibenzothiophene group, an azadibenzoselenophene group, an azacarbazole group, an azafluorene group, an azadibenzosilole group, an azanaphthobenzofuran group, an azanaphthobenzothiophene group, an azanaphthobenzoselenophene group, an azabenzocarbazole group, an azabenzofluorene group, an azabenzodibenzosilole group, an azadinaphthofuran group, an azadinaphthothiophene group, an azadinaphthoselenophene group, an azadibenzocarbazole group, an azadibenzofluorene group, an azadinaphthosilole group, an azaphenanthrenonbenzofuran group, an azaphenanthrenonbenzothiophene group, an azaphenanthrenobenzoselenophene group, an azanaphthocarbazole group, an azanaphthofluorene group, or an azaphenanthrenobenzosilole group.

In an embodiment, ring B₂ may be a dibenzofuran group, a dibenzothiophene group, a dibenzoselenophene group, a naphthobenzofuran group, a naphthobenzothiophene group, a naphthobenzoselenophene group, a dinaphthofuran group, a dinaphthothiophene group, a dinaphthoselenophene group, a phenanthrenonbenzofuran group, a phenanthrenonbenzothiophene group, a phenanthrenonbenzoselenophene group, an azadibenzofuran group, an azadibenzothiophene group, an azadibenzoselenophene group, an azanaphthobenzofuran group, an azanaphthobenzothiophene group, an azanaphthobenzoselenophene group, an azadinaphthofuran group, an azadinaphthothiophene group, an azadinaphthoselenophene group, an azaphenanthrenonbenzofuran group, an azaphenanthrenonbenzothiophene group, or an azaphenanthrenonbenzoselenophene group.

In an embodiment, ring B₄ may be a benzene group, a naphthalene group, a phenanthrene group, an anthracene group, a pyridine group, a pyrimidine group, a pyrazine group, or a pyridazine group.

In an embodiment, ring B₆ may be a benzene group, a naphthalene group, a phenanthrene group, an anthracene group, a pyridine group, a pyrimidine group, a pyrazine group, a pyridazine group, a dibenzofuran group, a dibenzothiophene group, a dibenzoselenophene group, a carbazole group, a fluorene group, a dibenzosilole group, a naphthobenzofuran group, a naphthobenzothiophene group, a naphthobenzoselenophene group, a benzocarbazole group, a benzofluorene group, a benzodibenzosilole group, a dinaphtofuran group, a dinaphthothiophene group, a dinaphthoselenophene group, a dibenzocarbazole group, a dibenzofluorene group, a dinaphthosilole group, a phenanthrenobenzofuran group, a phenanthrenobenzothiophene group, a phenanthrenobenzoselenophene group, a naphthocarbazole group, a naphthofluorene group, a phenansthrenobenzosilole group, an azadibenzofuran group, an azadibenzothiophene group, an azadibenzoselenophene group, an azacarbazole group, an azafluorene group, an azadibenzosilole group, an azanaphthobenzofuran group, an azanaphthobenzothiophene group, an azanaphthobenzoselenophene group , an azabenzocarbazole group, an azabenzofluorene group, an azabenzodibenzosilole group, an azadinaphtofuran group, an azadinaphthothiophene group, an azadinaphthoselenophene group, an azadibenzocarbazole group, an azadibenzofluorene group, an azadinaphthosilole group, an azaphenanthrenobenzofuran group, an azaphenanthrenobenzothiophene group, an azaphenanthrenobenzoselenophene group, an azanaphthocarbazole group, an azanaphthofluorene group, or an azaphenanthrenobenzosilole group.

In an embodiment, Y₂-containing ring B₂ of Formula 1-1 and Y₄-containing ring B₄ of Formula 1-2 may be different from each other.

In an embodiment, Ar₁ to Ar₃ in Formula 8 may each independently be a benzene group, a naphthalene group, a phenanthrene group, an anthracene group, a dibenzofuran group, a dibenzothiophene group, a carbazole group, a fluorene group, or a pyridine group, each unsubstituted or substituted with R₁₀ₐ

x1 to x3 in Formula 8 represent the number of Ar₁ to the number of Ar₃, respectively. When x1 is 2 or greater, two or more of Ar₁ may be identical to or different from each other, when x2 is 2 or greater, two or more of Ar₂ may be identical to or different from each other, and when x3 is 2 or greater, two or more of Ar₃ may be identical to or different from each other. For example, in Formula 8, x1 and x2 may each independently be an integer from 1 to 10, and x3 may be 0, 1 or 2.

In an embodiment, at least one of x1 and x2 in Formula 8 may be 2 or more (for example, 2, 3, 4, or 5).

In an embodiment, in Formula 8, x1 and x2 may each independently be an integer from 1 to 10, x3 may be 0, 1, or 2, Ar₁ to Ar₃ may each independently be a benzene group, a naphthalene group, a phenanthrene group, an anthracene group, a dibenzofuran group, a dibenzothiophene group, a carbazole group, a fluorene group, or a pyridine group, each unsubstituted or substituted with R₁₀ₐ.

In an embodiment, in Formula 8, one or more of Ar₁ in number of x1, one or more of Ar₂ in number of x2, or a combination thereof may each independently be a dibenzofuran group, a dibenzothiophene group, a carbazole group, a fluorene group, or a pyridine group, each unsubstituted or substituted with R₁₀ₐ.

In an embodiment, in Formula 8, one or more of Ar₁ in number of x1, one or more of Ar₂ in number of x2, or a combination thereof may each independently be a dibenzofuran group, a dibenzothiophene group, or a carbazole group, each unsubstituted or substituted with R₁₀ₐ.

Ar₁₃ in Formula 8 may be a group represented by any one of Formulae 8-1 to 8-4, and Z₃ that is not hydrogen may be substituted at any position of Ar₁₃.

In an embodiment, W₁ to W₆ and Z₁ to Z₆ in Formula 1 may each independently be:
hydrogen, deuterium, -F, or a cyano group;
a C₁-C₂₀ alkyl group or a C₃-C₁₀ cycloalkyl group, each unsubstituted or substituted with deuterium, -F, a cyano group, or a combination thereof; or
a phenyl group, a biphenyl group, a naphthyl group, a dibenzofuranyl group, or a dibenzothiophenyl group (or a thienyl group), each unsubstituted or substituted with deuterium, -F, cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₈alkyl)phenyl group, a biphenyl group, a deuterated biphenyl group, a fluorinated biphenyl group, a (C₁-C₂₀ alkyl)biphenyl group, or a combination thereof; or
-Si(Q₁)(Q₂)(Q₃).

In this regard, Q₁ to Q₃ are each the same as described herein.

In an embodiment, at least one of W₁ to W₆, at least one of Z₁ to Z₆, or a combination thereof may include at least one deuterium.

In an embodiment, at least one of W₁ to W₆, at least one of Z₁ to Z₆, or a combination thereof may be a deuterated C₁-C₂₀ alkyl group, or a deuterated C₃-C₁₀ cycloalkyl group.

The term "biphenyl group" as used herein refers to a monovalent substituent having a structure in which two benzene groups are connected to each other through a single bond.

Examples of the C₃-C₁₀ cycloalkyl group as used herein are a cyclopentyl group, a cyclohexyl group, a cycloheptyl group, an adamantanyl group, a norbornanyl group, and the like.

The term "deuterated" as used herein includes the meaning of both fully deuterated and partially deuterated.

The term "fluorinated" as used herein includes the meaning of both fully fluorinated and partially fluorinated.

b1 to b6 in Formula 1 respectively indicate the number of W₁ to the number of W₆, and may each independently be, for example, 0, 1, 2, 3, or 4. When b1 is 2 or more, two or more of W₁ may be identical to or different from each other, when b2 is 2 or more, two or more of W₂ may be identical to or different from each other, when b3 is 2 or more, two or more of W₃ may be identical to or different from each other, when b4 is 2 or more, two or more of W₄ may be identical to or different from each other, when b5 is 2 or more, two or more of W₅ may be identical to or different from each other, and when b6 is 2 or more, two or more of W₆ may be identical to or different from each other.

y1 to y3 in Formula 8 indicate the number of Z₁ to the number of Z₃, respectively, and may be, for example, one of integers from 0 to 5. For example, y1 to y3 may each independently be 0, 1, or 2.

In an embodiment, the first emitter may be an organometallic compound represented by Formula 1A or an organometallic compound represented by Formula 1B:

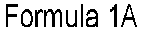

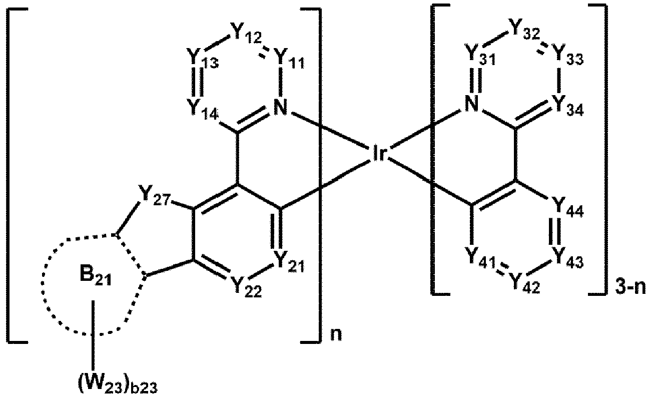

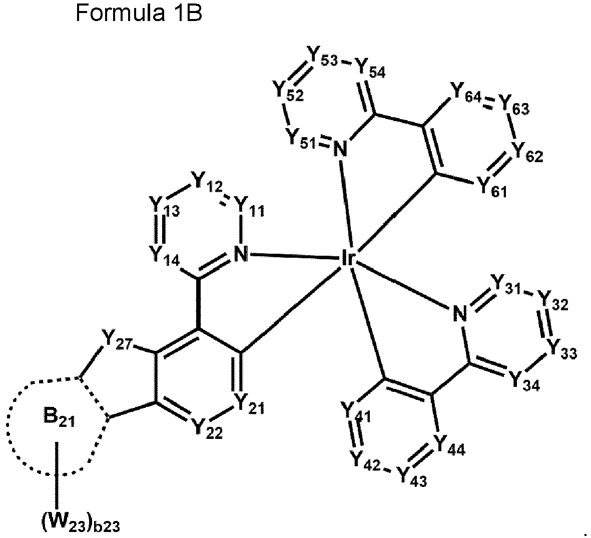

In an embodiment, the first emitter may be an organometallic compound represented by Formula 1A-1, an organometallic compound represented by Formula 1B-1, or an organometallic compound represented by Formula 1C-1: 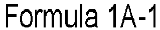 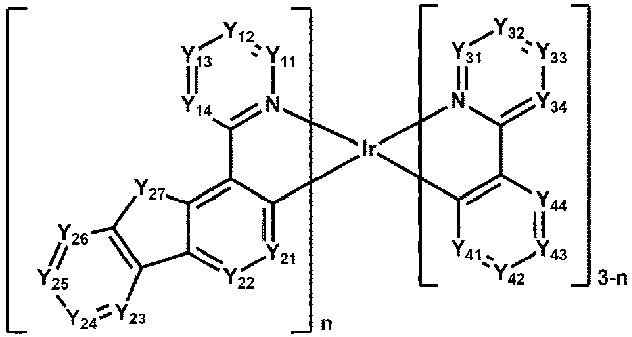 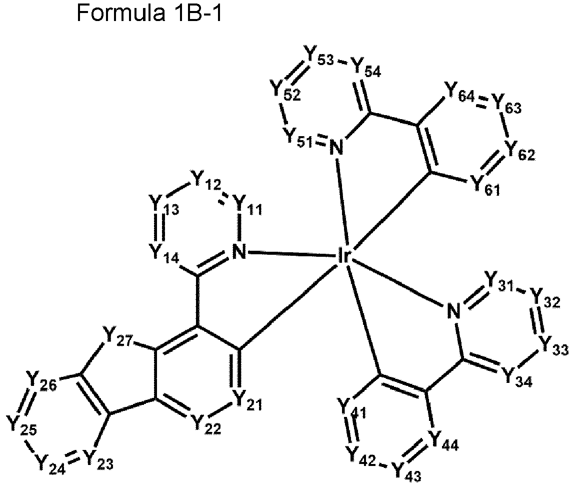 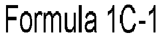 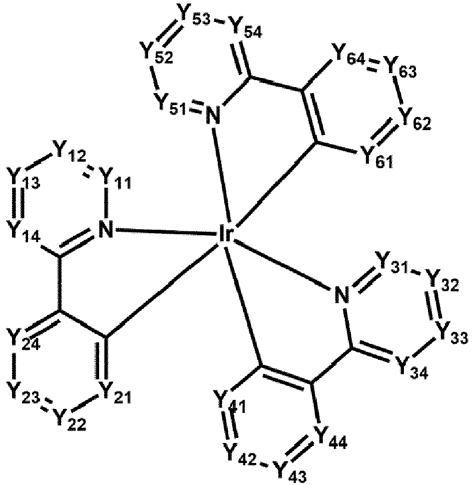
wherein, in Formulae 1A, 1B, 1A-1, 1B-1, and 1C-1,
n may be 1 or 2,
ring B₂₁ may be a C₃-C₆₀ carbocyclic group or C₁-C₆₀ heterocyclic group,
Y₁₁ may be C(W₁₁) or N, Y₁₂ may be C(W₁₂) or N, Y₁₃ may be C(W₁₃) or N, Y₁₄ may be C(W₁₄) or N, Y₂₁ may be C(W₂₁) or N, Y₂₂ may be C(W₂₂) or N, Y₂₃ may be C(W₂₃) or N, Y₂₄ may be C(W₂₄) or N, Y₂₅ may be C(W₂₅) or N, Y₂₆ may be C(W₂₆) or N, Y₃₁ may be C(W₃₁) or N, Y₃₂ may be C(W₃₂) or N, Y₃₃ may be C(W₃₃) or N, Y₃₄ may be C(W₃₄) or N, Y₄₁ may be C(W₄₁) or N, Y₄₂ may be C(W₄₂) or N, Y₄₃ may be C(W₄₃) or N, Y₄₄ may be C(W₄₄) or N, Y₅₁ may be C(W₃₁) or N, Y₅₂ may be C(W₃₂) or N, Y₅₃ may be C(W₅₃) or N, Y₅₄ may be C(W₅₄) or N, Y₆₁ may be C(W₆₁) or N, Y₆₂ may be C(W₃₂) or N, Y₆₃ may be C(W₆₃) or N, Y₆₄ may be C(W₆₄) or N,
Y₂₇ may be O, S, Se, N(W₂₇), C(W₂₇ₐ)(W_{27b}), or C(W₂₇ₐ)(W_{27b}),
W₁₁ to W₁₄ are each the same as described in connection with W₁,
W₂₁ to W₂₇, W₂₇ₐ, and W_{27b} are each the same as described in connection with W₂,
b23 may be an integer from 0 to 20,
W₃₁ to W₃₄ are each the same as described in connection with W₃,
W₄₁ to W₄₄ are each the same as described in connection with W₄,
W₅₁ to W₅₄ are each the same as described in connection with W₅,
W₆₁ to W₆₄ are each the same as described in connection with W₆,
two or more of W₁₁ to W₁₄ may optionally be bonded to each other to form a C₃-C₆₀ carbocyclic group that is unsubstituted or substituted with at least one R₁₀ₐ or a C₁-C₆₀ heterocyclic group that is unsubstituted or substituted with at least one R₁₀ₐ,
two or more of W₂₁ to W₂₇, and W₂₇ₐ and W_{27b} may optionally be bonded to each other to form a C₃-C₆₀ carbocyclic group that is unsubstituted or substituted with at least one R₁₀ₐ or a C₁-C₆₀ heterocyclic group that is unsubstituted or substituted with at least one R₁₀ₐ,
two or more of W₃₁ to W₃₄ may optionally be bonded to each other to form a C₃-C₆₀ carbocyclic group that is unsubstituted or substituted with at least one R₁₀ₐ or a C₁-C₆₀ heterocyclic group that is unsubstituted or substituted with at least one R₁₀ₐ, and
two or more of W₄₁ to W₄₄ may optionally be bonded to each other to form a C₃-C₆₀ carbocyclic group that is unsubstituted or substituted with at least one R₁₀ₐ or a C₁-C₆₀ heterocyclic group that is unsubstituted or substituted with at least one R₁₀ₐ.
two or more of W₅₁ to W₅₄ may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, and
two or more of W₆₁ to W₆₄ may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ.

Since n is 1 or 2 in Formula 1A and 1A-1, Formulae 1A and 1A-1 may correspond to an organometallic compound in which the third ligand in Formula 1 is the same as the second ligand or the first ligand.

The organometallic compound represented by Formula 1B or 1B-1 is an organometallic compound having three different bidentate ligands, and in Formula 1, a third ligand is different from each of a first ligand and a second ligand.

In an embodiment, ring B₂₁ in Formulae 1A and 1B may be a benzene group, a naphthalene group, a phenanthrene group, an anthracene group, a pyridine group, a pyrimidine group, a pyrazine group, a pyridazine group, a quinoline group, an isoquinoline group, a quinoxaline group, a quinazoline group, a benzoquinoline group, a benzoisoquinoline group, a benzoquinoxaline group, or a benzoquinazoline group.

In an embodiment, ring B₂₁ in Formulae 1A and 1B may be a pyridine group, a pyrimidine group, a pyrazine group, a pyridazine group, a quinoline group, an isoquinoline group, a quinoxaline group, a quinazoline group, a benzoquinoline group, a benzoisoquinoline group, a benzoquinoxaline group, or a benzoquinazoline group.

In an embodiment, at least one of Y₂₁ to Y₂₆ in Formulae 1A-1 and 1 B-1 may be N.

In an embodiment, at least one of Y₂₃ to Y₂₆ in Formulae 1A-1 and 1 B-1 may be N.

In an embodiment, Y₂₆ in Formulae 1A-1 and 1B-1 may be N.

In an embodiment, in Formulae 1A-1 and 1B-1, Y₂₁ to Y₂₅ may not be N and Y₂₆ may be N.

In an embodiment, each of Y₁₁ to Y₁₄, Y₂₁, Y₂₂, Y₃₁ to Y₃₄ and Y₄₁ to Y₄₄ in Formulae 1A, 1B, 1A-1 and 1B-1 may not be N.

In an embodiment, each of Y₁₁ to Y₁₄, Y₂₁ to Y₂₄, Y₃₁ to Y₃₄, Y₄₁ to Y₄₄, Y₅₁ to Y₅₄, and Y₆₁ to Y₆₄ in Formula 1C-1 may be C.

In an embodiment, a group represented by 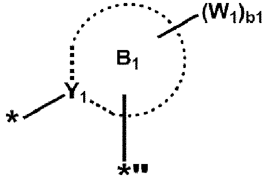 in Formula 1-1, a group represented by 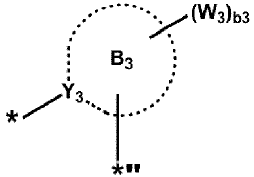 in Formula 1-2, a group represented by 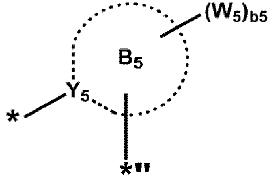 in Formula 1-3, a group represented by 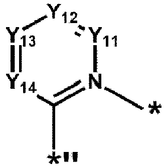 in Formulae 1A, 1B, 1A-1, 1B-1 and 1C-1, a group represented by 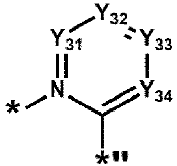 in Formulae 1A, 1B, 1A-1, 1B-1, and 1C-1, and a group represented by 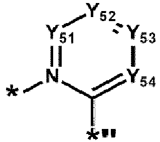 in Formulae 1B, 1B-1, and 1C-1 may each independently be one of groups represented by Formulae BN-1 to BN-16: 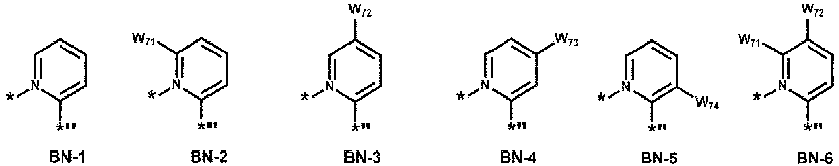 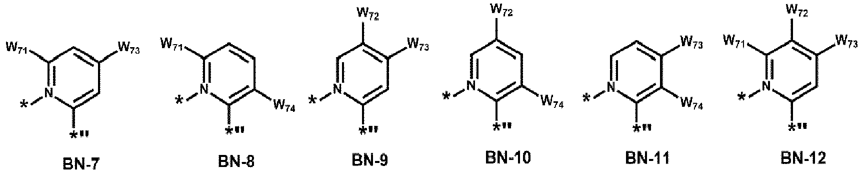 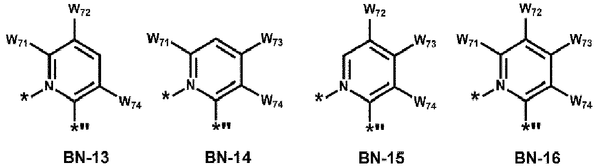
wherein, in Formulae BN-1 to BN-16,
W₇₁ to W₇₄ are each the same as described in connection with W₁, W₃, or W₅, provided that each of W₇₁ to W₇₄ may not be hydrogen,
* indicates a binding site to iridium in Formulae 1, 1A, 1B, 1A-1, 1B-1, and 1C-1, and
*" indicates a binding site to a neighboring atom in Formulae 1, 1A, 1B, 1A-1, 1B-1, and 1C-1.

In an embodiment, a group represented by 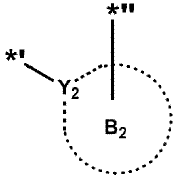 in Formula 1-1, a group represented by 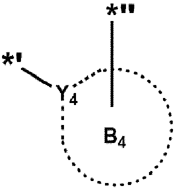 in Formula 1-2, and a group represented by 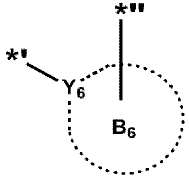 in Formula 1-3 may each independently be one of groups represented by Formulae BC-1 to BC-47: 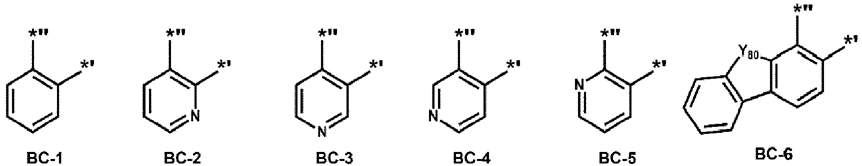 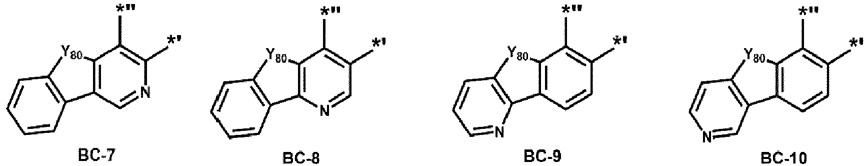 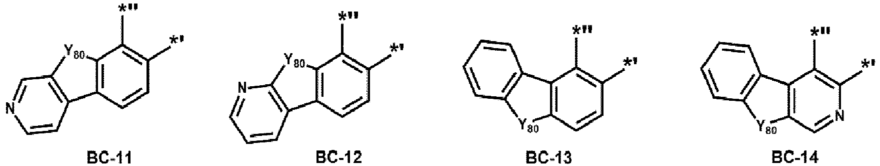 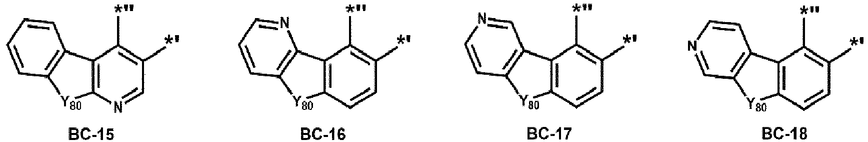 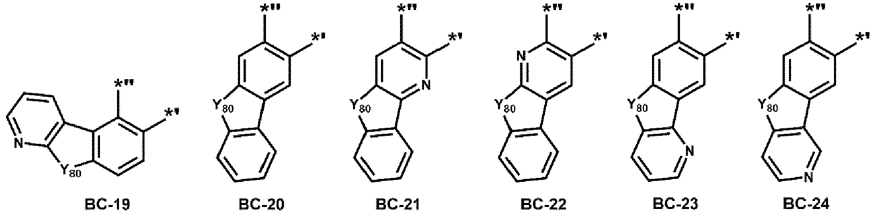 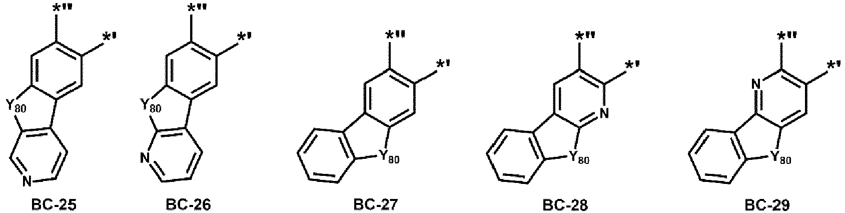 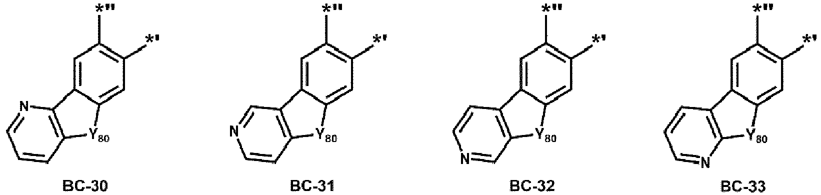 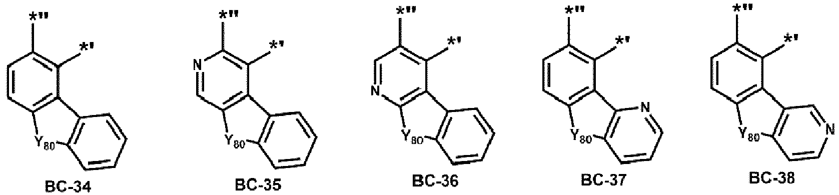 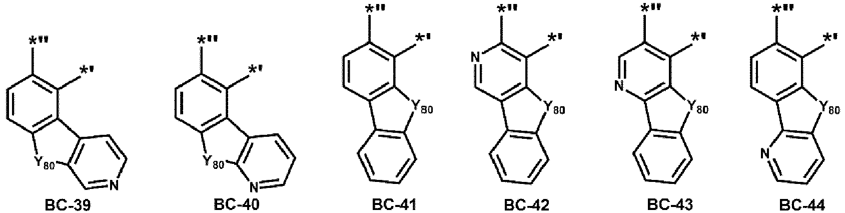 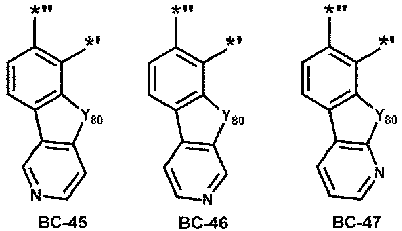
wherein, in Formulae BC-1 to BC-47,
Y₈₀ may be O, S, Se, N(W₈₀), C(W₈₀ₐ)(W_{80b}), or Si(W₈₀ₐ)(W_{80b}),
W₈₀, W₈₀ₐ, and W_{80b} are each the same as described in connection with W₂, W₄, or W₆,
*' indicates a binding site to iridium in Formula 1, and
*" indicates a binding site to a neighboring atom in Formula 1.

Formulae BC-1 to BC-47 may be substituted or unsubstituted with W₂, W₄, or W₆ as described herein, and could be easily understood with reference to the structures of Formulae 1-1, 1-2, and 1-3.

In an embodiment, a group represented by 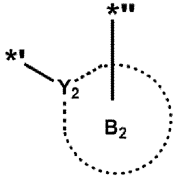 in Formula 1-1 may be one of Formulae BC-6 to BC-47.

In an embodiment, a group represented by 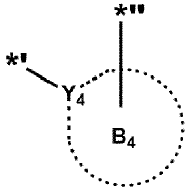 in Formula 1-2 may be represented by one of Formulae BC-1 to BC-5.

b51 to b53 in Formulae 2-1 and 2-2 indicate the number of L₅₁ to the number of L₅₃, respectively, and may each be an integer from 1 to 5. When b51 is 2 or more, two or more of L₅₁(s) may be identical to or different from each other, when b52 is 2 or more, two or more of L₅₂(s) may be identical to or different from each other, and when b53 is 2 or more, two or more of L₅₃(s) may be identical to or different from each other. In an embodiment, b51 to b53 may each independently be 1 or 2.

L₅₁ to L₅₃ in Formulae 2-1 and 2-2 may each independently be
a single bond; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, a oxazole group, a isoxazole group, a thiazole group, an isothiazole group, an oxadiazole group, a thiadiazole group, a benzopyrazole group, a benzimidazole group, a benzoxazole group, a benzothiazole group, a benzooxadiazole group, a benzothiadiazole group, a dibenzooxasiline group, a dibenzothiasiline group, a dibenzodihydroazasiline group, a dibenzodihydrodisiline group, a dibenzodihydrosiline group, a dibenzodioxine group, a dibenzooxathiine group, a dibenzooxazine group, a dibenzopyran group, a dibenzodithiine group, a dibenzothiazine group, a dibenzothiopyran group, a dibenzocyclohexadiene group, a dibenzodihydropyridine group, a dibenzodihydropyrazine group, an indolocarbazole group, an indolodibenzofuran group, or an indolodibenzothiophene group, each unsubstituted or substituted with deuterium, - F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O(Q₃₁), -S(Q₃₁), -Si(Q₃₁)(Q₃₂)(Q₃₃), -N(Q₃₁)(Q₃₂), - B(Q₃₁)(Q₃₂), -P(Q₃₁)(Q₃₂), -C(=O)(Q₃₁), -S(=O)₂(Q₃₁), -P(=O)(Q₃₁)(Q₃₂), or a combination thereof,
Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In Formulae 2-1 and 2-2, X₅₄ may be N or C(R₅₄), X₅₅ may be N or C(R₅₅), X₅₆ may be N or C(R₅₆), and at least one of X₅₄ to X₅₆ may be N. R₅₄ to R₅₆ are the same as described herein. In an embodiment, two or three of X₅₄ to X₅₆ may be N.

R₅₁ to R₅₇, R₅₇ₐ, R_{57b}, R₇₁ to R₇₄, R₈₁ to R₈₅, R₈₂ₐ, R_{82b}, R₈₃ₐ, R_{83b}, R₈₄ₐ, and R_{84b} may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ aryl alkyl group unsubstituted or substituted with at least one R₁₀ₐ, a C₂-C₆₀ heteroaryl alkyl group unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂). Q₁ to Q₃ may each be the same as described herein.

For example, i) R₁ to R₇, Rsa, R_{8b}, R₆ₐ, R_{6b}, R₇ₐ, R_{7b}, R', and R" in Formula 1, ii) R₅₁ to R₅₇, R₅₇ₐ, R_{57b}, R₇₁ to R₇₄, R₈₁ to R₈₅, R₈₂ₐ, R_{82b}, R₈₃ₐ, R_{83b}, R₈₄ₐ, and R_{84b} in Formulae 2-1, 2-2 and 3-1 to 3-5, and iii) R₁₀ₐ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or a combination thereof; or
-C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂),
Q₁ to Q₃ and Q₃₁ to Q₃₃ may each independently be:
   -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or -CD₂CDH₂; or
   an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or a combination thereof: 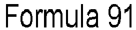 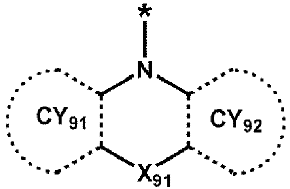
   wherein, in Formula 91,
   ring CY₉₁ and ring CY₉₂ may each independently be a C₅-C₃₀ carbocyclic group unsubstituted or substituted with at least one R₁₀ₐ or a C₁-C₃₀ heterocyclic group unsubstituted or substituted with at least one R₁₀ₐ,
   X₉₁ may be a single bond, O, S, N(R₉₁), B(R₉₁), C(R₉₁ₐ)(R_{91b}), or Si(R₉₁ₐ)(R_{91b}),
   R₉₁, R₉₁ₐ, and R_{91b} may each be the same as described in connection with R₈₂, R₈₂ₐ, and R_{82b}, respectively,
   R₁₀ₐ may be the same as described herein, and
   * indicates a binding site to a neighboring atom.

For example, in Formula 91,
ring CY₉₁ and ring CY₉₂ may each independently be a benzene group, a pyridine group, a pyrimidine group, a pyrazine group, a pyridazine group, or a triazine group, each unsubstituted or substituted with at least one R₁₀ₐ,
R₉₁, R₉₁ₐ, and R_{91b} may each independently be:
   hydrogen or a C₁-C₁₀ alkyl group; or
   a phenyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or a combination thereof.

In an embodiment, i) W₁ to W₆, W₁₁ to W₁₄, W₂₁ to W₂₇, W₂₇ₐ, W_{27b}, W₃₁ to W₃₄, W₄₁ to W₄₄, W₇₁ to W₇₄, W₈₀, W₈₀ₐ and W_{80b} in Formulae 1, 1A, 1B, 1A-1, 1B-1, BN-1 to BN-16, and BC-1 to BC-47, ii) R₅₁ to R₅₇, R₅₇ₐ, R_{57b}, R₇₁ to R₇₄, R₈₁ to R₈₅, R₈₂ₐ, R_{82b}, R₈₃ₐ, R_{83b}, R₈₄ₐ and R_{84b} in Formulae 2-1, 2-2, 3-1 to 3-5, 502b and 503, and iii) R₁₀ₐ may each independently be hydrogen, deuterium, -F, a cyano group, a nitro group, -CH₃, -CD₃, - CD₂H, -CDH₂, -CF₃, -CF₂H, -CFH₂, a group represented by one of Formulae 9-1 to 9-19, a group represented by one of Formulae 10-1 to 10-246, -C(Q₁)(Q₂)(Q₃), -Si(Q₁)(Q₂)(Q₃), or -P(=O)(Q₁)(Q₂) (where Q₁ to Q₃ are each the same as described herein) (provided that each of R₁₀ₐ and W₇₁ to W₇₄ is not hydrogen): 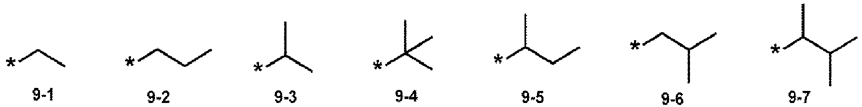 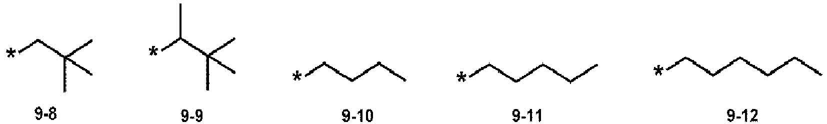 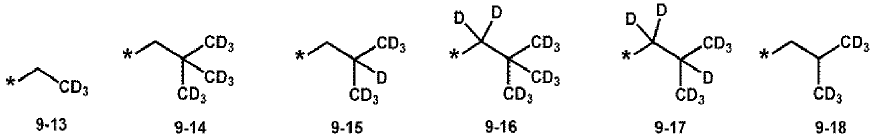 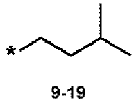 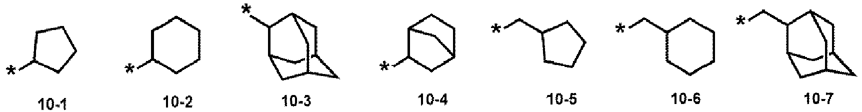 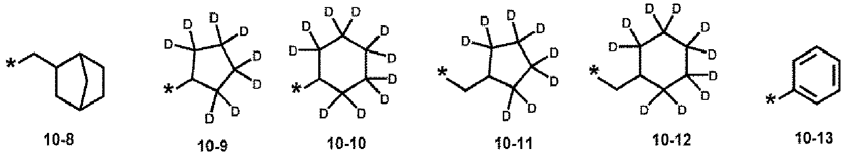 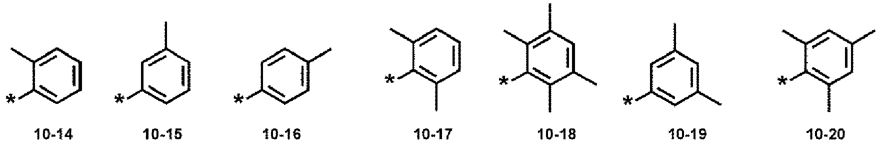 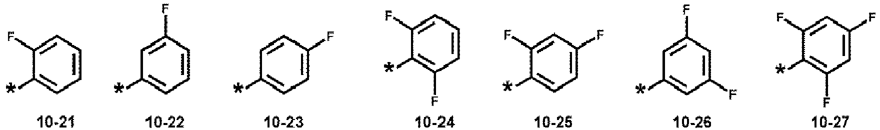 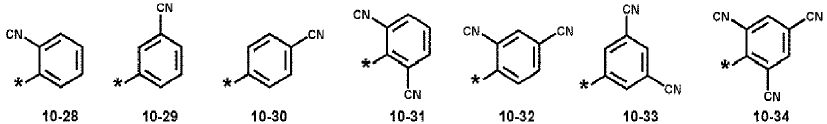 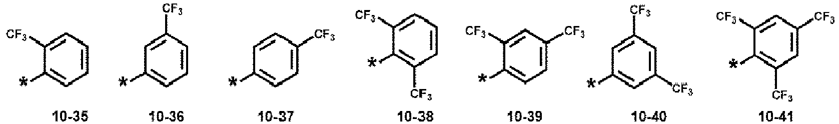 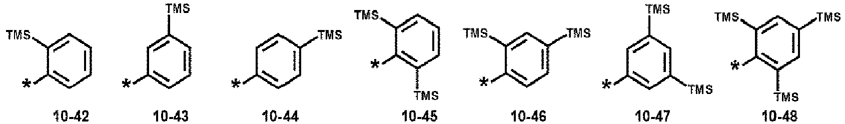 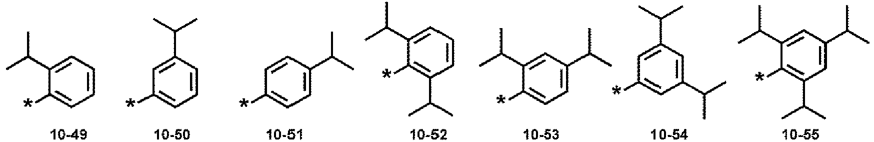 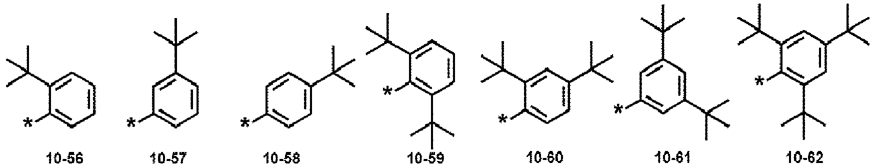 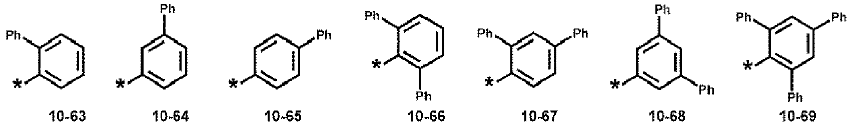 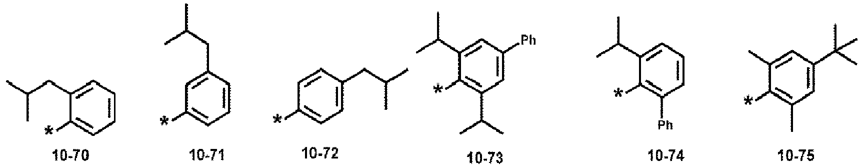 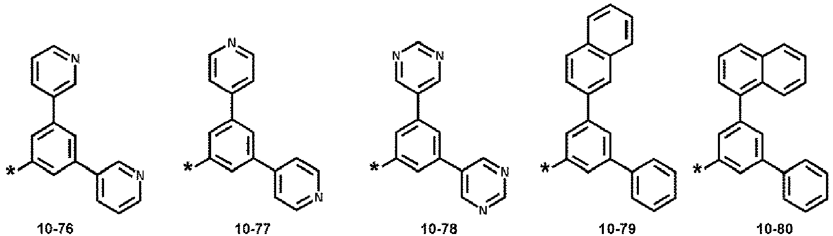 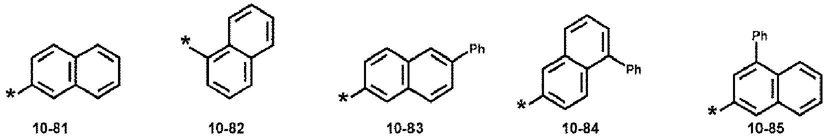 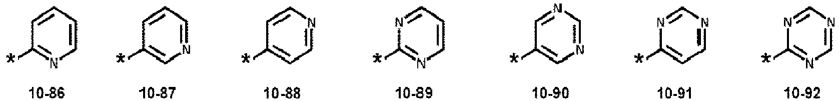 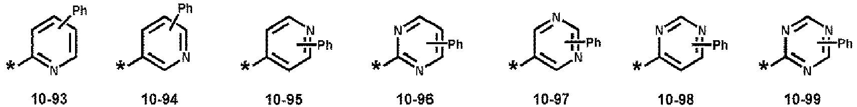 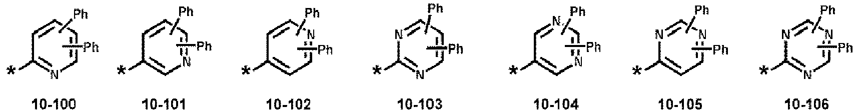 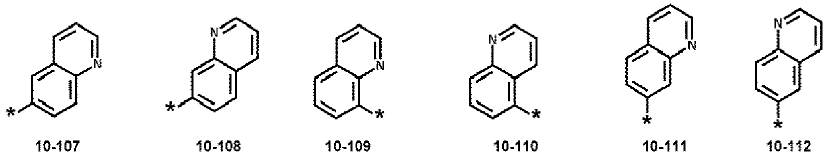 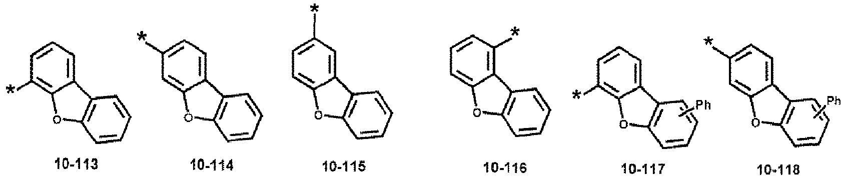 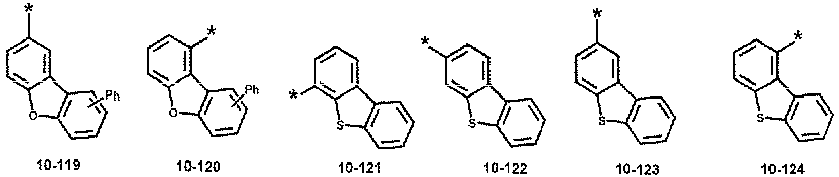 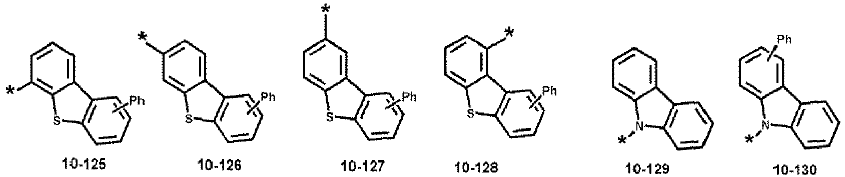 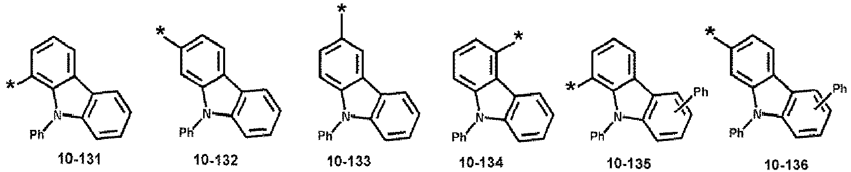 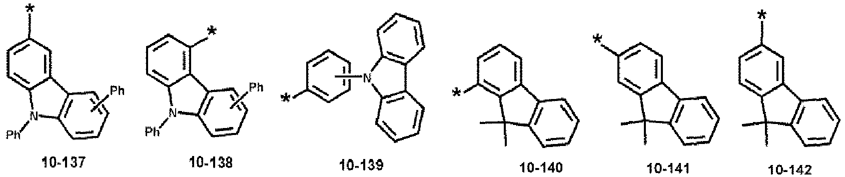 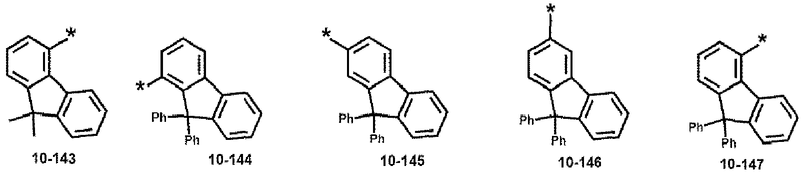 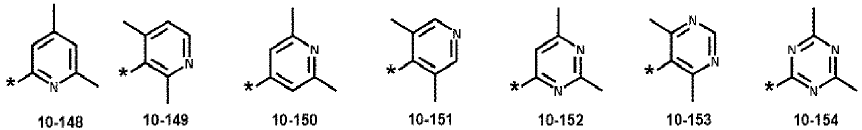 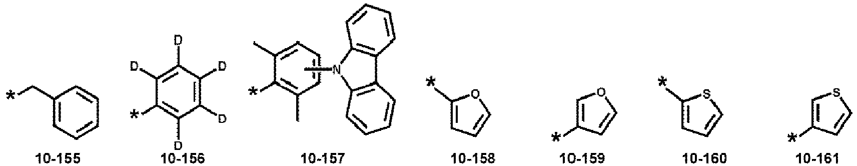 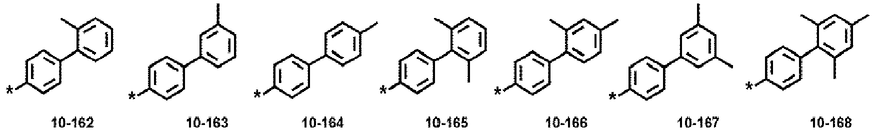 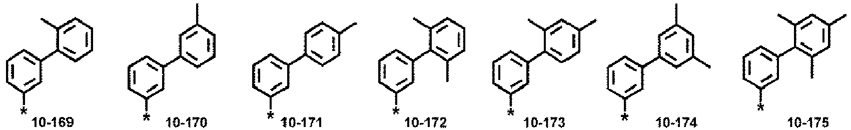 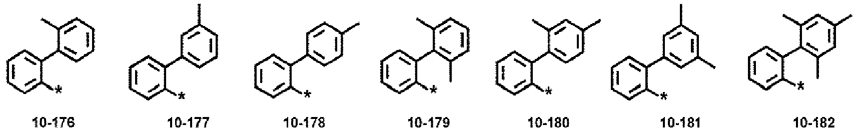 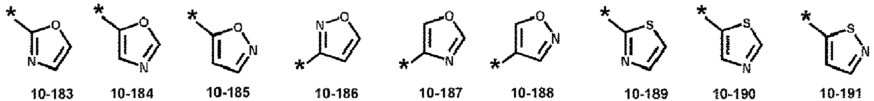 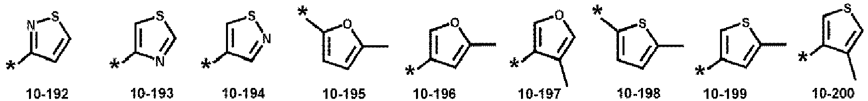 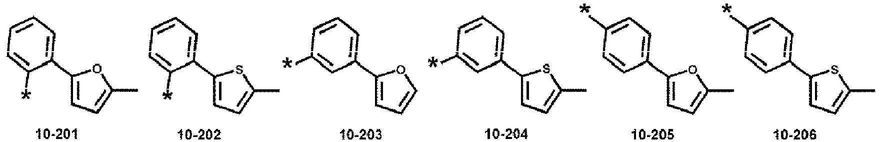 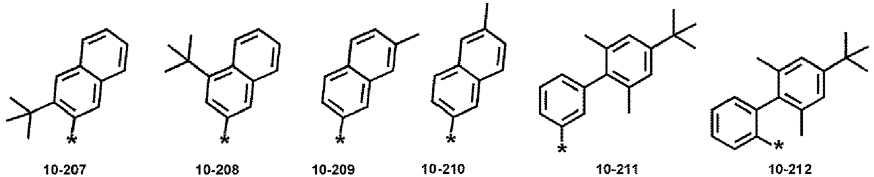 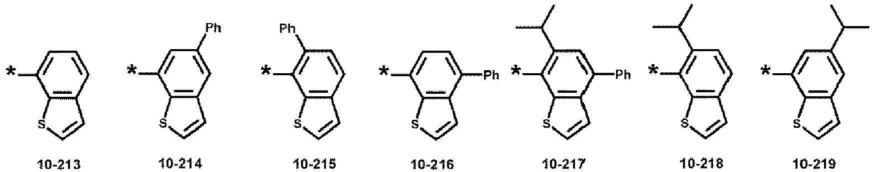 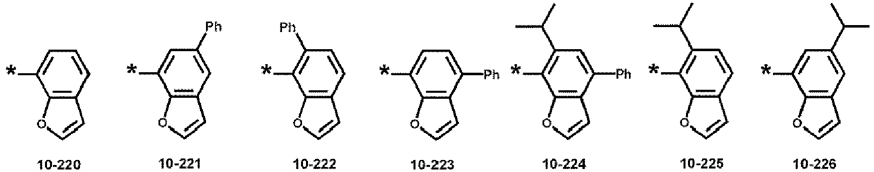 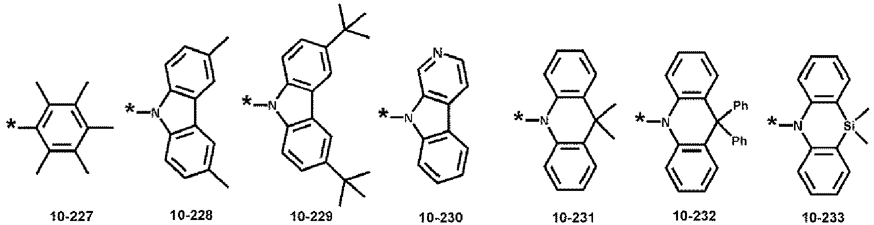 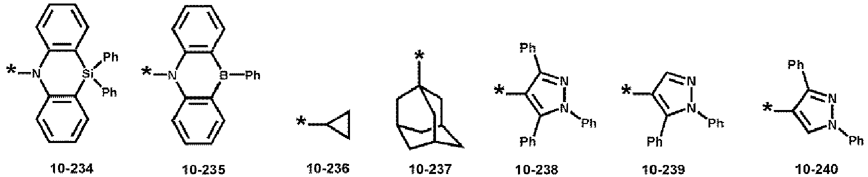 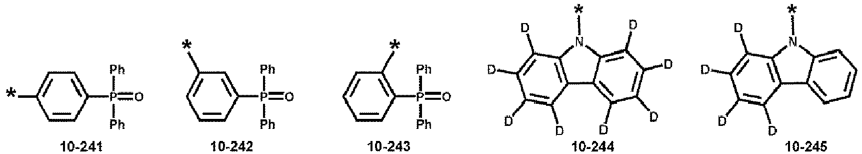 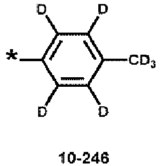 wherein, in Formulae 9-1 to 9-19 and 10-1 to 10-246, * indicates a binding site to a neighboring atom, "Ph" represents a phenyl group, and "TMS" represents a trimethylsilyl group.

a71 to a74 in Formulae 3-1 to 3-5 respectively indicate the number of R₇₁ to the number of R₇₄, and may each independently be an integer from 0 to 20. When a71 is 2 or more, two or more of R₇₁(s) may be identical to or different from each other, when a72 is 2 or more, two or more of R₇₂(s) may be identical to or different from each other, when a73 is 2 or more, two or more of R₇₃(s) may be identical to or different from each other, and when a74 is 2 or more, two or more of R₇₄(s) may be identical to or different from each other. a71 to a74 may each independently be an integer from 0 to 8.

In Formula 1, i) two or more of W₁(s) in the number of b1 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, ii) two or more of W₂(s) in the number of b2 may optionally be bonded to each other to form a C₃-C₆₀ carbocyclic group unsubstituted or substituted with at least one R10a or a C₁-C₆₀ heterocyclic group unsubstituted or substituted with at least one R₁₀ₐ, iii) two or more of Ws(s) in the number of b3 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, iv) two or more of W₄(s) in the number of b4 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, v) two or more of Ws(s) in the number of b5 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ, vi) two or more of W₆(s) in the number of b6 may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ.

In Formulae 3-1 to 3-5, L₈₁ to L₈₅ may each independently be:
a single bond; or
*-C(Q₄)(Q₅)-*' or *-Si(Q₄)(Q₅)-*'; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, - O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), -P(=O)(Q₃₁)(Q₃₂), or a combination thereof,
Q₄, Q₅, and Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In one or more embodiments, a group represented by 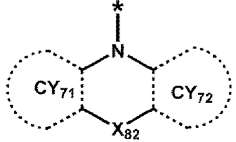 in Formulae 3-1 and 3-2 may be a group represented by one of Formulae CY71-1(1) to CY71-1(8), and/or
a group represented by 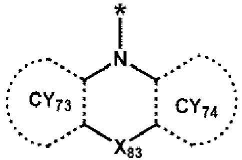 in Formulae 3-1 and 3-3 may be a group represented by one of Formulae CY71-2(1) to CY71-2(8), and/or
a group represented by 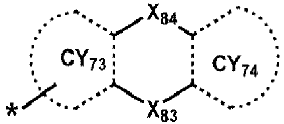 in Formulae 3-2 and 3-4 may be a group represented by one of Formulae CY71-3(1) to CY71-3(32),
a group represented by 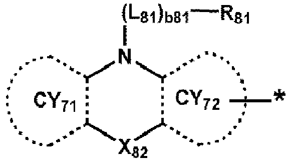 in Formulae 3-3 to 3-5 may be a group represented by one of Formulae CY71-4(1) to CY71-4(32), and/or
a group represented by 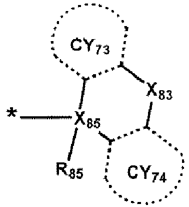 in Formula 3-5 may be a group represented by one of Formulae CY71-5(1) to CY71-5(8): 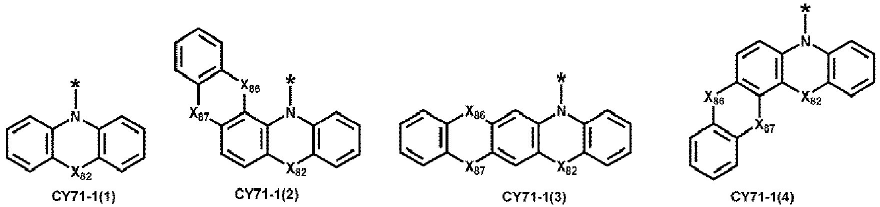 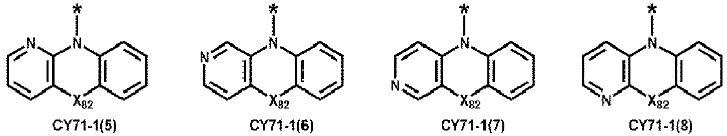 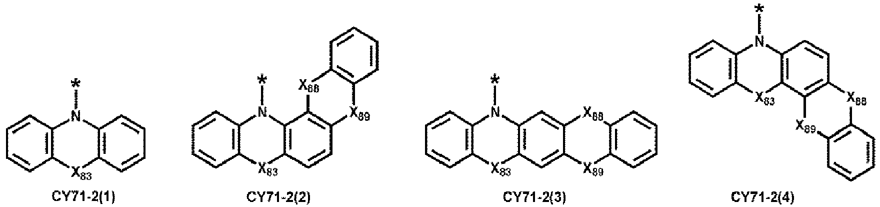 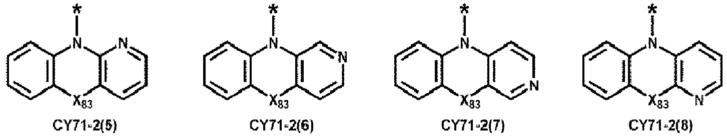 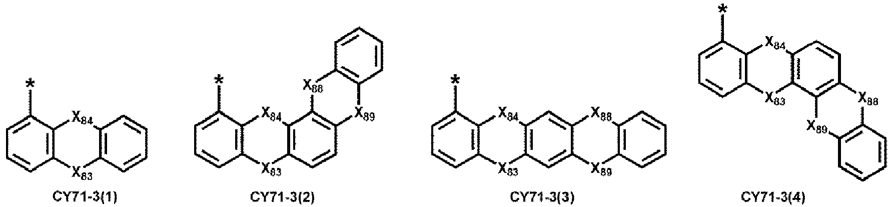 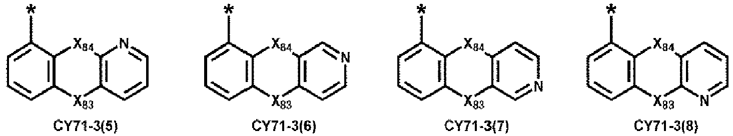 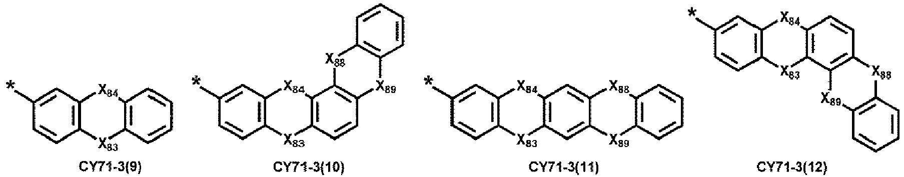 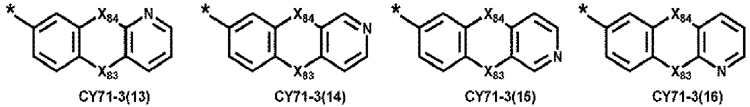 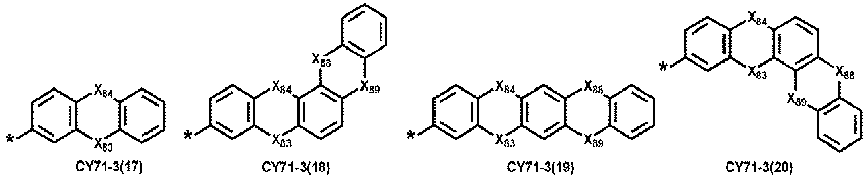 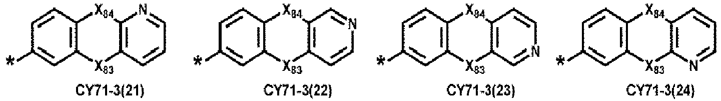 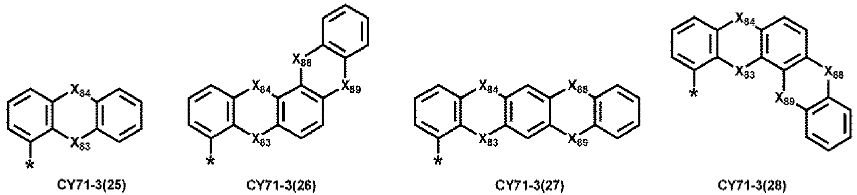 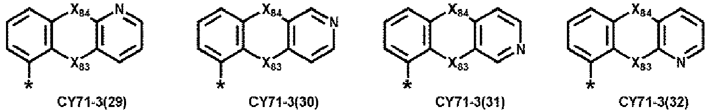 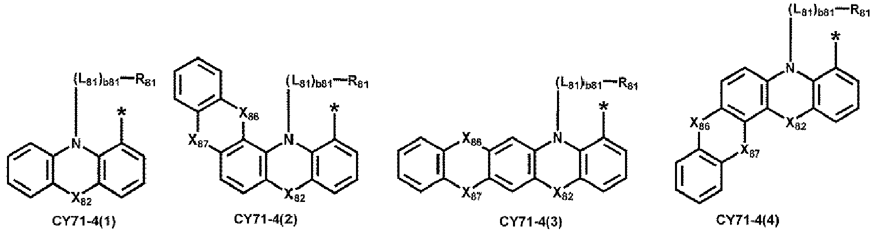 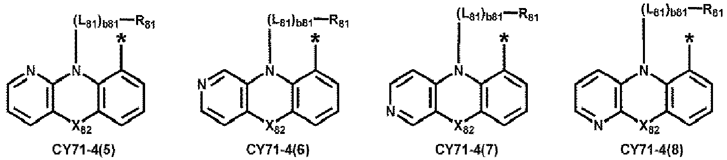 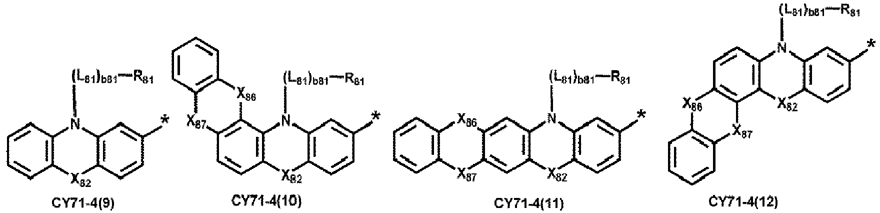 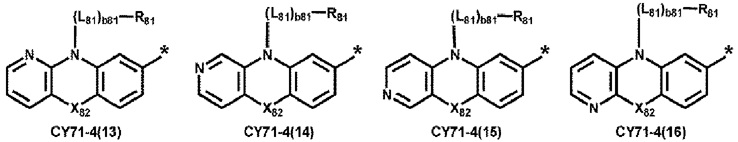 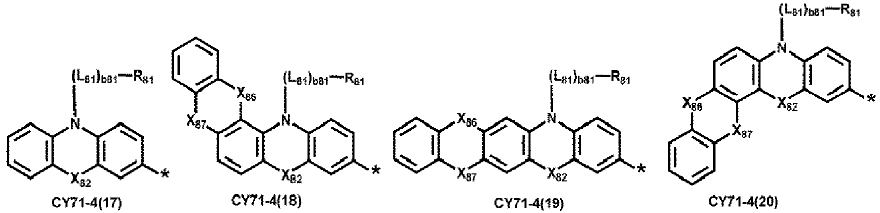 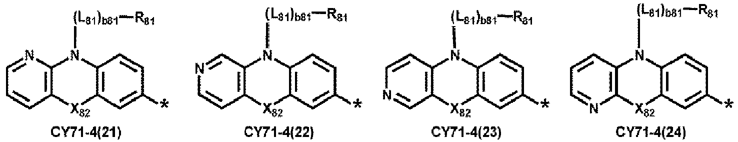 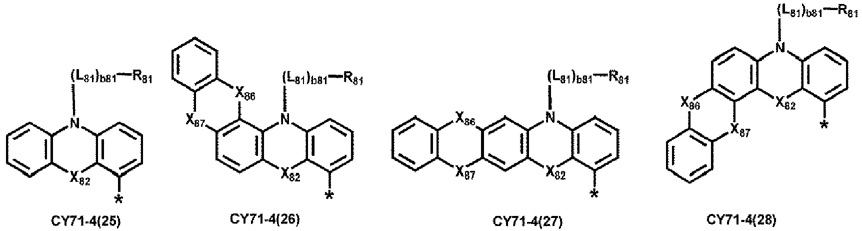 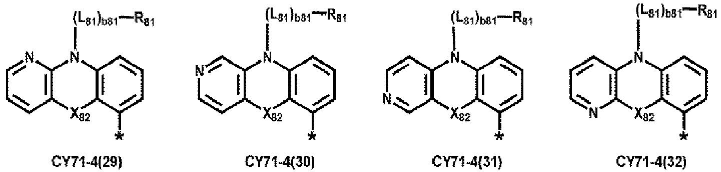 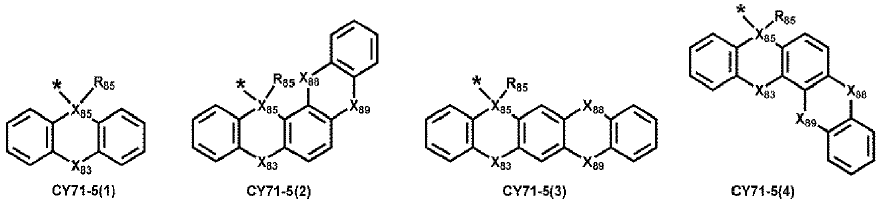 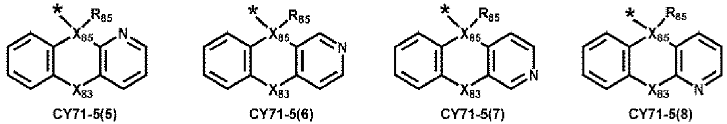
wherein, in Formulae CY71-1(1) to CY71-1(8), CY71-2(1) to CY71-2(8), CY71-3(1) to CY71-3(32), CY71-4(1) to CY71-4(32), and CY71-5(1) to CY71-5(8),
X₈₁ to X₈₅, L₈₁, b81, R₈₁, and R₈₅ may each be the same as described herein,
X₈₆ may be a single bond, O, S, N(R₈₆), B(R₈₆), C(R₈₆ₐ)(R_{86b}), or Si(R₈₆ₐ)(R_{86b}),
X₈₇ may be a single bond, O, S, N(R₈₇), B(R₈₇), C(R₈₇ₐ)(R_{87b}), or Si(R₈₇ₐ)(R_{87b}),
in Formulae CY71-1(1) to CY71-1(8) and CY71-4(1) to CY71-4(32), each of X₈₆ and X₈₇ may not be a single bond at the same time,
X₈₈ may be a single bond, O, S, N(R₈₈), B(R₈₈), C(R₈₈ₐ)(R_{88b}), or Si(R₈₈ₐ)(R_{88b}),
X₈₉ may be a single bond, O, S, N(R₈₉), B(R₈₉), C(R₈₉ₐ)(R_{89b}), or Si(R₈₉ₐ)(R_{89b}),
in Formulae CY71-2(1) to CY71-2(8), CY71-3(1) to CY71-3(32), and CY71-5(1) to CY71-5(8), each of X₈₈ and X₈₉ may not be a single bond at the same time, and
R₈₆ to R₈₉, R₈₆ₐ, R_{86b}, R₈₇ₐ, R_{87b}, R₈₈ₐ, R_{88b}, R₈₉ₐ, and R_{89b} may each be the same as described in connection with R₈₁.

### Examples of compounds

In an embodiment, the first emitter or the organometallic compound represented by Formula 1, 1A, 1B, 1A-1 or 1B-1 may be one of the following Compounds GD-1 to GD-18:

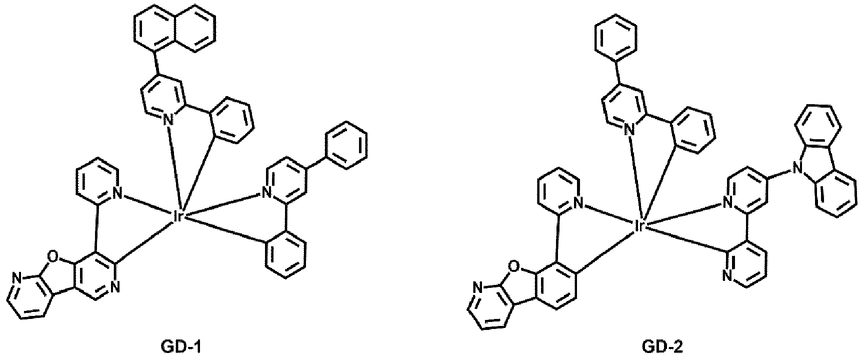

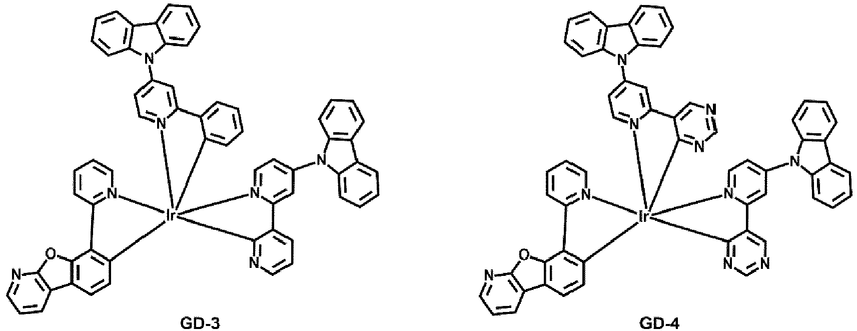

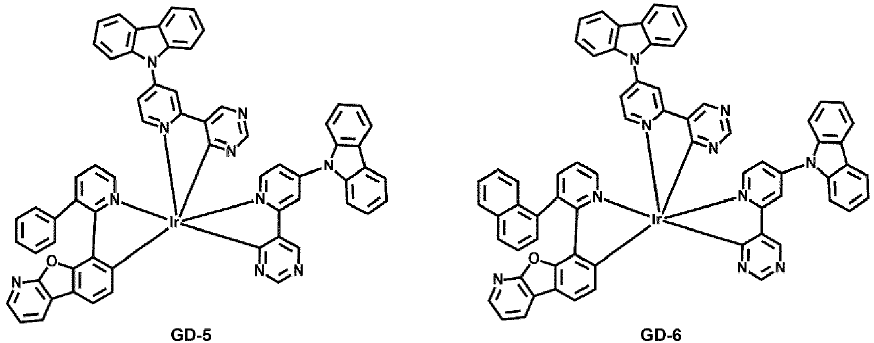

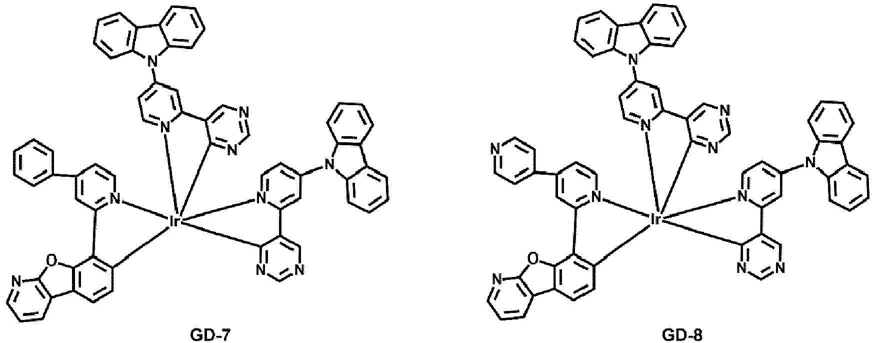

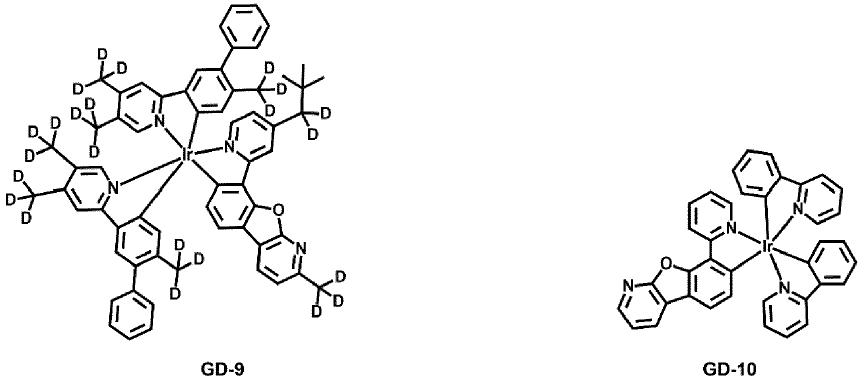

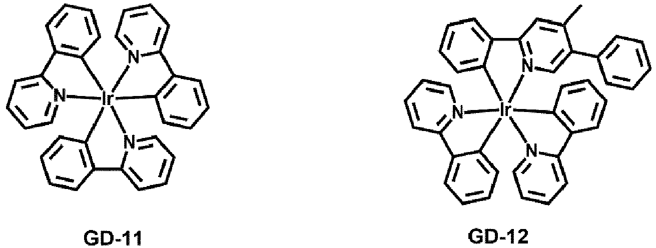

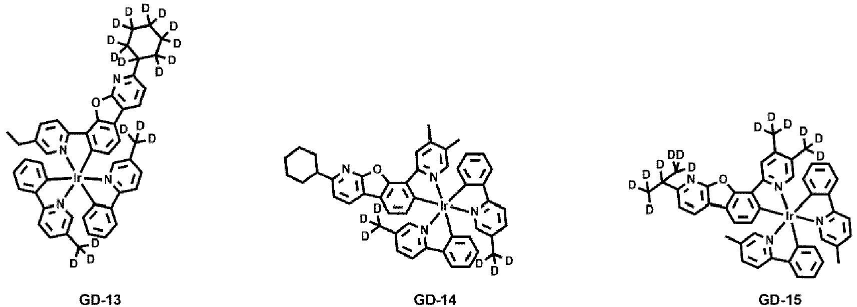

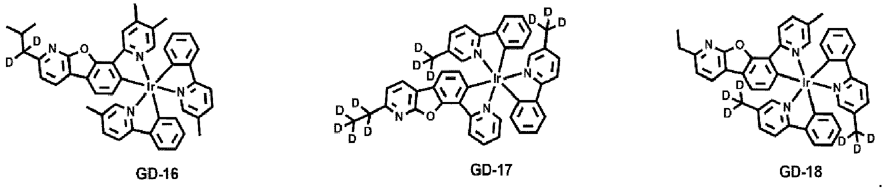

According to another embodiment, the heterocyclic compound may be one of the following compounds ET-1 to ET-6:

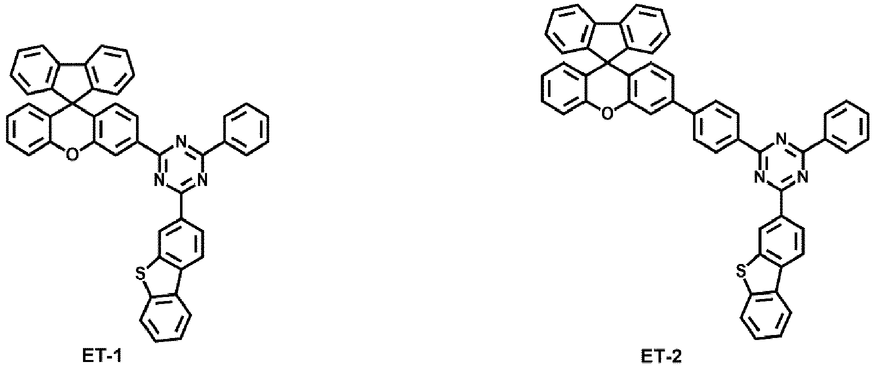

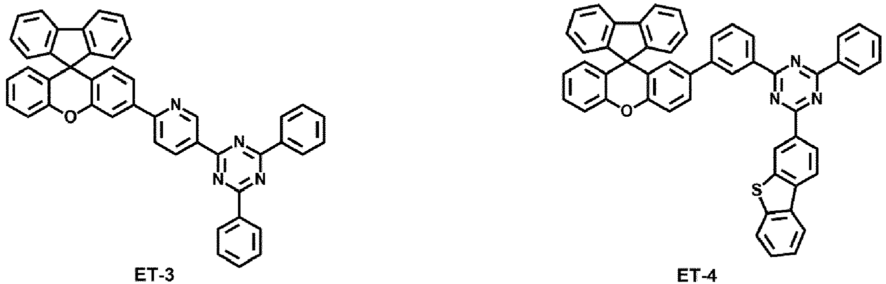

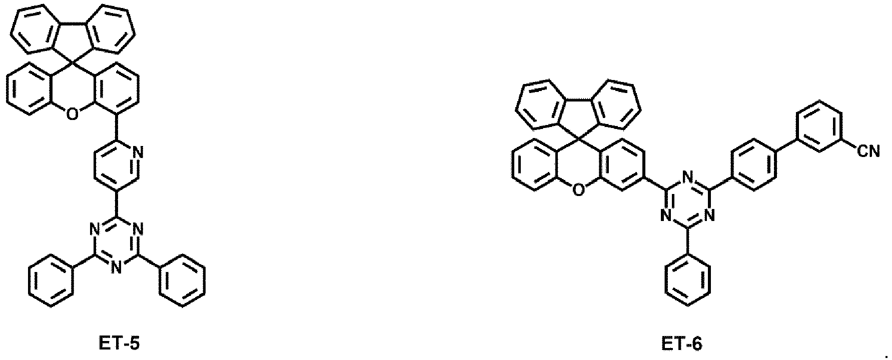

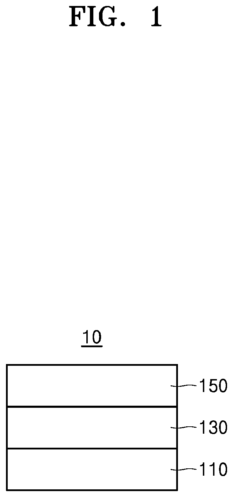

### [Description of FIG. 1]

FIG. 1 is a schematic cross-sectional view of a light-emitting device 10 according to an embodiment. The light-emitting device 10 includes a first electrode 110, an interlayer 130, and a second electrode 150.

Hereinafter, the structure of the light-emitting device 10 according to an embodiment and a method of manufacturing the light-emitting device 10 will be described with reference to FIG. 1.

### [First electrode 110]

Referring to FIG. 1, a substrate may be additionally located under the first electrode 110 or above the second capping layer 170. In an embodiment, as the substrate, a glass substrate or a plastic substrate may be used. In one or more embodiments, the substrate may be a flexible substrate, and may include plastics with excellent heat resistance and durability, such as polyimide, polyethylene terephthalate (PET), polycarbonate, polyethylene naphthalate, polyarylate (PAR), polyetherimide, or a combination thereof.

The first electrode 110 may be formed by, for example, depositing or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a semi-transmissive electrode, or a transmissive electrode. In an embodiment, when the first electrode 110 is a transmissive electrode, a material for forming the first electrode 110 may include indium tin oxide (ITO), indium zinc oxide (IZO), tin oxide (SnO₂), zinc oxide (ZnO), or a combination thereof. In one or more embodiments, when the first electrode 110 is a semi-transmissive electrode or a reflective electrode, a material for forming the first electrode 110 may include magnesium (Mg), silver (Ag), aluminum (Al), aluminum-lithium (Al-Li), calcium (Ca), magnesium-indium (Mg-In), magnesium-silver (Mg-Ag), or a combination thereof.

The first electrode 110 may have a single-layer structure consisting of a single layer or a multi-layer structure including multiple layers. For example, the first electrode 110 may have a three-layer structure of ITO/Ag/ITO.

### [Interlayer 130]

The interlayer 130 is arranged on the first electrode 110. The interlayer 130 may include the emission layer.

The interlayer 130 may further include a hole transport region arranged between the first electrode 110 and the emission layer, and an electron transport region arranged between the emission layer and the second electrode 150.

The interlayer 130 may further include, in addition to various organic materials, a metal-containing compound such as an organometallic compound, an inorganic material such as quantum dots, or the like.

In an embodiment, the interlayer 130 may include i) two or more emitting units sequentially stacked between the first electrode 110 and the second electrode 150, and ii) a charge generation layer located between two neighboring emitting units. When the interlayer 130 includes the two or more emitting units and the charge generation layer, the light-emitting device 10 may be a tandem light-emitting device.

### [Hole transport region in interlayer 130]

The hole transport region may have: i) a single-layer structure consisting of a single layer consisting of a single material, ii) a single-layer structure consisting of a single layer consisting of multiple materials that are different from each other, or iii) a multi-layer structure including multiple materials including multiple materials that are different from each other.

The hole transport region may include a hole injection layer, a hole transport layer, an emission auxiliary layer, an electron blocking layer, or a combination thereof.

For example, the hole transport region may have a multi-layer structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein constituent layers of each structure are stacked sequentially from the first electrode 110.

The hole transport region may include a compound represented by Formula 201, a compound represented by Formula 202, or a combination thereof:

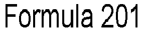

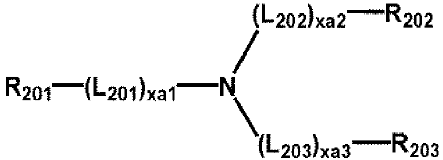

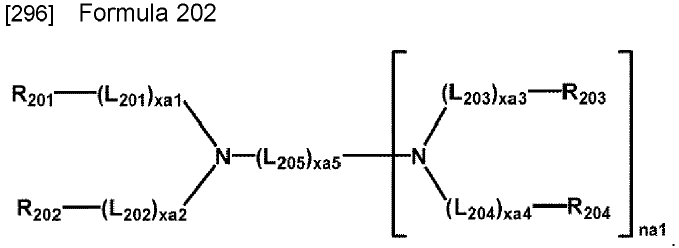

In Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
R₂₀₁ and R₂₀₂ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ to form a C₈-C₆₀ polycyclic group (for example, a carbazole group or the like) unsubstituted or substituted with at least one R₁₀ₐ (for example, see Compound HT16),
R₂₀₃ and R₂₀₄ may optionally be linked to each other, via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group unsubstituted or substituted with at least one R₁₀ₐ, and
na1 may be an integer from 1 to 4.

For example, each of Formulae 201 and 202 may include at least one of groups represented by Formulae CY201 to CY217:

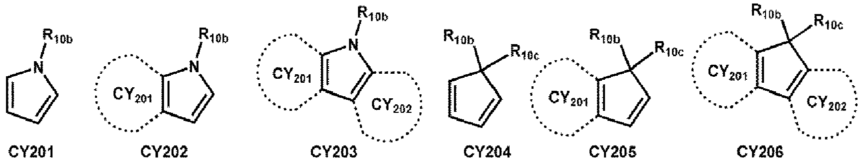

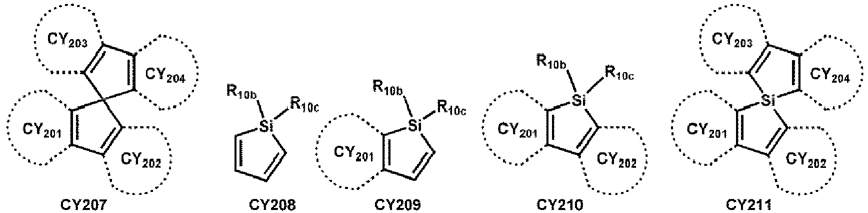

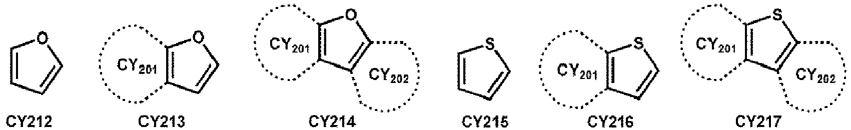

R_{10b} and R_{10c} in Formulae CY201 to CY217 may each be as defined in R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In one or more embodiments, ring CY₂₀₁ to ring CY₂₀₄ in Formulae CY201 to CY217 may each independently be a benzene group, a naphthalene group, a phenanthrene group, or an anthracene group.

In one or more embodiments, each of Formulae 201 and 202 may include at least one of the groups represented by Formulae CY201 to CY203.

In one or more embodiments, Formula 201 may include at least one of the groups represented by Formulae CY201 to CY203 and at least one of the groups represented by Formulae CY204 to CY217.

In one or more embodiments, in Formula 201, xa1 may be 1, R₂₀₁ may be one of the groups represented by Formulae CY201 to CY203, xa2 may be 0, and R₂₀₂ may be one of the groups represented by Formulae CY204 to CY207.

In one or more embodiments, each of Formulae 201 and 202 may not include the groups represented by Formulae CY201 to CY203.

In one or more embodiments, each of Formulae 201 and 202 may not include the groups represented by Formulae CY201 to CY203, and may include at least one of the groups represented by Formulae CY204 to CY217.

In one or more embodiments, each of Formulae 201 and 202 may not include the groups represented by Formulae CY201 to CY217.

For example, the hole transport region may include one of Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or a combination thereof:

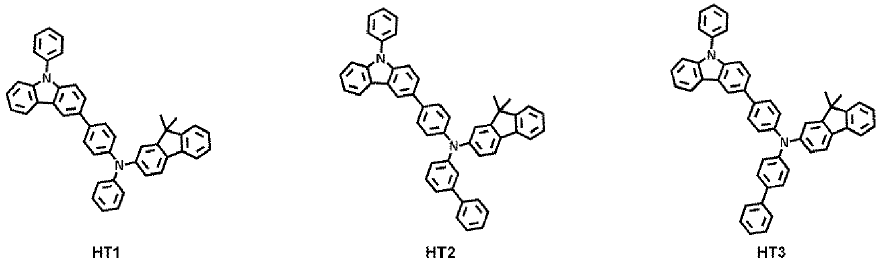

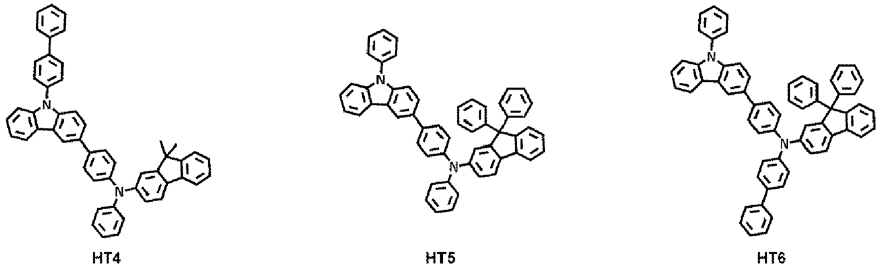

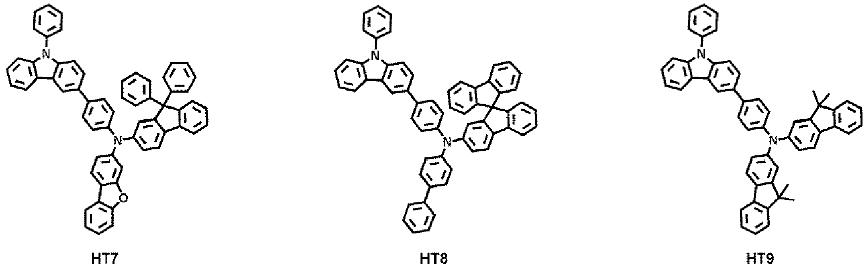

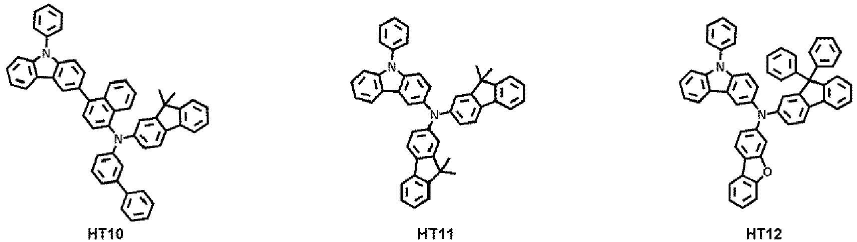

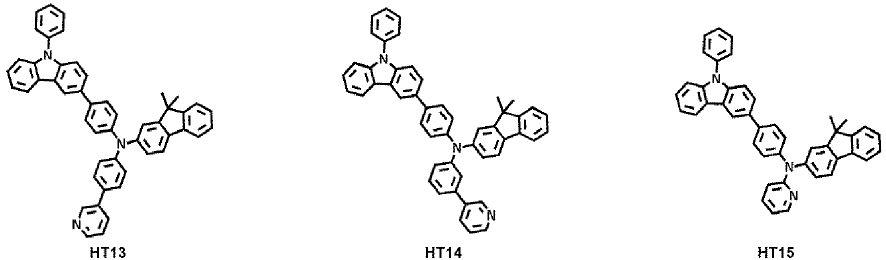

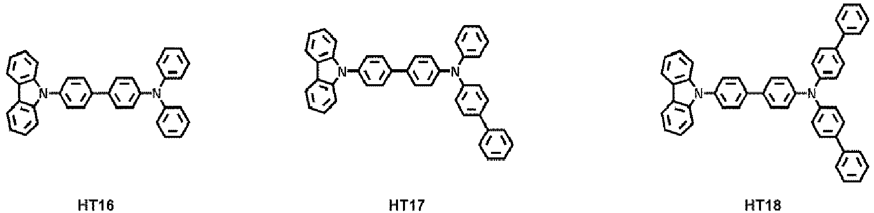

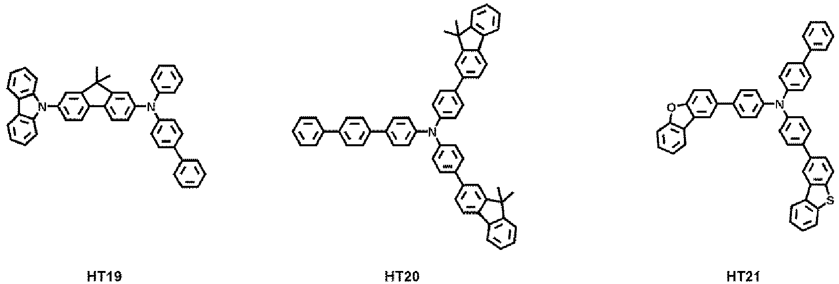

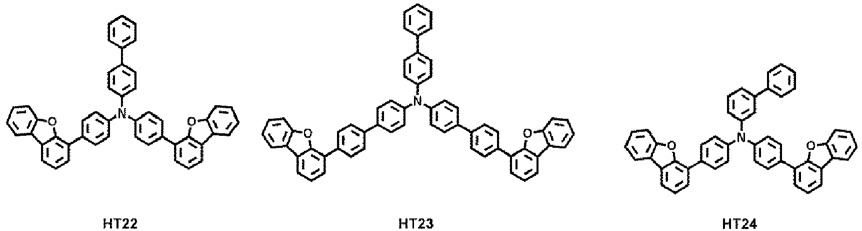

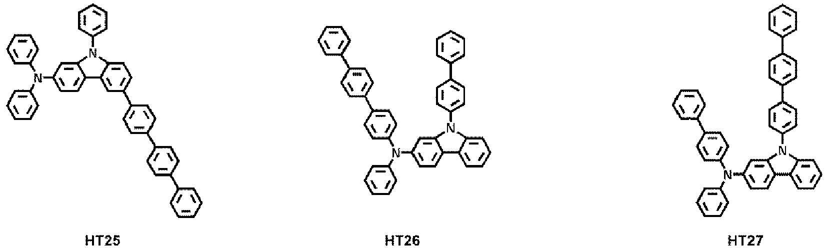

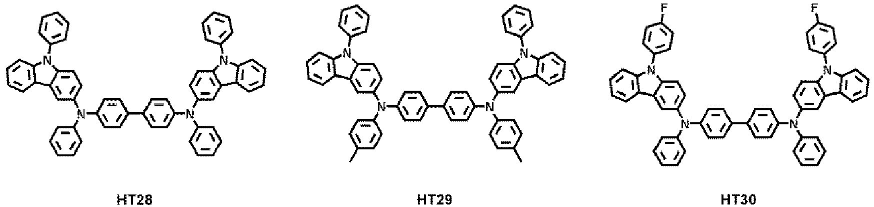

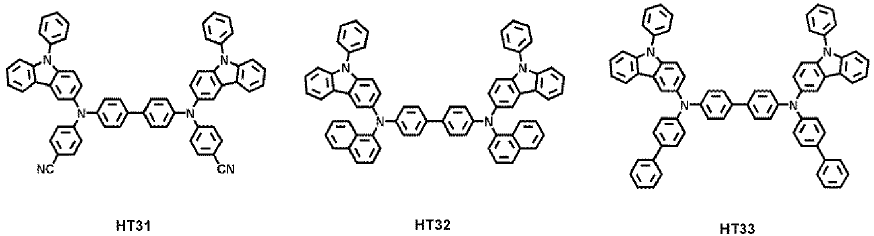

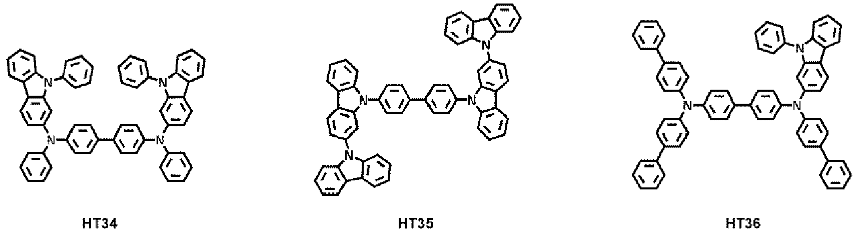

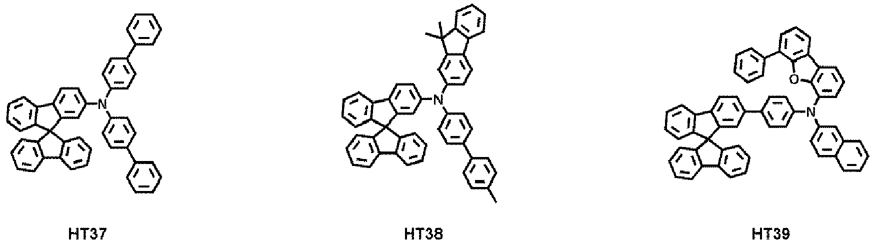

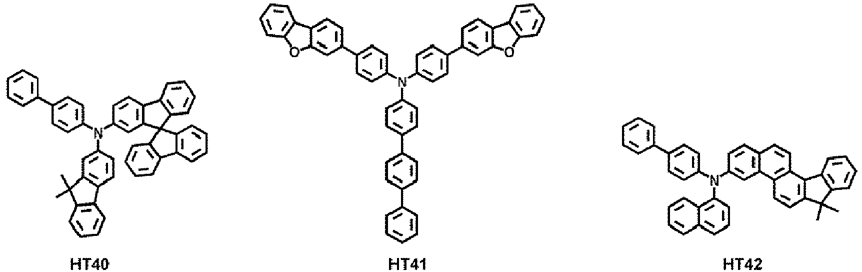

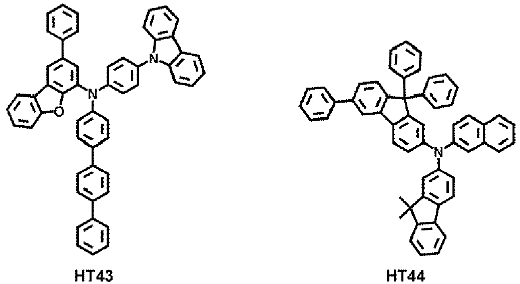

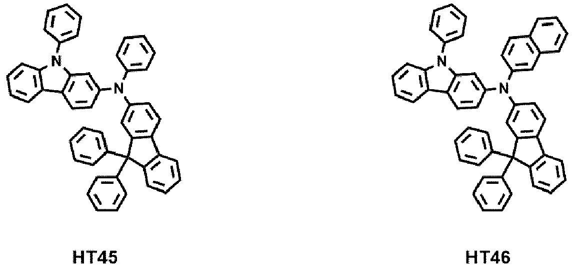

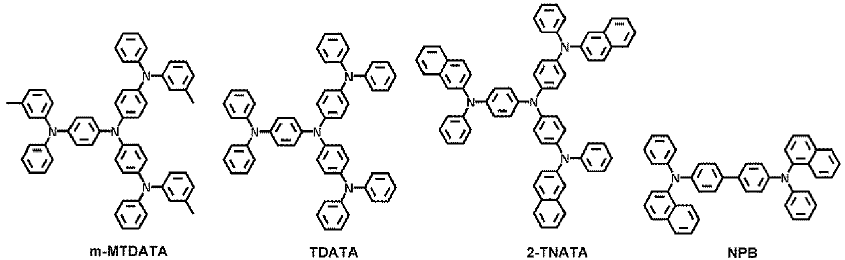

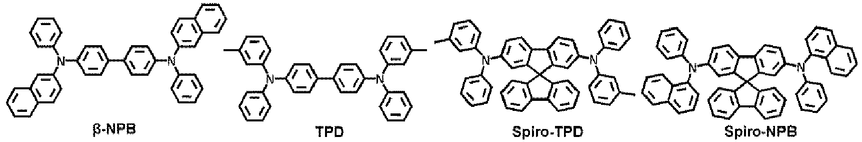

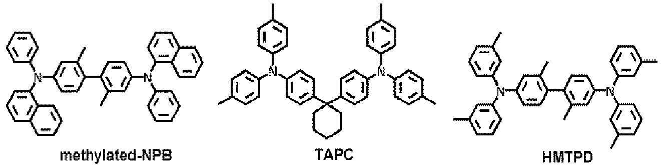

A thickness of the hole transport region may be in a range of about 50 Å to about 10,000 Å, for example, about 100 Å to about 4,000 Å. When the hole transport region includes a hole injection layer, a hole transport layer, or a combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The emission auxiliary layer may increase light-emission efficiency by compensating for an optical resonance distance according to the wavelength of light emitted by the emission layer, and the electron blocking layer may block the leakage of electrons from the emission layer to the hole transport region. Materials that may be included in the hole transport region may be included in the emission auxiliary layer and the electron blocking layer.

### [p-dopant]

The hole transport region may further include, in addition to these materials, a charge-generation material for the improvement of conductive properties. The charge-generation material may be uniformly or non-uniformly dispersed in the hole transport region (for example, in the form of a single layer consisting of a charge-generation material).

The charge-generation material may be, for example, a p-dopant.

For example, the p-dopant may have a LUMO energy level of less than or equal to about -3.5 eV.

In an embodiment, the p-dopant may include a quinone derivative, a cyano group-containing compound, a compound including element EL1 and element EL2, or a combination thereof.

Examples of the quinone derivative are TCNQ, F4-TCNQ, and the like.

Examples of the cyano group-containing compound are HAT-CN, a compound represented by Formula 221, and the like:

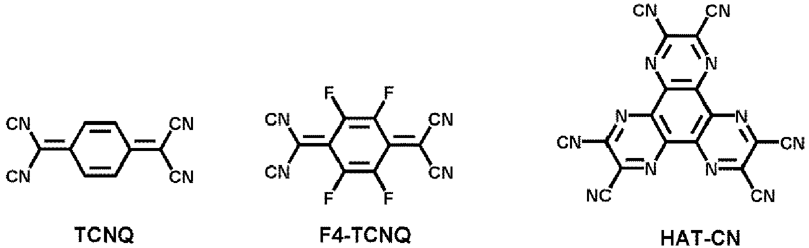

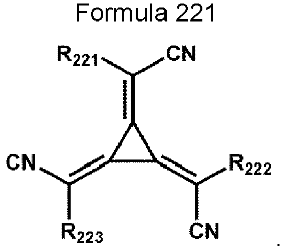

In Formula 221,
R₂₂₁ to R₂₂₃ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ, and
at least one of R₂₂₁ to R₂₂₃ may each independently be a C₃-C₆₀ carbocyclic group or a C₁-C₆₀ heterocyclic group, substituted with a cyano group; -F; -Cl; -Br; -I; a C₁-C₂₀ alkyl group substituted with a cyano group, -F, -Cl, -Br, -I, or a combination thereof; or a combination thereof.

In the compound including element EL1 and element EL2, element EL1 may be metal, metalloid, or a combination thereof, and element EL2 may be non-metal, metalloid, or a combination thereof.

Examples of the metal are an alkali metal (for example, lithium (Li), sodium (Na), potassium (K), rubidium (Rb), cesium (Cs), etc.); alkaline earth metal (for example, beryllium (Be), magnesium (Mg), calcium (Ca), strontium (Sr), barium (Ba), etc.); transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); post-transition metal (for example, zinc (Zn), indium (In), tin (Sn), etc.); lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.); and the like.

Examples of the metalloid are silicon (Si), antimony (Sb), tellurium (Te), and the like.

Examples of the non-metal are oxygen (O), halogen (for example, F, Cl, Br, I, etc.), and the like.

Examples of the compound including element EL1 and element EL2 are metal oxide, metal halide (for example, metal fluoride, metal chloride, metal bromide, metal iodide, etc.), metalloid halide (for example, metalloid fluoride, metalloid chloride, metalloid bromide, metalloid iodide, etc.), metal telluride, or a combination thereof.

Examples of the metal oxide are tungsten oxide (for example, WO, W₂O₃, WO₂, WO₃, W₂O₃, etc.), vanadium oxide (for example, VO, V₂O₃, VO₂, V₂O₅, etc.), molybdenum oxide (MoO, Mo₂O₃, MoO₂, MoOs, Mo₂O₃, etc.), rhenium oxide (for example, ReOs, etc.), and the like.

Examples of the metal halide are alkali metal halide, alkaline earth metal halide, transition metal halide, post-transition metal halide, lanthanide metal halide, and the like.

Examples of the alkali metal halide are LiF, NaF, KF, RbF, CsF, LiCI, NaCl, KCI, RbCI, CsCI, LiBr, NaBr, KBr, RbBr, CsBr, Lil, Nal, KI, Rbl, Csl, and the like.

Examples of the alkaline earth metal halide are BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, Bel₂, Mgl₂, Cal₂, Srl₂, Bal₂, and the like.

Examples of the transition metal halide are titanium halide (for example, TiF₄, TiCl₄, TiBr₄, TiI₄, etc.), zirconium halide (for example, ZrF₄, ZrCl₄, ZrBr₄, ZrI₄, etc.), hafnium halide (for example, HfF₄, HfCl₄, HfBr₄, HfI₄, etc.), vanadium halide (for example, VF₃, VCl₃, VBr₃, VI₃, etc.), niobium halide (for example, NbF₃, NbCl₃, NbBr₃, NbI₃, etc.), tantalum halide (for example, TaF₃, TaCl₃, TaBr₃, TaI₃, etc.), chromium halide (for example, CrF₃, CrCl₃, CrBr₃, CrI₃, etc.), molybdenum halide (for example, MoF₃, MoCl₃, MoBr₃, MoI₃, etc.), tungsten halide (for example, WF₃, WCl₃, WBr₃, WI₃, etc.), manganese halide (for example, MnF₂, MnCl₂, MnBr₂, MnI₂, etc.), technetium halide (for example, TcF₂, TcCl₂, TcBr₂, TcI₂, etc.), rhenium halide (for example, ReF₂, ReCl₂, ReBr₂, ReI₂, etc.), iron halide (for example, FeF₂, FeCl₂, FeBr₂, FeI₂, etc.), ruthenium halide (for example, RuF₂, RuCl₂, RuBr₂, RuI₂, etc.), osmium halide (for example, OsF₂, OsCl₂, OsBr₂, OsI₂, etc.), cobalt halide (for example, CoF₂, CoCl₂, CoBr₂, CoI₂, etc.), rhodium halide (for example, RhF₂, RhCl₂, RhBr₂, RhI₂, etc.), iridium halide (for example, IrF₂, IrCl₂, IrBr₂, IrI₂, etc.), nickel halide (for example, NiF₂, NiCl₂, NiBr₂, NiI₂, etc.), palladium halide (for example, PdF₂, PdCl₂, PdBr₂, PdI₂, etc.), platinum halide (for example, PtF₂, PtCl₂, PtBr₂, PtI₂, etc.), copper halide (for example, CuF, CuCI, CuBr, Cul, etc.), silver halide (for example, AgF, AgCl, AgBr, Agl, etc.), gold halide (for example, AuF, AuCI, AuBr, Aul, etc.), and the like.

Examples of the post-transition metal halide are zinc halide (for example, ZnF₂, ZnCl₂, ZnBr₂, ZnI₂, etc.), indium halide (for example, InI₃, etc.), tin halide (for example, SnI₂, etc.), and the like.

Examples of the lanthanide metal halide may include YbF, YbF₂, YbF₃, SmF₃, YbCl, YbCl₂, YbCl₃ SmCl₃, YbBr, YbBr₂, YbBr₃, SmBr₃, Ybl, YbI₂, YbI₃, SmI₃, and the like.

Examples of the metalloid halide are antimony halide (for example, SbCl₅, etc.) and the like.

Examples of the metal telluride are alkali metal telluride (for example, Li₂Te, Na₂Te, K₂Te, Rb₂Te, Cs₂Te, etc.), alkaline earth metal telluride (for example, BeTe, MgTe, CaTe, SrTe, BaTe, etc.), transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), post-transition metal telluride (for example, ZnTe, etc.), and lanthanide metal telluride (for example, LaTe, CeTe, PrTe, NdTe, PmTe, EuTe, GdTe, TbTe, DyTe, HoTe, ErTe, TmTe, YbTe, LuTe, etc.).

### [Emission layer in interlayer 130]

When the light-emitting device 10 is a full-color light-emitting device, the emission layer may be patterned into a red emission layer, a green emission layer, and/or a blue emission layer, according to a sub-pixel. In an embodiment, the emission layer may have a stacked structure of two or more layers of a red emission layer, a green emission layer, and a blue emission layer, in which the two or more layers contact each other or are separated from each other, to emit white light. In one or more embodiments, the emission layer may include two or more materials of a red light-emitting material, a green light-emitting material, and a blue light-emitting material, in which the two or more materials are mixed with each other in a single layer, to emit white light.

In an embodiment, the emission layer may further include a host, an auxiliary dopant, a sensitizer, delayed fluorescence material, or a combination thereof, in addition to the first emitter as described in the present specification.

When the emission layer further includes a host in addition to the first emitter, the amount of the first emitter may be about 0.01 to about 15 parts by weight based on 100 parts by weight of the host.

The thickness of the emission layer may be in a range of about 100 Å to about 1,000 Å, for example, about 200 Å to about 600 Å. When the thickness of the emission layer 120 is within these ranges, excellent luminescence characteristics may be obtained without a substantial increase in driving voltage.

### [Host]

The host in the emission layer may include an electron-transporting compound described herein (for example, refer to the compounds represented by Formula 2-1 or 2-2), a hole-transporting compound described herein (for example, refer to a compound represented by one of Formulae 3-1 to 3-5), or a combination thereof.

In one or more embodiments, the host may include an alkali earth metal complex, a post-transition metal complex, or a combination thereof. In one or more embodiments, the host may include a Be complex (for example, Compound H55), an Mg complex, a Zn complex, or a combination thereof.

In one or more embodiments, the host may include one of Compounds H1 to H130, 9,10-di(2-naphthyl)anthracene (ADN), 2-methyl-9,10-bis(naphthalen-2-yl)anthracene (MADN), 9,10-di(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), or a combination thereof:

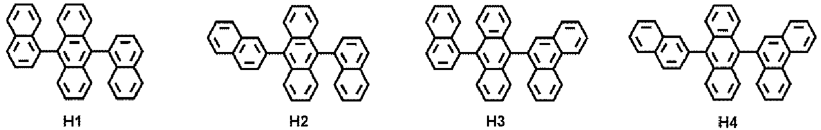

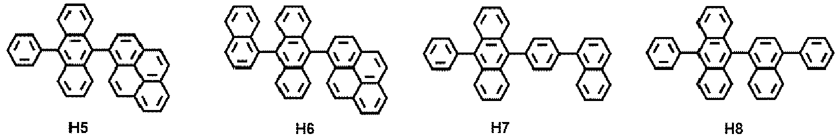

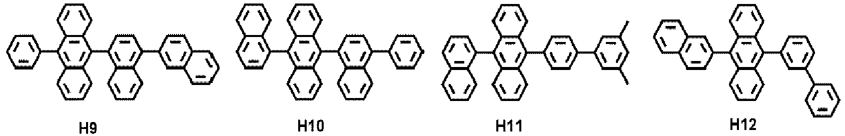

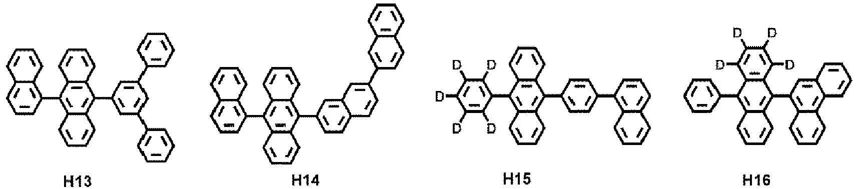

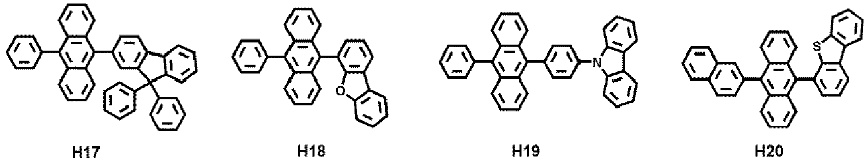

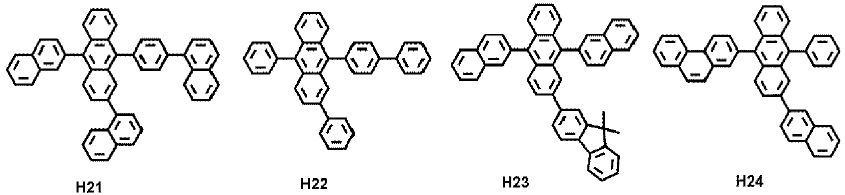

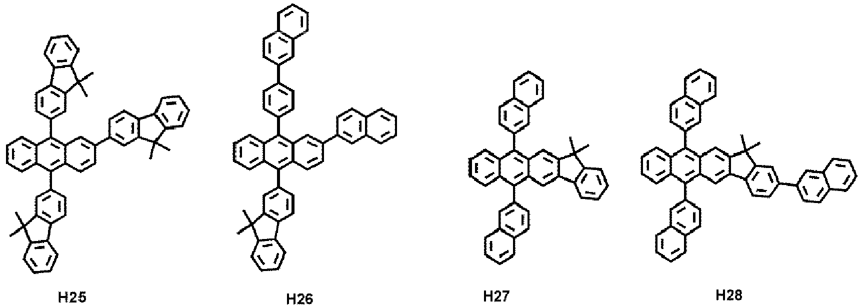

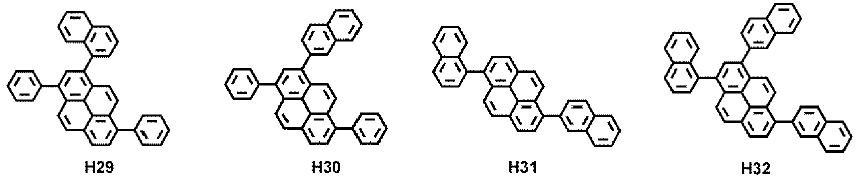

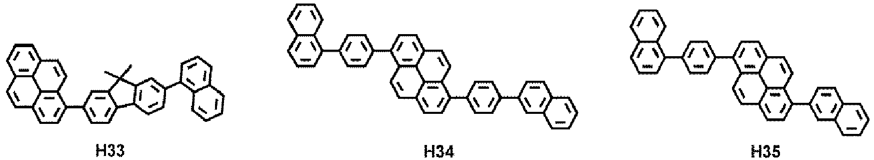

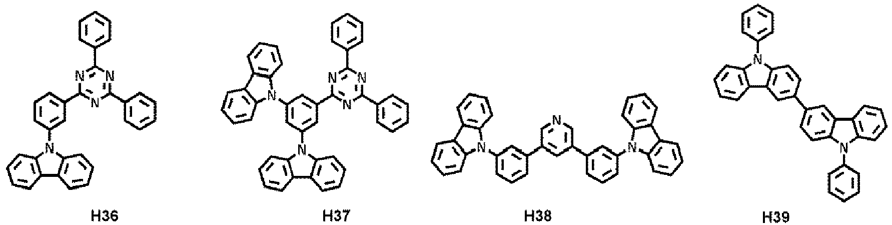

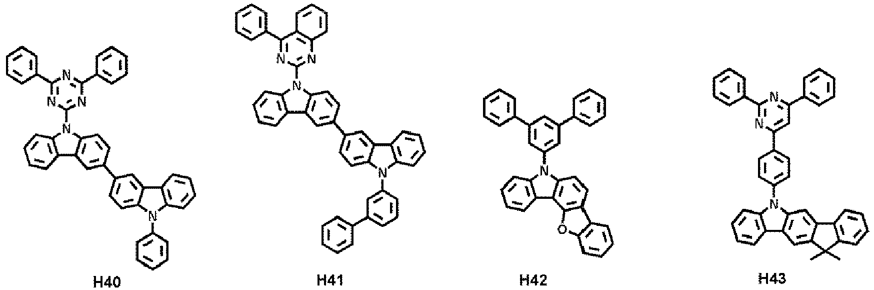

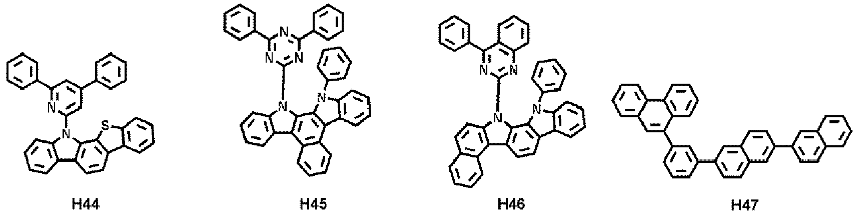

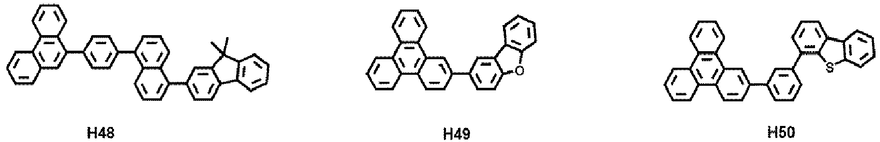

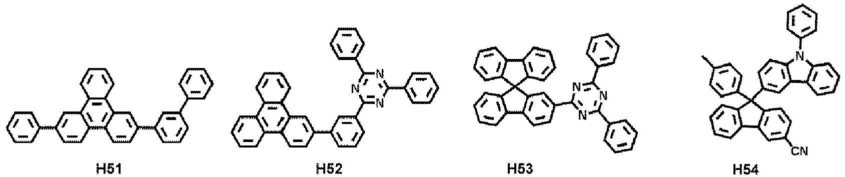

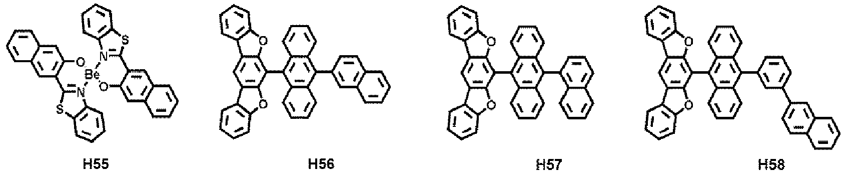

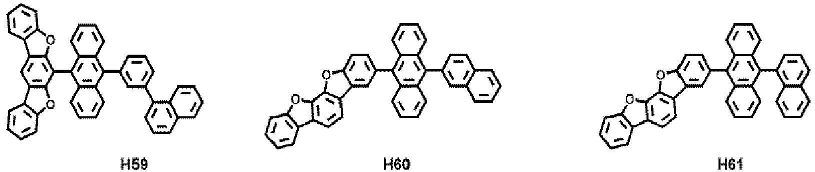

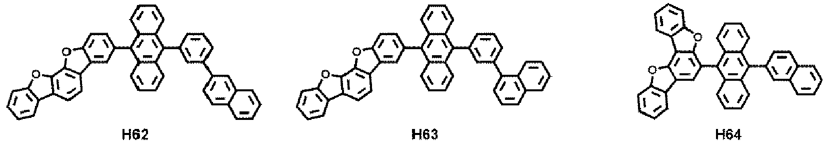

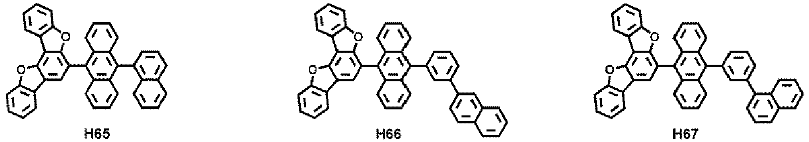

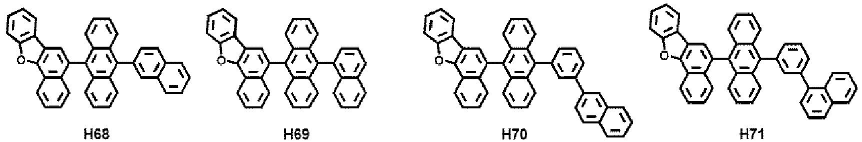

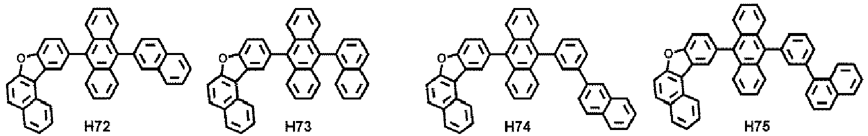

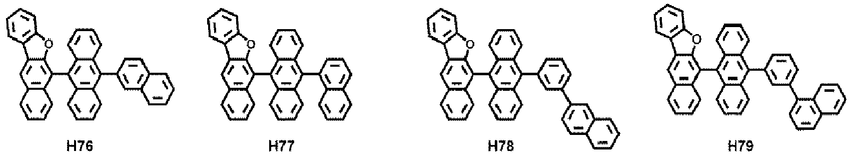

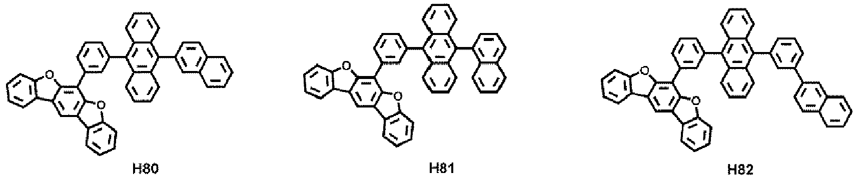

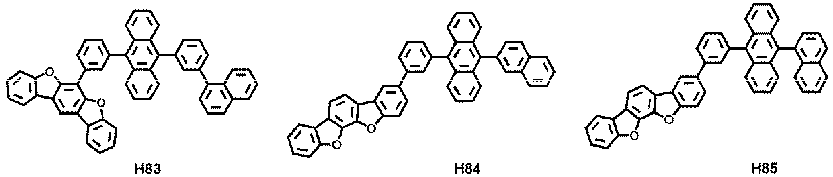

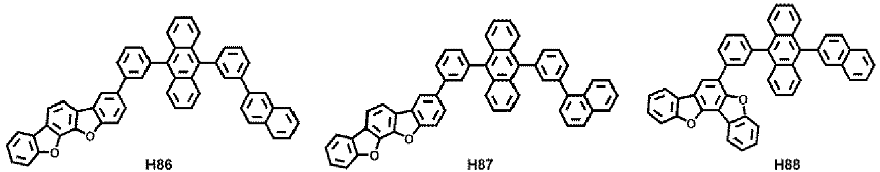

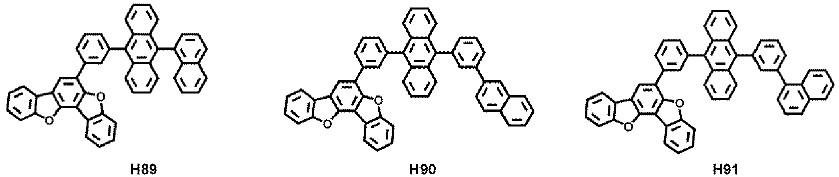

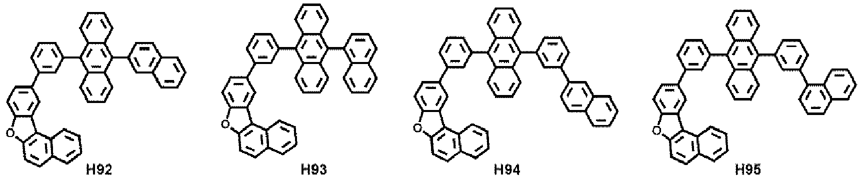

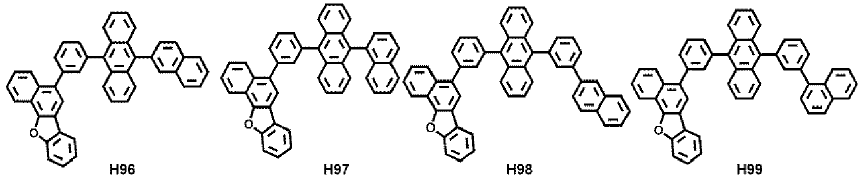

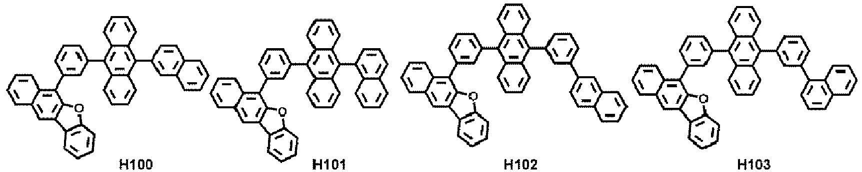

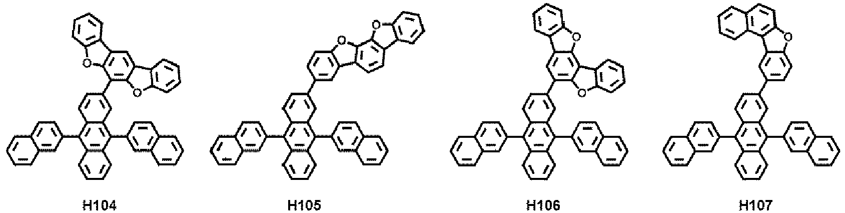

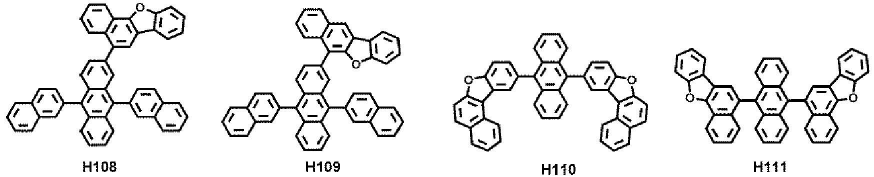

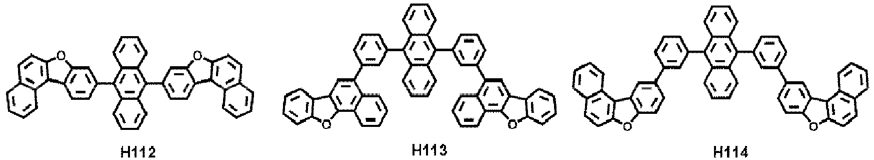

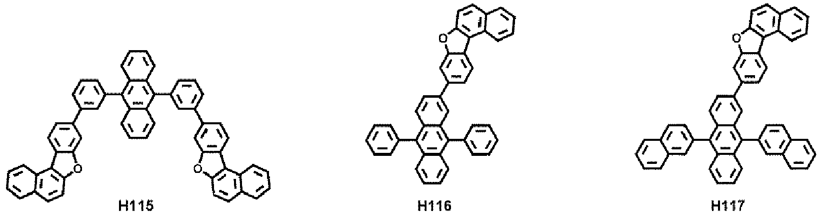

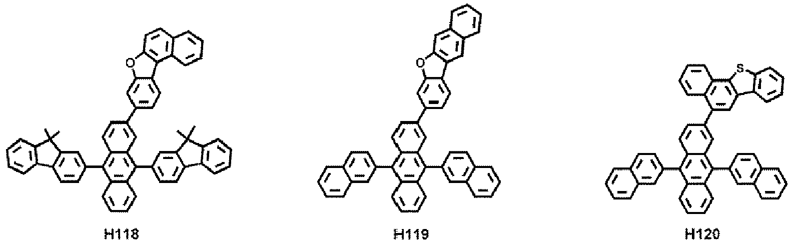

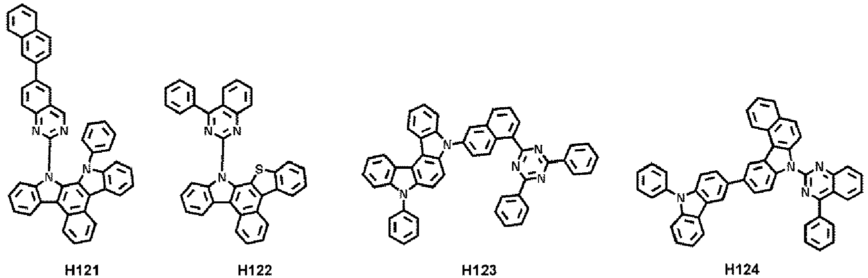

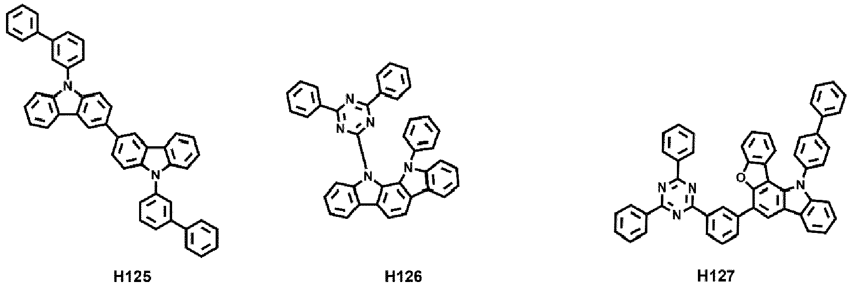

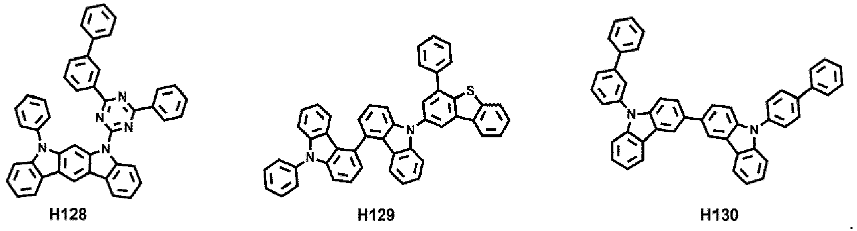

In an embodiment, the host may include a silicon-containing compound, a phosphine oxide-containing compound, or a combination thereof.

The host may have various modifications. For example, the host may include only one kind of compound, or may include two or more kinds of different compounds.

### [Phosphorescent dopant]

The emission layer may include, as a phosphorescent dopant, the first emitter as described herein.

In an embodiment, the emission layer may further include, in addition to the first emitter as described in the present specification, an organometallic compound represented by Formula 401:

Formula 401 M(L_{401xc}1(L₄₀₂)_{xc2}

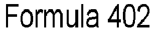

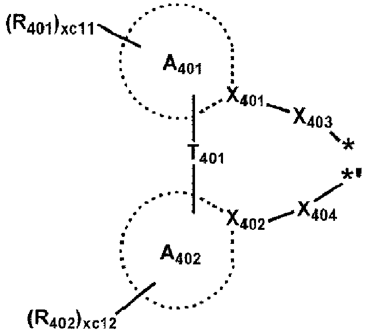

wherein in Formulae 401 and 402,
M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 is 1, 2, or 3, wherein, when xc1 is 2 or more, two or more of L₄₀₁ may be identical to or different from each other,
L₄₀₂ may be an organic ligand, and xc2 may be 0, 1, 2, 3, or 4, wherein, when xc2 is 2 or more, two or more of L₄₀₂ may be identical to or different from each other,
X₄₀₁ and X₄₀₂ may each independently be N or C,
ring A₄₀₁ and ring A₄₀₂ may each independently be a C₃-C₆₀ carbocyclic group or a C₁-C₆₀ heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*',
X₄₀₃ and X₄₀₄ may each independently be a chemical bond (for example, a covalent bond or a coordination bond), O, S, N(Q413), B(Q413), P(Q413), C(Q413)(Q414), or Si(Q413)(Q414),
Q₄₁₁ to Q₄₁₄ may each be the same as described in connection with Q₁,
R₄₀₁ and R₄₀₂ may each independently be hydrogen, deuterium, -F, -Cl, -Br, -I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, - Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), or - P(=O)(Q₄₀₁)(Q₄₀₂),
Q₄₀₁ to Q₄₀₃ may each be the same as described in connection with Q₁,
xc11 and xc12 may each independently be an integer from 0 to 10, and
* and *' in Formula 402 each indicate a binding site to M in Formula 401.

For example, in Formula 402, i) X₄₀₁ may be nitrogen and X₄₀₂ may be carbon, or ii) each of X₄₀₁ and X₄₀₂ may be nitrogen.

In one or more embodiments, when xc1 in Formula 402 is 2 or more, two ring A₄₀₁(s) in two or more of L₄₀₁(s) may be optionally linked to each other via T₄₀₂, which is a linking group, or two ring A₄₀₂(s) may be optionally linked to each other via T₄₀₃, which is a linking group (see Compounds PD1 to PD4 and PD7). T₄₀₂ and T₄₀₃ may each independently be as defined in T₄₀₁.

In Formula 401, L₄₀₂ may be an organic ligand. For example, L₄₀₂ may include a halogen group, a diketone group (for example, an acetylacetonate group), a carboxylic acid group (for example, a picolinate group), -C(=O), an isonitrile group, a -CN group, a phosphorus group (for example, a phosphine group, a phosphite group, etc.), or a combination thereof.

### [Fluorescent dopant]

The emission layer may further include a fluorescent dopant in addition to the first emitter as described in the present specification.

The fluorescent dopant may include an arylamine compound, a styrylamine compound, a boron-containing compound, or a combination thereof.

For example, the fluorescent dopant may include a compound represented by Formula 501: 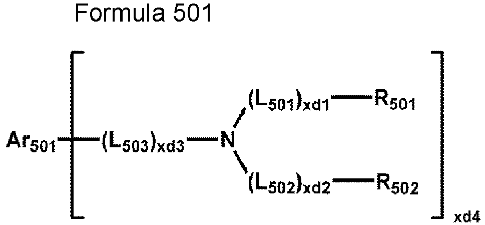
wherein, in Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

In an embodiment, Ar₅₀₁ in Formula 501 may be a condensed cyclic group (for example, an anthracene group, a chrysene group, a pyrene group, etc.) in which three or more monocyclic groups are condensed together.

In an embodiment, xd4 in Formula 501 may be 2.

For example, the fluorescent dopant may include: one of Compounds FD1 to FD36; DPVBi; DPAVBi; or a combination thereof:

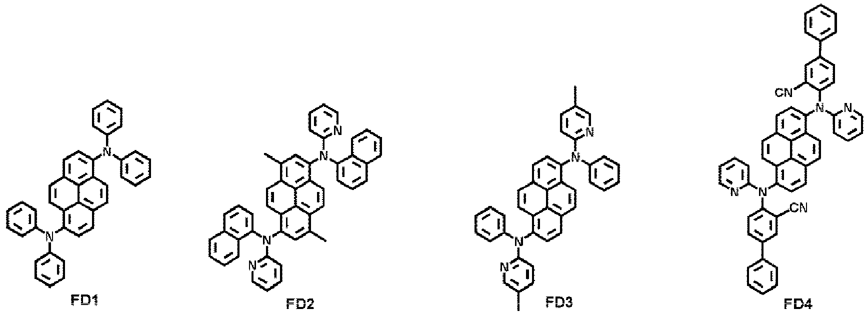

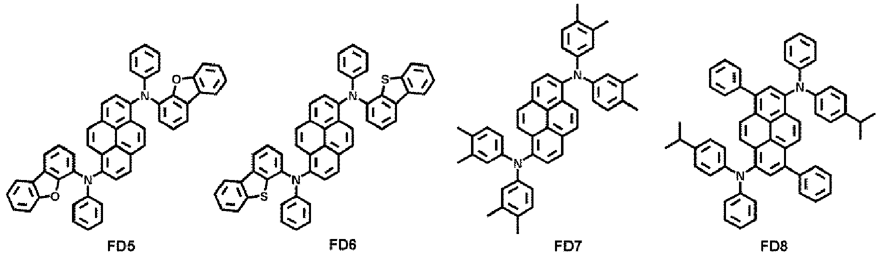

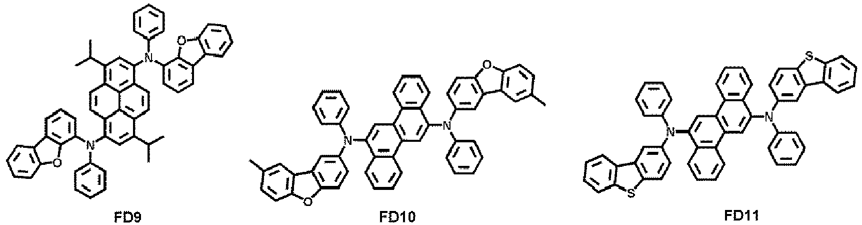

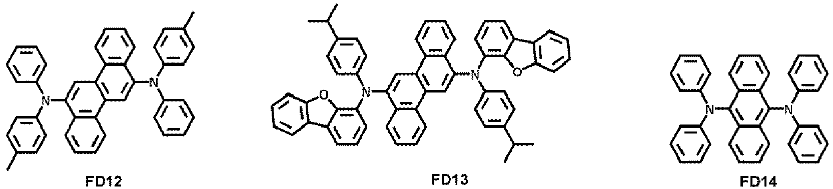

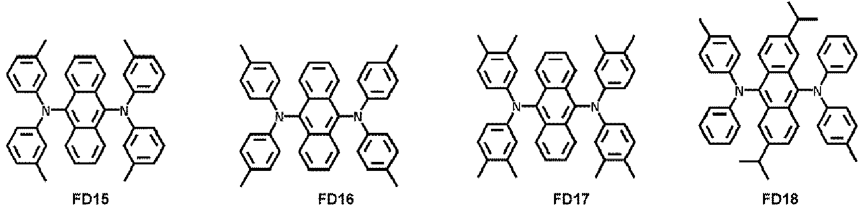

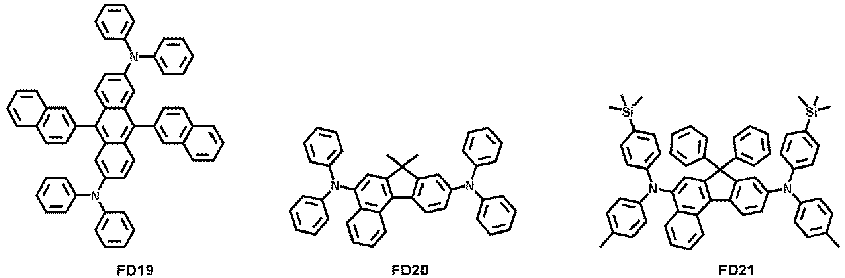

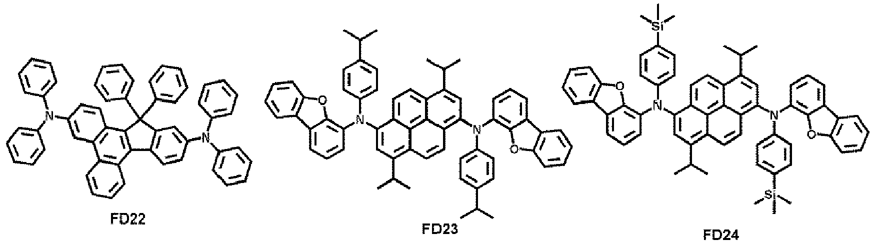

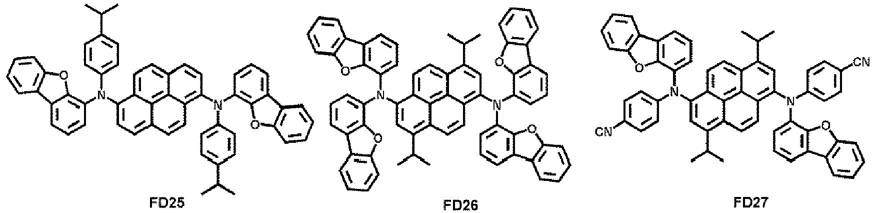

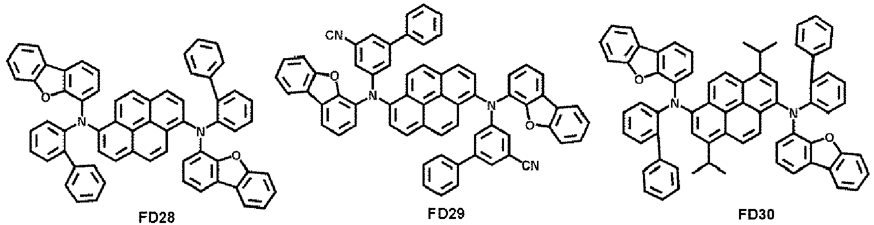

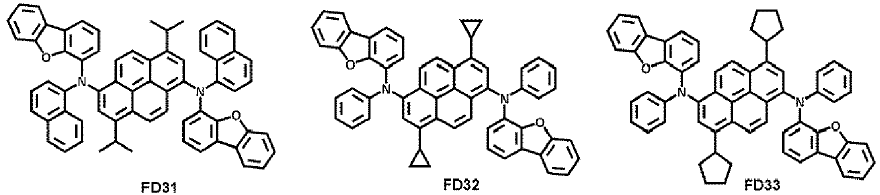

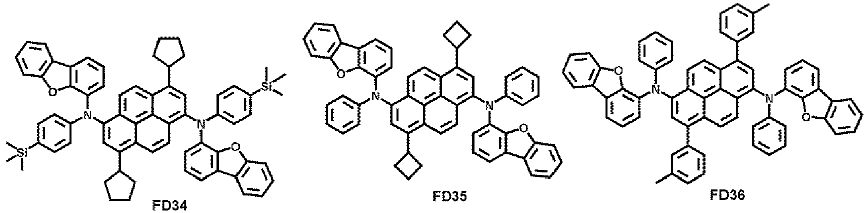

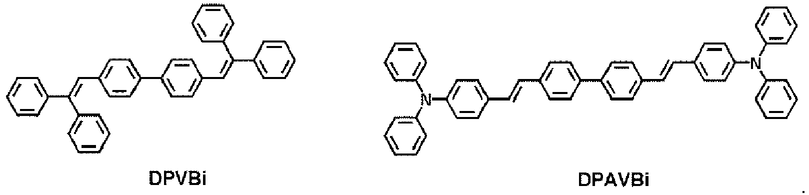

### [Delayed fluorescence material]

The emission layer may further include a delayed fluorescence material.

In the present specification, the delayed fluorescence material may be selected from compounds capable of emitting delayed fluorescence based on a delayed fluorescence emission mechanism.

The delayed fluorescence material included in the emission layer may act as a host or a dopant depending on the type of other materials included in the emission layer.

In an embodiment, a difference between a triplet energy level (eV) of the delayed fluorescence material and the singlet energy level (eV) of the delayed fluorescence material may be greater than or equal to 0 eV and less than or equal to 0.5 eV. When the difference between the triplet energy level (eV) of the delayed fluorescence material and the singlet energy level (eV) of the delayed fluorescence material is satisfied within the range above, up-conversion from the triplet state to the singlet state of the delayed fluorescence materials may effectively occur, and thus, the light-emitting device 10 may have improved luminescence efficiency.

For example, the delayed fluorescence material may include: i) a material including at least one electron donor (for example, a π electron-rich C₃-C₆₀ cyclic group and the like, such as a carbazole group) and at least one electron acceptor (for example, a sulfoxide group, a cyano group, a π electron-deficient nitrogen-containing C₁-C₆₀ cyclic group, and the like), ii) a material including a C₈-C₆₀ polycyclic group including at least two cyclic groups condensed to each other while sharing boron (B), and the like.

Examples of the delayed fluorescence material may include at least one of Compounds DF1 to DF14:

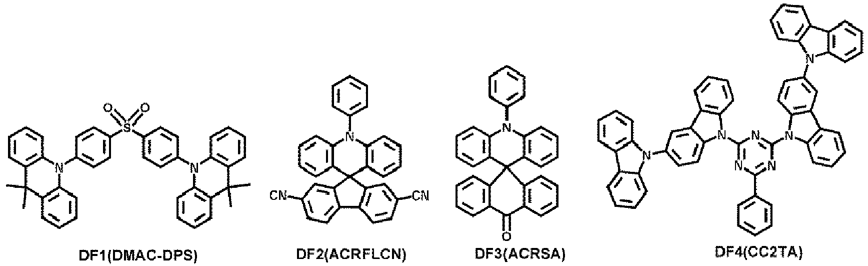

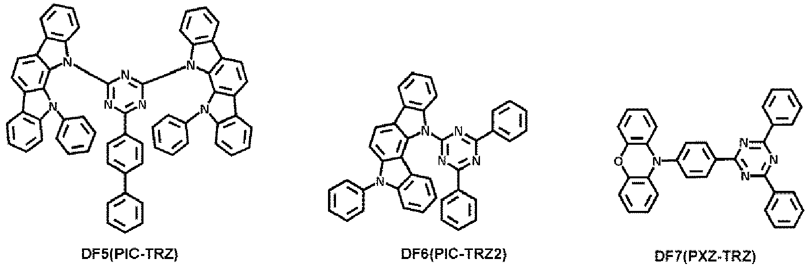

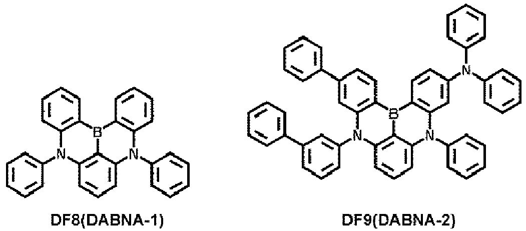

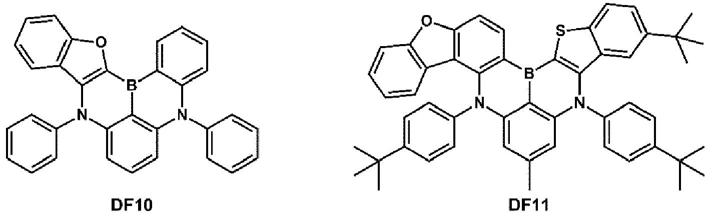

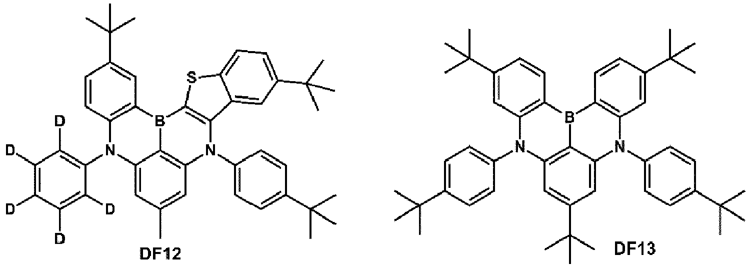

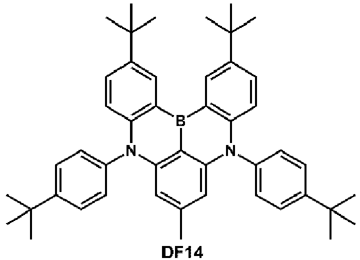

### [Electron transport region in interlayer 130]

The electron transport region may have: i) a single-layer structure consisting of a single layer consisting of a single material, ii) a single-layer structure consisting of a single layer consisting of multiple different materials, or iii) a multi-layer structure including multiple layers including different materials.

The electron transport region may include a buffer layer, a hole blocking layer, an electron control layer, an electron transport layer, an electron injection layer, or a combination thereof.

For example, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein constituent layers of each structure are sequentially stacked from the emission layer.

The electron transport region may include a heterocyclic compound (for example, a compound represented by Formula 8, etc.) as described in the present specification.

For example, the electron transport region may have a structure in which an electron transport layer and an electron injection layer are sequentially stacked, and the heterocyclic compound described in the present specification may be included in the electron transport layer.

In an embodiment, the electron transport region may have a structure in which a hole-blocking layer, an electron transport layer, and an electron injection layer are sequentially stacked, and the heterocyclic compound described in the present specification may be included in the electron transport layer.

The electron transport region (for example, a buffer layer, a hole-blocking layer, an electron control layer, or an electron transport layer in the electron transport region) may further include, in addition to the heterocyclic compound described herein, a metal-free compound including at least one π electron-deficient nitrogen-containing C₁-C₆₀ cyclic group.

For example, the electron transport region may further include a compound represented by Formula 601 in addition to the heterocyclic compound described in the present specification.

Formula 601 [Ar₆₀₁]ₓₑ₁₁-[(L₆₀₁)ₓₑ₁-R₆₀₁]ₓₑ₂₁

In Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each be the same as described in connection with Q₁,
xe21 may be 1, 2, 3, 4, or 5, and
at least one of Ar₆₀₁, L₆₀₁, and R₆₀₁ may each independently be a π electron-deficient nitrogen-containing C₁-C₆₀ cyclic group unsubstituted or substituted with at least one R₁₀ₐ.

In an embodiment, when xe11 in Formula 601 is 2 or more, two or more of Ar₆₀₁ may be linked to each other via a single bond.

In an embodiment, Ar₆₀₁ in Formula 601 may be a substituted or unsubstituted anthracene group.

For example, the electron transport region may further include a compound represented by Formula 601-1 in addition to the heterocyclic compound described in the present specification.

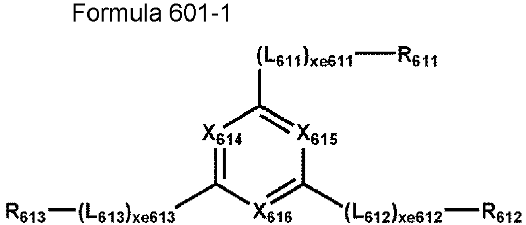

In Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may be N,
L_{611 to} L₆₁₃ may each be the same as described in connection with L₆₀₁,
xe611 to xe613 may each be the same as described in connection with xe1,
R₆₁₁ to R₆₁₃ may each be the same as described in connection with R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group unsubstituted or substituted with at least one R₁₀ₐ, or a C₁-C₆₀ heterocyclic group unsubstituted or substituted with at least one R₁₀ₐ.

For example, xe1 and xe611 to xe613 in Formulae 601 and 601-1 may each independently be 0, 1, or 2.

In an embodiment, the electron transport region may further include, in addition to the heterocyclic compound described in the present specification, one of the following compounds ET1 to ET46, 2,9-dimethyl-4,7-diphenyl-1,10-phenanthroline (BCP), 4,7-diphenyl-1,10-phenanthroline (Bphen), Alq3, BAIq, TAZ, NTAZ, or a combination thereof:

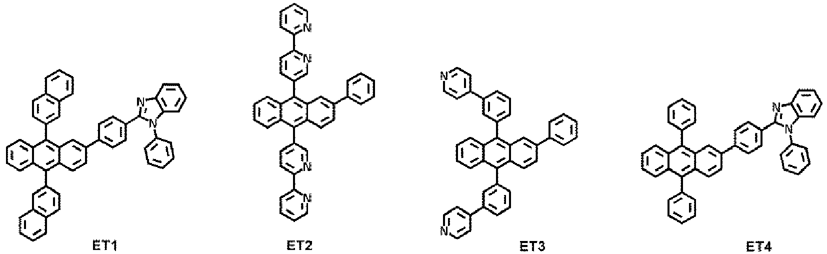

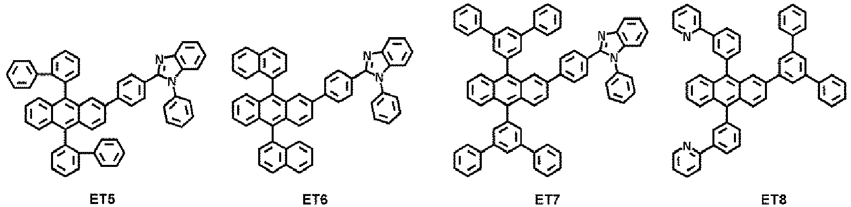

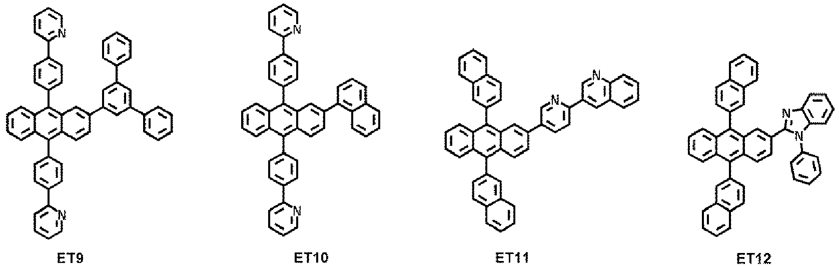

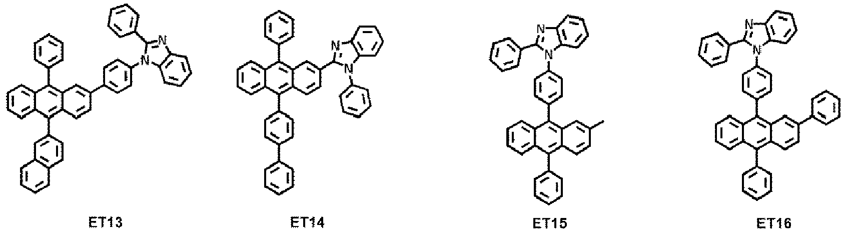

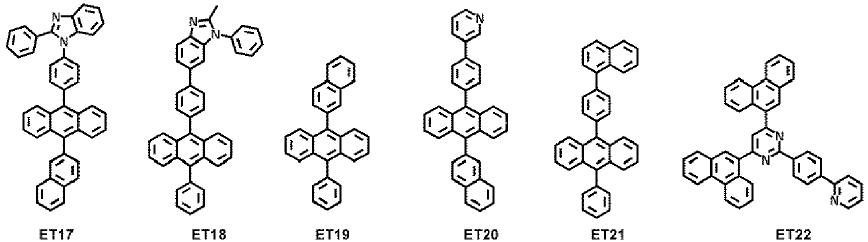

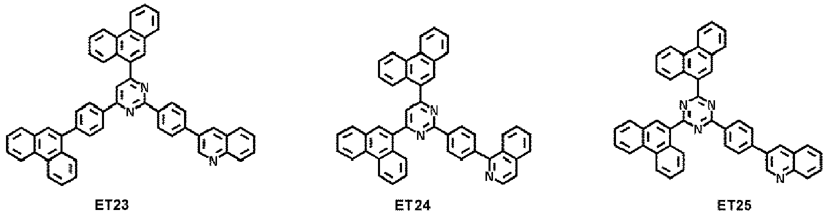

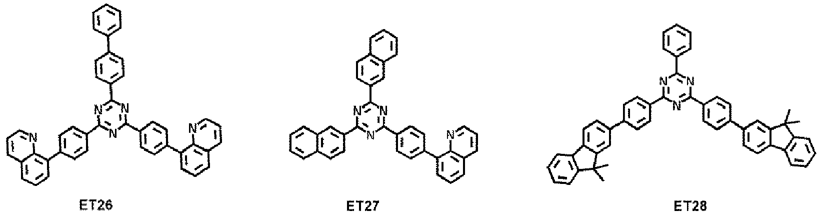

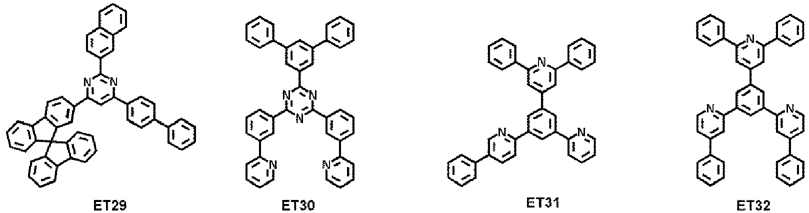

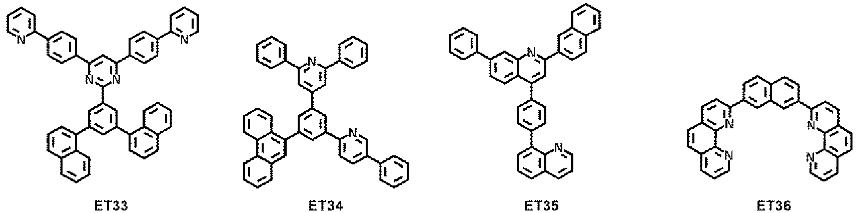

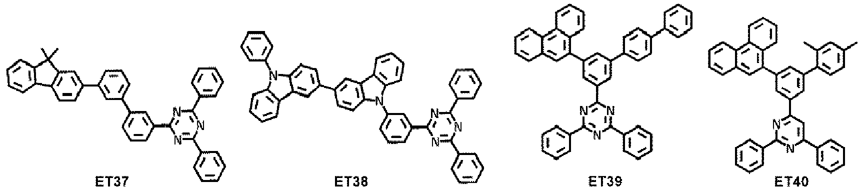

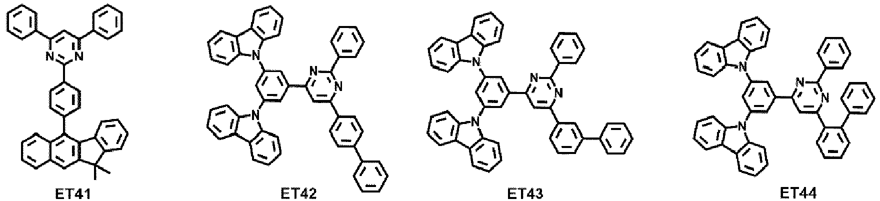

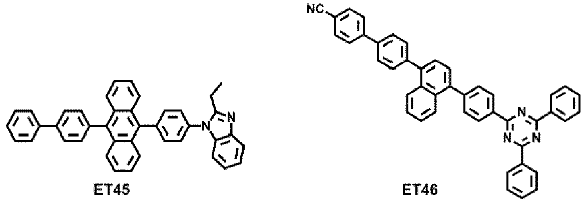

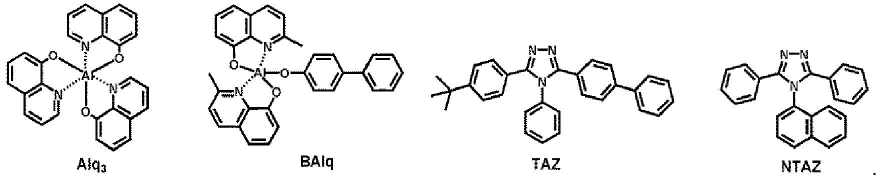

The thickness of the electron transport region may be in a range of about 100 Å to about 5,000 Å, for example, about 160 Å to about 4,000 Å. When the electron transport region includes a buffer layer, a hole blocking layer, an electron control layer, an electron transport layer, or a combination thereof, the thickness of the buffer layer, the hole blocking layer, or the electron control layer may be in a range of about 20 Å to about 1,000 Å, for example, about 30 Å to about 300 Å, and the thickness of the electron transport layer may be in a range of about 100 Å to about 1,000 Å, for example, about 150 Å to about 500 Å. When the thickness of the buffer layer, the hole-blocking layer, the electron control layer, the electron transport layer, and/or the electron transport layer are within these ranges, satisfactory electron transporting characteristics may be obtained without a substantial increase in driving voltage.

The electron transport region (for example, the electron transport layer in the electron transport region) may further include, in addition to the materials described above, a metal-containing material.

The metal-containing material may include an alkali metal complex, an alkaline earth metal complex, or a combination thereof. The metal ion of an alkali metal complex may be a Li ion, a Na ion, a K ion, a Rb ion, or a Cs ion, and the metal ion of an alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or a combination thereof.

For example, the metal-containing material may include a Li complex. The Li complex may include, for example, Compound ET-D1 (LiQ) or ET-D2:

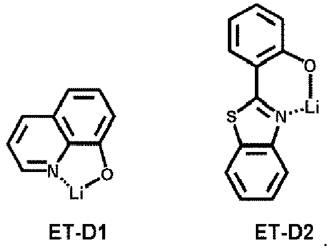

The electron transport region may include an electron injection layer that facilitates the injection of electrons from the second electrode 150. The electron injection layer may directly contact the second electrode 150.

The electron injection layer may have: i) a single-layer structure consisting of a single layer consisting of a single material, ii) a single-layer structure consisting of a single layer consisting of multiple different materials, or iii) a multi-layer structure including multiple layers including different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or a combination thereof.

The alkali metal may include Li, Na, K, Rb, Cs, or a combination thereof. The alkaline earth metal may include Mg, Ca, Sr, Ba, or a combination thereof. The rare earth metal may include Sc, Y, Ce, Tb, Yb, Gd, or a combination thereof.

The alkali metal-containing compound, the alkaline earth metal-containing compound, and the rare earth metal-containing compound may be oxides, halides (for example, fluorides, chlorides, bromides, iodides, etc.), or tellurides of the alkali metal, the alkaline earth metal, and the rare earth metal, or a combination thereof.

The alkali metal-containing compound may include: alkali metal oxides, such as Li₂O, Cs₂O, or K₂O; alkali metal halides, such as LiF, NaF, CsF, KF, Lil, Nal, Csl, KI, or Rbl; or a combination thereof. The alkaline earth metal-containing compound may include an alkaline earth metal compound, such as BaO, SrO, CaO, BaₓSr₁₋ₓO (wherein x is a real number satisfying 0<x<1), BaₓCa₁₋ₓO (wherein x is a real number satisfying 0<x<1), and the like. The rare earth metal-containing compound may include YbF₃, ScF₃, Sc₂O₃, Y₂O₃, Ce₂O₃, GdF₃, TbF₃, YbI₃, ScI₃, TbI₃, or a combination thereof. In an embodiment, the rare earth metal-containing compound may include lanthanide metal telluride. Examples of the lanthanide metal telluride are LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, Lu₂Te₃, and the like.

The alkali metal complex, the alkaline earth-metal complex, and the rare earth metal complex may include i) one of metal ions of the alkali metal, the alkaline earth metal, and the rare earth metal and ii), as a ligand bonded to the metal ion, for example, a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenyl benzimidazole, a hydroxyphenylbenzothiazole, a bipyridine, a phenanthroline, a cyclopentadiene, or a combination thereof.

In an embodiment, the electron injection layer may consist of an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or a combination thereof, as described above. In one or more embodiments, the electron injection layer may further include an organic material (for example, a compound represented by Formula 601).

In an embodiment, the electron injection layer may consist of i) an alkali metal-containing compound (for example, alkali metal halide), ii) a) an alkali metal-containing compound (for example, alkali metal halide); and b) an alkali metal, an alkaline earth metal, a rare earth metal, or a combination thereof. For example, the electron injection layer may be a KI:Yb co-deposited layer, an Rbl:Yb co-deposited layer, a LiF:Yb co-deposited layer, and the like.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or a combination thereof may be uniformly or non-uniformly dispersed in a matrix including the organic material.

The thickness of the electron injection layer may be in a range of about 1 Å to about 100 Å, and, for example, about 3 Å to about 90 Å. When the thickness of the electron injection layer is within the ranges above, satisfactory electron injection characteristics may be obtained without a substantial increase in driving voltage.

### [Second electrode 150]

The second electrode 150 may be arranged on the interlayer 130 having a structure as described above. The second electrode 150 may be a cathode, which is an electron injection electrode, and as a material for forming the second electrode 150, a metal, an alloy, an electrically conductive compound, or a combination thereof, each having a low-work function, may be used.

The second electrode 150 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or a combination thereof. The second electrode 150 may be a transmissive electrode, a semi-transmissive electrode, or a reflective electrode.

The second electrode 150 may have a single-layer structure or a multi-layer structure including multiple layers.

### [Capping layer]

The first capping layer may be arranged outside the first electrode 110, and/or the second capping layer may be arranged outside the second electrode 150. In particular, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

Light generated in the emission layer of the interlayer 130 of the light-emitting device 10 may be extracted toward the outside through the first electrode 110 which is a semi-transmissive electrode or a transmissive electrode, and the first capping layer. Light generated in the emission layer of the interlayer 130 of the light-emitting device 10 may be extracted toward the outside through the second electrode 150 which is a semi-transmissive electrode or a transmissive electrode, and the second capping layer.

The first capping layer and the second capping layer may increase external emission efficiency according to the principle of constructive interference. Accordingly, the light extraction efficiency of the light-emitting device 10 is increased, so that the luminescence efficiency of the light-emitting device 10 may be improved.

Each of the first capping layer and the second capping layer may include a material having a refractive index of greater than or equal to 1.6 (at 589 nm).

The first capping layer and the second capping layer may each independently be an organic capping layer including an organic material, an inorganic capping layer including an inorganic material, or an organic-inorganic composite capping layer including an organic material and an inorganic material.

At least one of the first capping layer and the second capping layer may each independently include a carbocyclic compound, a heterocyclic compound, an amine group-containing compound, a porphine derivative, a phthalocyanine derivative, a naphthalocyanine derivative, an alkali metal complex, an alkaline earth metal complex, or a combination thereof. The carbocyclic compound, the heterocyclic compound, and the amine group-containing compound may optionally be substituted with a substituent including O, N, S, Se, Si, F, Cl, Br, I, or a combination thereof. In an embodiment, at least one of the first capping layer and the second capping layer may each independently include an amine group-containing compound.

In one or more embodiments, at least one of the first capping layer and the second capping layer may each independently include a compound represented by Formula 201, a compound represented by Formula 202, or a combination thereof.

In one or more embodiments, at least one of the first capping layer and the second capping layer may each independently include: one of Compounds HT28 to HT33; one of Compounds CP1 to CP6; β-NPB; or a combination thereof:

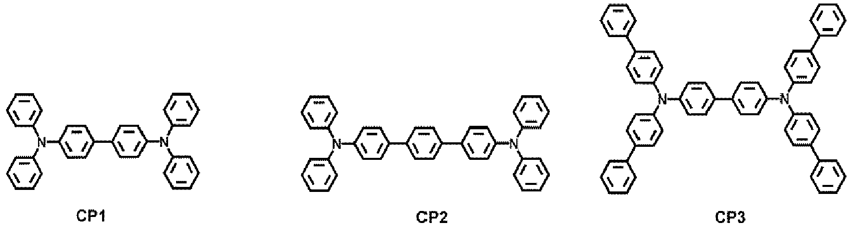

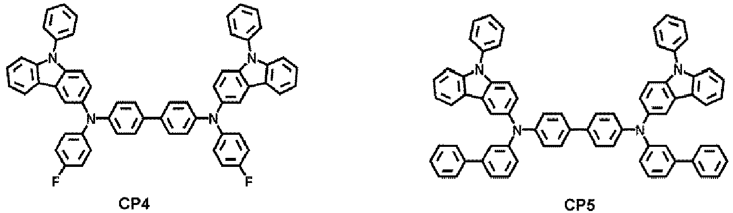

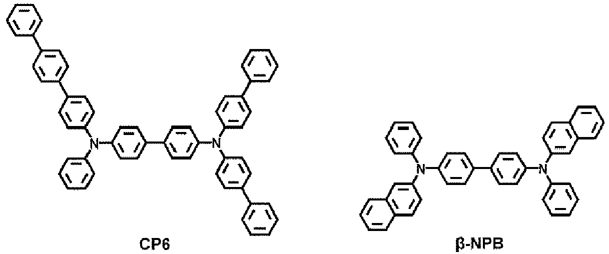

### [Electronic device]

The light-emitting device may be included in various electronic devices. For example, the electronic device including the light-emitting device may be a light-emitting device, an authentication apparatus, or the like.

The electronic device (for example, a light-emitting device) may further include, in addition to the light-emitting device, i) a color filter, ii) a color conversion layer, or iii) a color filter and a color conversion layer. The color filter and/or the color conversion layer may be arranged in at least one traveling direction of light emitted from the light-emitting device. For example, the light emitted from the light-emitting device may be blue light, green light, or white light. Details on the light-emitting device may be referred to the descriptions provided herein. In an embodiment, the color conversion layer may include a quantum dot.

The electronic device may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be arranged among the subpixel areas to define each of the subpixel areas.

The color filter may further include a plurality of color filter areas and light-shielding patterns arranged among the color filter areas, and the color conversion layer may further include a plurality of color conversion areas and light-shielding patterns arranged among the color conversion areas.

The plurality of color filter areas (or the plurality of color conversion areas) may include a first area emitting first color light, a second area emitting second color light, and/or a third area emitting third color light, wherein the first color light, the second color light, and/or the third color light may have different maximum emission wavelengths from one another. For example, the first color light may be red light, the second color light may be green light, and the third color light may be blue light. For example, the plurality of color filter areas (or the plurality of color conversion areas) may include quantum dots. In particular, the first area may include a red quantum dot, the second area may include a green quantum dot, and the third area may not include a quantum dot. Details on the quantum dot may be referred to the descriptions provided herein. The first area, the second area, and/or the third area may each further include a scatter.

For example, the light-emitting device may emit first light, the first area may absorb the first light to emit first-first color light, the second area may absorb the first light to emit second-first color light, and the third area may absorb the first light to emit third-first color light. Here, the first-first color light, the second-first color light, and the third-first color light may have different maximum emission wavelengths. In particular, the first light may be blue light, the first-first color light may be red light, the second-first color light may be green light, and the third-first color light may be blue light.

The electronic device may further include a thin-film transistor, in addition to the light-emitting device as described above. The thin-film transistor may include a source electrode, a drain electrode, and an activation layer, wherein any one of the source electrode and the drain electrode may be electrically connected to any one of the first electrode and the second electrode of the light-emitting device.

The thin-film transistor may further include a gate electrode, a gate insulating film, and the like.

The activation layer may include crystalline silicon, amorphous silicon, an organic semiconductor, an oxide semiconductor, and the like.

The electronic device may further include a sealing portion for sealing the light-emitting device. The sealing portion may be arranged between the color filter and/or the color conversion layer and the light-emitting device. The sealing portion allows light from the light-emitting device to be extracted to the outside, and simultaneously prevents ambient air and moisture from penetrating into the light-emitting device. The sealing portion may be a sealing substrate including a transparent glass substrate or a plastic substrate. The sealing portion may be a thin-film encapsulation layer including at least one layer of an organic layer and/or an inorganic layer. When the sealing portion is a thin film encapsulation layer, the electronic device may be flexible.

Various functional layers may be additionally located on the sealing portion, in addition to the color filter and/or the color conversion layer, according to the use of the electronic device. Examples of the functional layers may include a touch screen layer, a polarizing layer, and the like. The touch screen layer may be a pressure-sensitive touch screen layer, a capacitive touch screen layer, or an infrared touch screen layer. The authentication apparatus may be, for example, a biometric authentication apparatus that authenticates an individual by using biometric information of a living body (for example, fingertips, pupils, etc.).

The authentication apparatus may further include, in addition to the light-emitting device as described above, a biometric information collector.

The electronic device may be applied to various displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, various measuring instruments, meters (for example, meters for a vehicle, an aircraft, and a vessel), projectors, and the like.

### [Electronic apparatus]

The light-emitting device may be included in various electronic apparatuses.

For example, the electronic apparatus including the light-emitting device may be a flat panel display, a curved display, a computer monitor, a medical monitor, a television, a billboard, a light for indoor or outdoor lighting and/or signaling, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro display, a 3D display, a virtual or augmented reality display, a vehicle, a video wall including multiple displays tiled together, a theater or stadium screen, a phototherapy device, and a signboard.

The light-emitting device may have excellent effects in terms of luminescence efficiency long lifespan, and thus the electronic apparatus including the light-emitting device may have characteristics, such as high luminance, high resolution, and low power consumption.

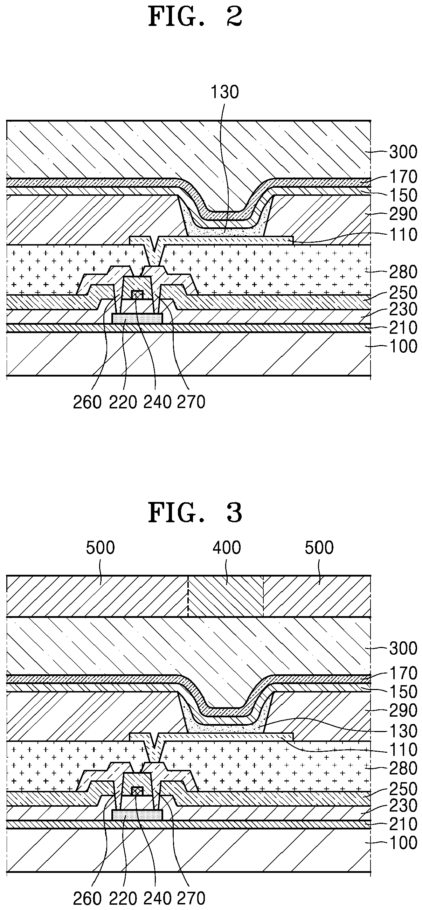

### [Description of FIGS. 2 and 3]

FIG. 2 is a cross-sectional view of a light-emitting device, which is one of electronic devices according to an embodiment.

The light-emitting apparatus of FIG. 2 includes a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be arranged on the substrate 100. The buffer layer 210 may prevent penetration of impurities through the substrate 100 and may provide a flat surface on the substrate 100.

A TFT may be arranged on the buffer layer 210. The TFT may include an activation layer 220, a gate electrode 240, a source electrode 260, and a drain electrode 270.

The activation layer 220 may include an inorganic semiconductor such as silicon or polysilicon, an organic semiconductor, or an oxide semiconductor, and may include a source region, a drain region, and a channel region.

A gate insulating film 230 for insulating the activation layer 220 from the gate electrode 240 may be arranged on the activation layer 220, and the gate electrode 240 may be arranged on the gate insulating film 230.

An interlayer insulating film 250 may be arranged on the gate electrode 240. The interlayer insulating film 250 may be arranged between the gate electrode 240 and the source electrode 260 and between the gate electrode 240 and the drain electrode 270, to insulate from one another.

The source electrode 260 and the drain electrode 270 may be arranged on the interlayer insulating film 250. The interlayer insulating film 250 and the gate insulating film 230 may be formed to expose the source region and the drain region of the activation layer 220, and the source electrode 260 and the drain electrode 270 may be arranged in contact with the exposed portions of the source region and the drain region of the activation layer 220.

The TFT may be electrically connected to a light-emitting device to drive the light-emitting device, and may be covered and protected by a passivation layer 280. The passivation layer 280 may include an inorganic insulating film, an organic insulating film, or a combination thereof. A light-emitting device may be provided on the passivation layer 280. The light-emitting device may include the first electrode 110, the interlayer 130, and the second electrode 150.

The first electrode 110 may be arranged on the passivation layer 280. The passivation layer 280 may be arranged to expose a portion of the drain electrode 270, not fully covering the drain electrode 270, and the first electrode 110 may be arranged to be connected to the exposed portion of the drain electrode 270.

A pixel defining layer 290 including an insulating material may be arranged on the first electrode 110. The pixel defining layer 290 may expose a certain region of the first electrode 110, and an interlayer 130 may be formed in the exposed region of the first electrode 110. The pixel defining layer 290 may be a polyimide-based organic film or a polyacrylic-based organic film. Although not shown in FIG. 2, at least some layers of the interlayer 130 may extend beyond the upper portion of the pixel defining layer 290 to be arranged in the form of a common layer.

A second electrode 150 may be located on the interlayer 130, and a second capping layer 170 may be additionally formed on the second electrode 150. The second capping layer 170 may be formed to cover the second electrode 150.

The encapsulation portion 300 may be located on the second capping layer 170. The encapsulation portion 300 may be arranged on a light-emitting device to protect the light-emitting device from moisture or oxygen. The encapsulation portion 300 may include: an inorganic film including silicon nitride (SiNx), silicon oxide (SiOx), indium tin oxide, indium zinc oxide, or a combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, or the like), an epoxy-based resin (for example, aliphatic glycidyl ether (AGE), or the like), or a combination thereof; or a combination of the inorganic films and the organic films.

FIG. 3 is a cross-sectional view of a light-emitting device, which is one of electronic devices according to an embodiment.

The light-emitting apparatus of FIG. 3 is the same as the light-emitting apparatus of FIG. 2, except that a light-shielding pattern 500 and a functional region 400 are additionally located on the encapsulation portion 300. The functional region 400 may be i) a color filter area, ii) a color conversion area, or iii) a combination of the color filter area and the color conversion area. In an embodiment, the light-emitting device included in the light-emitting apparatus of FIG. 3 may be a tandem light-emitting device.

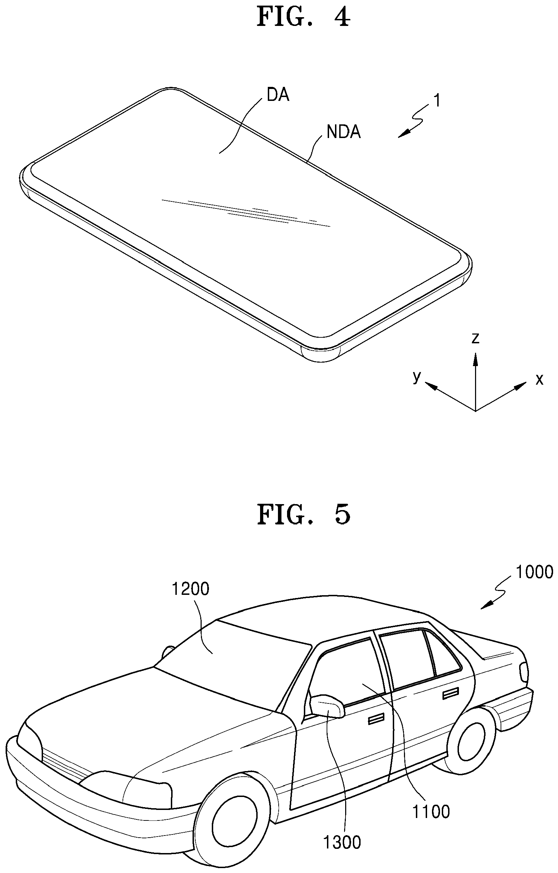

### [Description of FIG. 4]

FIG. 4 is a schematic perspective view of electronic apparatus 1 including a light-emitting device according to an embodiment. The electronic apparatus 1 may be, as a device apparatus that displays a moving image or still image, a portable electronic apparatus, such as a mobile phone, a smart phone, a tablet personal computer (PC), a mobile communication terminal, an electronic notebook, an electronic book, a portable multimedia player (PMP), a navigation, or a ultra mobile PC (UMPC), as well as various products, such as a television, a laptop, a monitor, a billboards, or an Internet of things (IOT). The electronic apparatus 1 may be such a product above or a part thereof. In addition, the electronic apparatus 1 may be a wearable device, such as a smart watch, a watch phone, a glasses-type display, or a head mounted display (HMD), or a part of the wearable device. However, embodiments of the disclosure are not limited thereto. For example, the electron apparatus 1 may include a dashboard of a vehicle, a center fascia of a vehicle, a center information display arranged on a dashboard of a vehicle, a room mirror display replacing a side mirror of a vehicle, an entertainment display for the rear seat of a vehicle or a display arranged on the back of the front seat, or a head up display (HUD) installed in the front of a vehicle or projected on a front window glass, a computer generated hologram augmented reality head up display (CGH AR HUD). FIG. 4 illustrates a case in which the electronic apparatus 1 is a smart phone for convenience of explanation.

The electronic apparatus 1 may include a display area DA and a non-display area NDA outside the display area DA. A display device may implement an image through an array of a plurality of pixels that are two-dimensionally arranged in the display area DA.

The non-display area NDA is an area that does not display an image, and may entirely surround the display area DA. On the non-display area NDA, a driver for providing electrical signals or power to display devices arranged on the display area DA may be arranged. On the non-display area NDA, a pad, which is an area to which an electronic element or a printing circuit board, may be electrically connected may be arranged.

In the electronic apparatus 1, a length in the x-axis direction and a length in the y-axis direction may be different from each other. In an embodiment, as shown in FIG. 4 , the length in the x-axis direction may be shorter than the length in the y-axis direction. In one or more embodiments, the length in the x-axis direction may be the same as the length in the y-axis direction. In one or more embodiments, the length in the x-axis direction may be longer than the length in the y-axis direction.

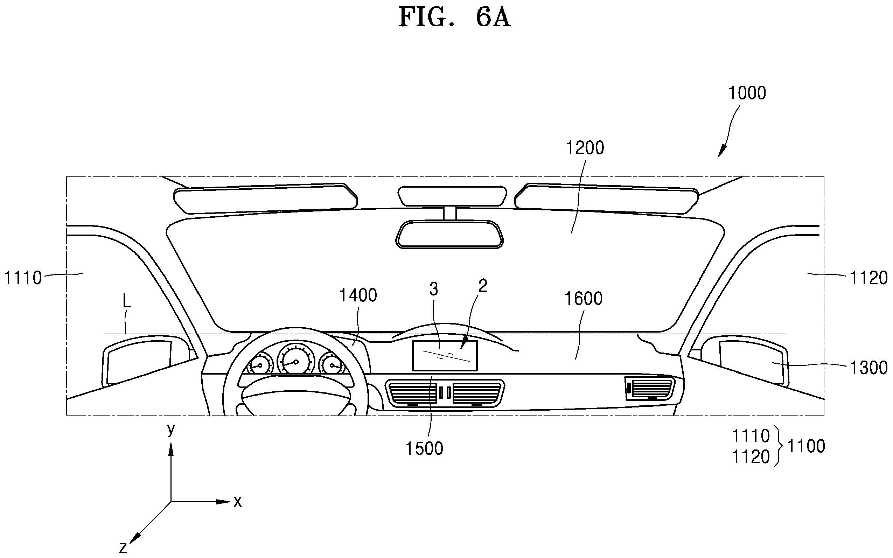

[Description of FIGS. 5 and 6A to 6C] FIG. 5 is a schematic view of exterior of a vehicle 1000 as an electronic apparatus including a light-emitting device according to an embodiment. FIGS. 6A to 6C are each a diagram schematically illustrating an interior of a vehicle 1000 according to various embodiments.

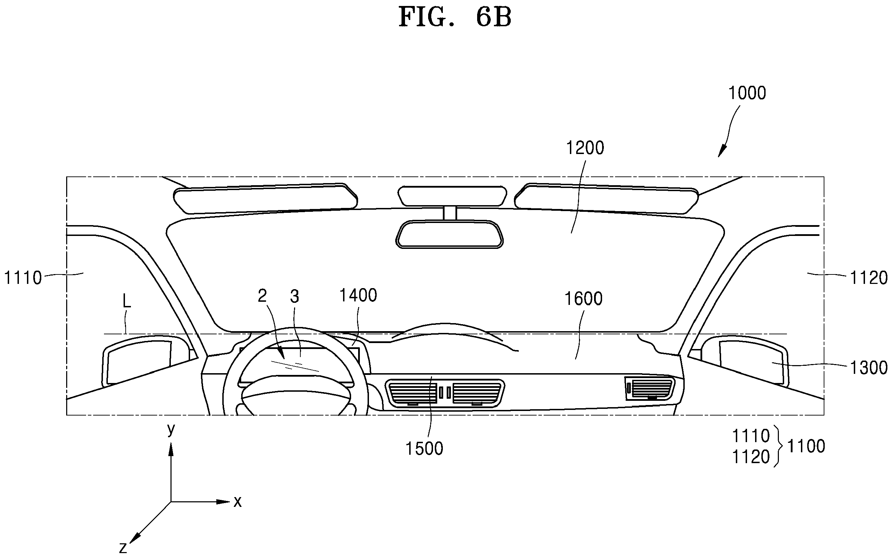

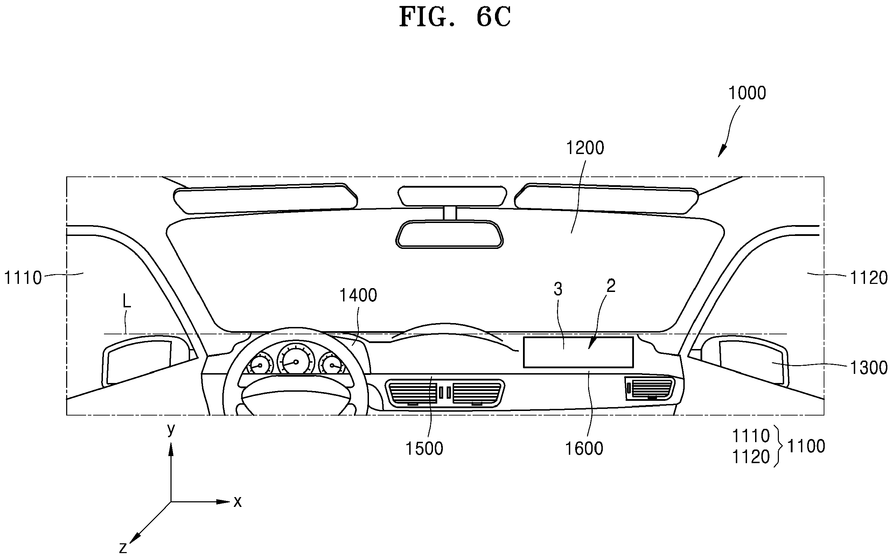

Referring to FIGS. 5, 6A, 6B, and 6C, the vehicle 1000 may refer to various apparatuses for moving a subject to be transported, such as a human, an object, or an animal, from a departure point to a destination point. The vehicle 1000 may include a vehicle traveling on a road or track, a vessel moving over the sea or river, an airplane flying in the sky using the action of air, and the like.

The vehicle 1000 may travel on a road or a track. The vehicle 1000 may move in a predetermined direction according to rotation of at least one wheel. For example, the vehicle 1000 may include a three-wheeled or four-wheeled vehicle, a construction machine, a two-wheeled vehicle, a prime mover device, a bicycle, and a train running on a track.

The vehicle 1000 may include a body having an interior and an exterior, and a chassis in which mechanical apparatuses necessary for driving are installed as other parts except for the body. The exterior of the body may include a front panel, a bonnet, a roof panel, a rear panel, a trunk, a pillar provided at a boundary between doors, and the like. The chassis of the vehicle 1000 may include a power generating device, a power transmitting device, a driving device, a steering device, a braking device, a suspension device, a transmission device, a fuel device, front and rear left and right wheels, and the like.

The vehicle 1000 may include a side window glass 1100, a front window glass 1200, a side mirror 1300, a cluster 1400, a center fascia 1500, a passenger seat dashboard 1600, and a display device 2.

The side window glass 1100 and the front window glass 1200 may be partitioned by a pillar arranged between the side window glass 1100 and the front window glass 1200.

The side window glass 1100 may be installed on the side of the vehicle 1000. In an embodiment, the side window glass 1100 may be installed on a door of the vehicle 1000. A plurality of side window glasses 1100 may be provided and may face each other. In an embodiment, the side window glass 1100 may include a first side window glass 1110 and a second side window glass 1120. In an embodiment, the first side window glass 1110 may be arranged adjacent to the cluster 1400. The second side window glass 1120 may be arranged adjacent to the passenger seat dashboard 1600.

In an embodiment, the side window glasses 1100 may be spaced apart from each other in the x-direction or the -x-direction. For example, the first side window glass 1110 and the second side window glass 1120 may be spaced apart from each other in the x direction or the -x direction. In other words, an imaginary straight line L connecting the side window glasses 1100 may extend in the x-direction or the -x-direction. For example, an imaginary straight line L connecting the first side window glass 1110 and the second side window glass 1120 to each other may extend in the x direction or the -x direction.

The front window glass 1200 may be installed in front of the vehicle 1000. The front window glass 1200 may be arranged between the side window glasses 1100 facing each other.

The side mirror 1300 may provide a rear view of the vehicle 1000. The side mirror 1300 may be installed on the exterior of the vehicle body. In one embodiment, a plurality of side mirrors 1300 may be provided. Any one of the plurality of side mirrors 1300 may be arranged outside the first side window glass 1110. The other one of the plurality of side mirrors 1300 may be arranged outside the second side window glass 1120.

The cluster 1400 may be arranged in front of the steering wheel. The cluster 1400 may include a tachometer, a speedometer, a coolant thermometer, a fuel gauge turn indicator, a high beam indicator, a warning lamp, a seat belt warning lamp, an odometer, an odometer, an automatic shift selector indicator lamp, a door open warning lamp, an engine oil warning lamp, and /or a low fuel warning light.

The center fascia 1500 may include a control panel on which a plurality of buttons for adjusting an audio device, an air conditioning device, and a heater of a seat are disposed. The center fascia 1500 may be arranged on one side of the cluster 1400.

A passenger seat dashboard 1600 may be spaced apart from the cluster 1400 with the center fascia 1500 arranged therebetween. In an embodiment, the cluster 1400 may be arranged to correspond to a driver seat (not shown), and the passenger seat dashboard 1600 may be disposed to correspond to a passenger seat (not shown). In an embodiment, the cluster 1400 may be adjacent to the first side window glass 1110, and the passenger seat dashboard 1600 may be adjacent to the second side window glass 1120.

In an embodiment, the display device 2 may include a display panel 3, and the display panel 3 may display an image. The display device 2 may be arranged inside the vehicle 1000. In an embodiment, the display device 2 may be arranged between the side window glasses 1100 facing each other. The display device 2 may be arranged on at least one of the cluster 1400, the center fascia 1500, and the passenger seat dashboard 1600.

The display device 2 may include an organic light-emitting display device, an inorganic EL display device, a quantum dot display device, and the like. Hereinafter, as the display device 2 according to an embodiment of the present disclosure, an organic light-emitting display device including the light-emitting device according to the present disclosure will be described as an example, but various types of display devices as described above may be used in embodiments of the present disclosure.

Referring to FIG. 6A, the display device 2 may be arranged on the center fascia 1500. In an embodiment, the display device 2 may display navigation information. In an embodiment, the display device 2 may display audio, video, or information regarding vehicle settings.

Referring to FIG. 6B , the display device 2 may be arranged on the cluster 1400. When the display device 2 is arranged on the cluster 1400, the cluster 1400 may display driving information and the like through the display device 2. That is, the cluster 1400 may be implemented digitally. The digital cluster 1400 may display vehicle information and driving information as images. For example, a needle and a gauge of a tachometer and various warning light icons may be displayed by a digital signal.

Referring to FIG. 6C, the display device 2 may be arranged on the passenger seat dashboard 1600. The display device 2 may be embedded in the passenger seat dashboard 1600 or arranged on the passenger seat dashboard 1600. In an embodiment, the display device 2 arranged on the for the passenger seat dashboard 1600 may display an image related to information displayed on the cluster 1400 and/or information displayed on the center fascia 1500. In one or more embodiments, the display device 2 arranged on the passenger seat dashboard 1600 may display information different from information displayed on the cluster 1400 and/or information displayed on the center fascia 1500.

### [Manufacturing method]

Respective layers included in the hole transport region, the emission layer, and respective layers included in the electron transport region may be formed in a certain region by using one or more suitable methods selected from vacuum deposition, spin coating, casting, Langmuir-Blodgett (LB) deposition, ink-jet printing, laser-printing, laser-induced thermal imaging, and the like.

When respective layers included in the hole transport region, the emission layer, and respective layers included in the electron transport region are formed by vacuum deposition, the deposition may be performed at a deposition temperature of about 100 °C to about 500 °C, a vacuum degree of about 10⁻⁸ torr to about 10⁻³ torr, and a deposition speed of about 0.01 Å/sec to about 100 Å/sec, depending on a material to be included in a layer to be formed and the structure of a layer to be formed.

### [Definition of terms]

The term "C₃-C₆₀ carbocyclic group" as used herein refers to a cyclic group consisting of carbon only as a ring-forming atom and having three to sixty carbon atoms, and the term "C₁-C₆₀ heterocyclic group" as used herein refers to a cyclic group that has one to sixty carbon atoms and further has, in addition to carbon, a heteroatom as a ring-forming atom. The C₃-C₆₀ carbocyclic group and the C₁-C₆₀ heterocyclic group may each be a monocyclic group consisting of one ring or a polycyclic group in which two or more rings are condensed with each other. For example, the number of ring-forming atoms of the C₁-C₆₀ heterocyclic group may be from 3 to 61.

The "cyclic group" as used herein may include both the C₃-C₆₀ carbocyclic group and the C₁-C₆₀ heterocyclic group.

The term "π electron-rich C₃-C₆₀ cyclic group" as used herein refers to a cyclic group that has three to sixty carbon atoms and does not include *-N=*' as a ring-forming moiety, and the term "π electron-deficient nitrogen-containing C₁-C₆₀ cyclic group" as used herein refers to a heterocyclic group that has one to sixty carbon atoms and includes *-N=*' as a ring-forming moiety.

For example,
the C₃-C₆₀ carbocyclic group may be i) a T1 group or ii) a condensed cyclic group in which two or more T1 groups are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) a T2 group, ii) a condensed cyclic group in which at least two T2 groups are condensed with each other, or iii) a condensed cyclic group in which at least one T2 group and at least one T1 group are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, or the like),
the π electron-rich C₃-C₆₀ cyclic group may be i) a T1 group, ii) a condensed cyclic group in which at least two T1 groups are condensed with each other, iii) a T3 group, iv) a condensed cyclic group in which at least two T3 groups are condensed with each other, or v) a condensed cyclic group in which at least one T3 group and at least one T1 group are condensed with each other (for example, the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, or the like),
the π electron-deficient nitrogen-containing C₁-C₆₀ cyclic group may be i) a T4 group, ii) a condensed cyclic group in which at least two T4 groups are condensed with each other, iii) a condensed cyclic group in which at least one T4 group and at least one T1 group are condensed with each other, iv) a condensed cyclic group in which at least one T4 group and at least one T3 group are condensed with each other, or v) a condensed cyclic group in which at least one T4 group, at least one T1 group, and at least one T3 group are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and the like),
the T1 group may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,
group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
the T3 group may be a furan group, a thiophene group, a 1H-pyrrole group, a silole group, or a borole group, and
the T4 group may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group, the C₃-C₆₀ carbocyclic group, the C₁-C₆₀ heterocyclic group, the π electron-rich C₃-C₆₀ cyclic group, or the π electron-deficient nitrogen-containing C₁-C₆₀ cyclic group" as used herein refer to a group condensed to any cyclic group, a monovalent group, or a polyvalent group (for example, a divalent group, a trivalent group, a tetravalent group, etc.) according to the structure of a formula for which the corresponding term is used. For example, the "benzene group" may be a benzo group, a phenyl group, a phenylene group, or the like, which may be easily understood by one of ordinary skill in the art according to the structure of a formula including the "benzene group."

Examples of the monovalent C₃-C₆₀ carbocyclic group and the monovalent C₁-C₆₀ heterocyclic group are a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Examples of the divalent C₃-C₆₀ carbocyclic group and the monovalent C₁-C₆₀ heterocyclic group are a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group" as used herein refers to a linear or branched aliphatic hydrocarbon monovalent group that has one to sixty carbon atoms, and specific examples thereof are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as used herein refers to a divalent group having the same structure as the C₁-C₆₀ alkyl group.

The term "C₂-C₆₀ alkenyl group" as used herein refers to a monovalent hydrocarbon group having at least one carbon-carbon double bond in the middle or at the terminus of the C₂-C₆₀ alkyl group, and examples thereof are an ethenyl group, a propenyl group, a butenyl group, and the like. The term "C₂-C₆₀ alkenylene group" as used herein refers to a divalent group having the same structure as the C₂-C₆₀ alkenyl group.

The term "C₂-C₆₀ alkynyl group" as used herein refers to a monovalent hydrocarbon group having at least one carbon-carbon triple bond in the middle or at the terminus of the C₂-C₆₀ alkyl group, and examples thereof are an ethynyl group, a propynyl group, and the like. The term "C₂-C₆₀ alkynylene group" as used herein refers to a divalent group having the same structure as the C₂-C₆₀ alkynyl group.

The term "C₁-C₆₀ alkoxy group" as used herein refers to a monovalent group represented by -OA₁₀₁ (wherein A₁₀₁ is the C₁-C₆₀ alkyl group), and examples thereof are a methoxy group, an ethoxy group, an isopropyloxy group, and the like.

The term "C₃-C₁₀ cycloalkyl group" as used herein refers to a monovalent saturated hydrocarbon cyclic group having 3 to 10 carbon atoms, and examples thereof are a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, a bicyclo[2.2.2]octyl group, and the like. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent cyclic group of 1 to 10 carbon atoms, further including, in addition to carbon atoms, at least one heteroatom, as ring-forming atoms, and examples thereof are a 1,2,3,4-oxatriazolidinyl group, a tetrahydrofuranyl group, a tetrahydrothiophenyl group, and the like. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent cyclic group that has three to ten carbon atoms and at least one carbon-carbon double bond in the ring thereof and no aromaticity, and examples thereof are a cyclopentenyl group, a cyclohexenyl group, a cycloheptenyl group, and the like. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent cyclic group of 1 to 10 carbon atoms, further including, in addition to carbon atoms, at least one heteroatom, as ring-forming atoms, and having at least one carbon-carbon double bond in the cyclic structure thereof. Examples of the C₁-C₁₀ heterocycloalkenyl group are a 4,5-dihydro-1,2,3,4-oxatriazolyl group, a 2,3-dihydrofuranyl group, a 2,3-dihydrothiophenyl group, and the like. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system of 6 to 60 carbon atoms, and the term "C₆-C₆₀ arylene group" as used herein refers to a divalent group having a carbocyclic aromatic system of 6 to 60 carbon atoms. Examples of the C₆-C₆₀ aryl group are a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, an ovalenyl group, and the like. When the C₆-C₆₀ aryl group and the C₆-C₆₀ arylene group each include two or more rings, the rings may be condensed with each other.

The term "C₁-C₆₀ heteroaryl group" as used herein refers to a monovalent group having a heterocyclic aromatic system of 1 to 60 carbon atoms, further including, in addition to carbon atoms, at least one heteroatom, as ring-forming atoms. The term "C₁-C₆₀ heteroarylene group" as used herein refers to a divalent group having a heterocyclic aromatic system of 1 to 60 carbon atoms, further including, in addition to carbon atoms, at least one heteroatom, as ring-forming atoms. Examples of the C₁-C₆₀ heteroaryl group are a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each include two or more rings, the rings may be condensed with each other.

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group are an indenyl group, a fluorenyl group, a spiro-bifluorenyl group, a benzofluorenyl group, an indenophenanthrenyl group, an indeno anthracenyl group, and the like. The term "divalent non-aromatic condensed polycyclic group" as used herein refers to a divalent group having the same structure as the monovalent non-aromatic condensed polycyclic group described above.

The term "monovalent non-aromatic condensed heteropolycyclic group" as used herein refers to a monovalent group (for example, having 1 to 60 carbon atoms) having two or more rings condensed to each other, further including, in addition to carbon atoms, at least one heteroatom, as ring-forming atoms, and having non-aromaticity in its entire molecular structure. Examples of the monovalent non-aromatic condensed heteropolycyclic group are a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indeno carbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group" as used herein refers to a divalent group having the same structure as the monovalent non-aromatic condensed heteropolycyclic group described above.

The term "C₆-C₆₀ aryloxy group" as used herein indicates -OA₁₀₂ (wherein A₁₀₂ is the C₆-C₆₀ aryl group), and the term "C₆-C₆₀ arylthio group" as used herein indicates - SA₁₀₃ (wherein A₁₀₃ is the C₆-C₆₀ aryl group).

The term "C₇₋C₆₀ arylalkyl group" as used herein refers to -A₁₀₄A₁₀₅ (wherein A₁₀₄ is a C₁-C₅₄ alkylene group, and A₁₀₅ is a C₆-C₅₉ aryl group), and the term "C₂-C₆₀ heteroarylalkyl group" as used herein refers to -A₁₀₆A₁₀₇ (wherein A₁₀₆ is a C₁-C₅₉ alkylene group, and A₁₀₇ is a C₁-C₅₉ heteroaryl group).

The term "R₁₀ₐ" as used herein may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), -P(=O)(Q₁₁)(Q₁₂), or a combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or a combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q31)(Q32).

Q₁ to Q₃, Q₁₁ to Q₁₃, Q₂₁ to Q₂₃, and Q₃₁ to Q₃₃ used herein may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or a combination thereof.

The term "heteroatom" as used herein refers to any atom other than a carbon atom. Examples of the heteroatom are O, S, N, P, Si, B, Ge, Se, and a combination thereof.

In the present specification, the third-row transition metal may include hafnium (Hf), tantalum (Ta), tungsten (W), rhenium (Re), osmium (Os), iridium (Ir), platinum (Pt), gold (Au), and the like.

"Ph" as used herein refers to a phenyl group, "Me" as used herein refers to a methyl group, "Et" as used herein refers to an ethyl group, "ter-Bu" or "Bu^{t}" as used herein refers to a tert-butyl group, and "OMe" as used herein refers to a methoxy group.

The term "biphenyl group" as used herein refers to "a phenyl group substituted with a phenyl group." In other words, the "biphenyl group" may be a substituted phenyl group having a C₆-C₆₀ aryl group as a substituent.

The term "terphenyl group" as used herein refers to "a phenyl group substituted with a biphenyl group." In other words, the "terphenyl group" may be a substituted phenyl group having, as a substituent, a C₆-C₆₀ aryl group substituted with a C₆-C₆₀ aryl group.
* and *' as used herein, unless defined otherwise, each refer to a binding site to a neighboring atom in a corresponding formula or moiety.

Hereinafter, a light-emitting device according to embodiments will be described in detail with reference to Examples.

### [Examples]

### Evaluation Example 1

The HOMO energy level, LUMO energy level, band gap, and percentage of ³MLCT of each of Compounds GD-1 to GD-12 were evaluated according to the method in Table 1, and results thereof are shown in Table 2.

**Table 1**

| | |
|---|---|
| HOMO energy level evaluation method | By using cyclic voltammetry (CV) (electrolyte: 0.1 M Bu₄NPF₆/solvent: dimethylforamide (DMF)/electrode: 3-electrode system (working electrode: GC, reference electrode: Ag/AgCl, and auxiliary electrode: Pt)), the potential (V)-current (A) graph of each compound was obtained, and then, from the oxidation onset of the graph, |
| | the HOMO energy level of each compound was calculated. |
| LUMO energy level evaluation method | By using cyclic voltammetry (CV) (electrolyte: 0.1 M Bu₄NPF₆/solvent: dimethylforamide (DMF)/electrode: 3-electrode system (working electrode: GC, reference electrode: Ag/AgCl, and auxiliary electrode: Pt)), the potential (V)-current (A) graph of each compound was obtained, and then, from the reduction onset of the graph, the LUMO energy level of each compound was calculated. |
| Band gap evaluation method | The absolute value of the difference between HOMO energy level and LUMO energy level was calculated |
| Method of evaluating the percentage (%) of the triplet metal-to-ligand charge transfer state (³MLCT) during total intramolecular charge transfer | For each compound, quantum chemical calculation is performed using Gaussian 09, a quantum chemical calculation program manufactured by Gaussian, USA (B3LYP is used for optimization of the ground state structure, and 6-311G (d, p) is used as a function) |

**Table 2**

| | HOMO Energy level (eV) | LUMO Energy level (eV) | Band gap(eV) | Percentage of ³MLCT (%) |
|---|---|---|---|---|
| GD-1 | -5.13 | -2.21 | 2.91 | 37.8 |
| GD-2 | -5.14 | -2.28 | 2.86 | 26.3 |
| GD-3 | -5.21 | -2.33 | 2.88 | 26.4 |
| GD-4 | -5.45 | -2.54 | 2.91 | 21.1 |
| GD-5 | -5.36 | -2.56 | 2.81 | 20.0 |
| GD-6 | -5.35 | -2.56 | 2.79 | 18.6 |
| GD-7 | -5.43 | -2.52 | 2.91 | 23.0 |
| GD-8 | -5.52 | -2.68 | 2.84 | 23.5 |
| GD-9 | -4.81 | -1.84 | 2.97 | 27.6 |
| GD-10 | -5.06 | -2.1 | 2.96 | 34.9 |
| GD-11 | -4.93 | -1.97 | 2.96 | 34.7 |
| GD-12 | -4.88 | -1.97 | 2.91 | 33.5 |

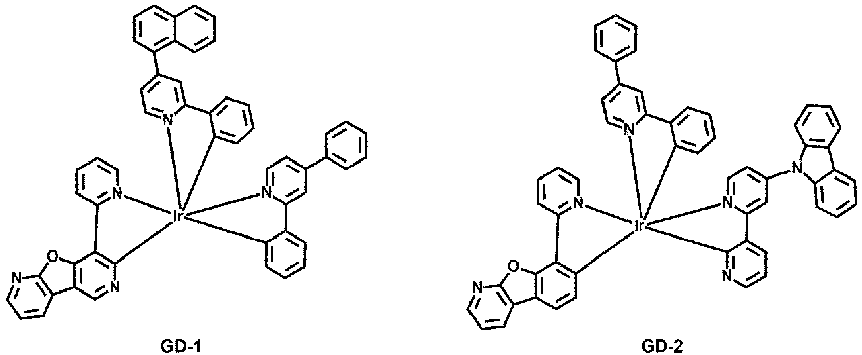

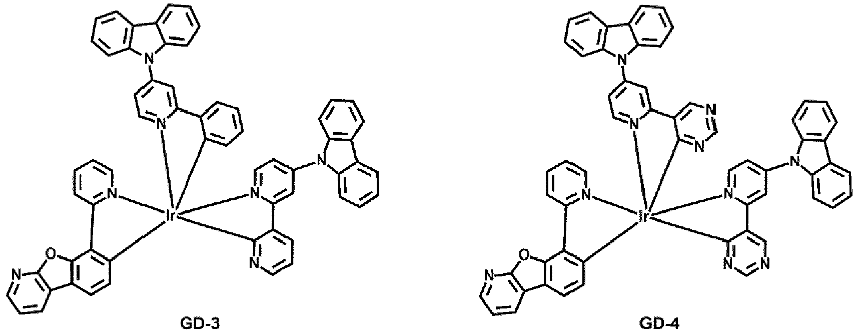

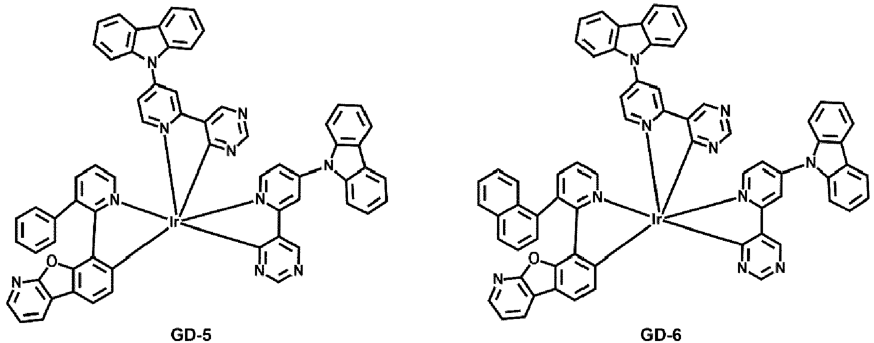

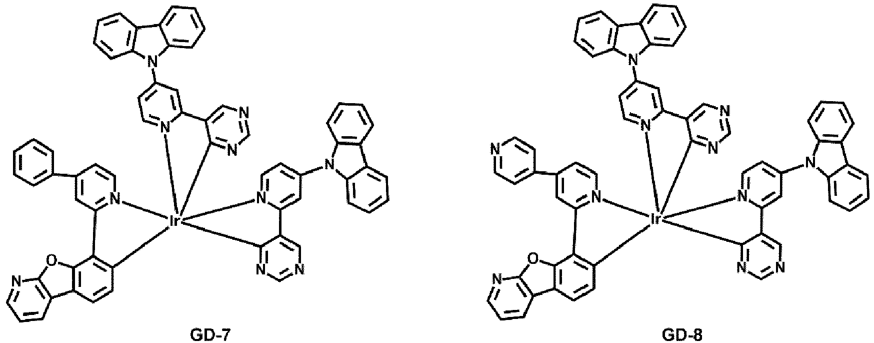

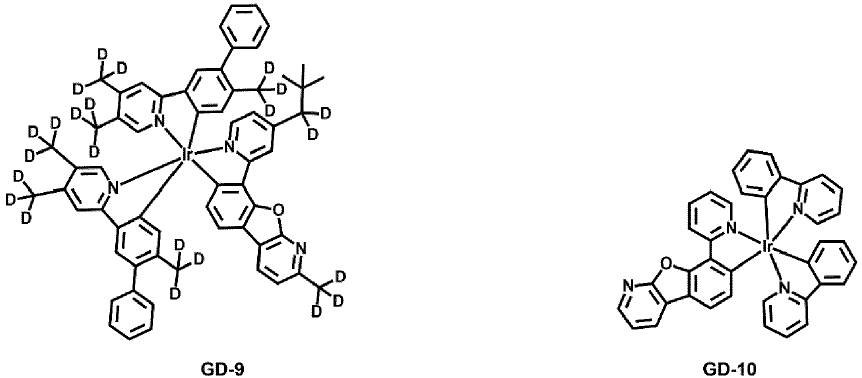

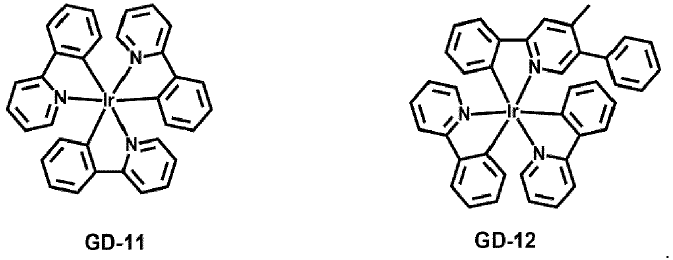

### Evaluation Example 2

PMMA and Compound GD-1 (4 wt% compared to PMMA) were mixed in CH₂Cl₂ solution, and then, the resultant obtained therefrom was coated on a quartz substrate using a spin coater, and then heat treated in an oven at 80 °C, followed by cooling to room temperature to manufacture Film GD-1 having a thickness of 40 nm. Subsequently, Films GD-2 to GD-12 were prepared using the same method as used to manufacture Film GD-1, except that each of Compounds GD-2 to GD-12 was used instead of Compound GD-1.

The emission spectrum of each of Films GD-2 to GD-12 was measured by using the quantaurus-QY absolute PL quantum yield spectrometer of Hamamatsu Inc. (equipped with a xenon light source, a monochromator, a photonic multichannel analyzer, and an integrating sphere, and using PLOY measurement software (Hamamatsu Photonics, Ltd., Shizuoka, Japan)). During measurement, the excitation wavelength was scanned from 320 nm to 380 nm at 10 nm intervals, and the spectrum measured at the excitation wavelength of 340 nm was used to obtain the maximum emission wavelength (emission peak wavelength) and FWHM of the compound included in each film. Results thereof are shown in Table 3.

**Table 3**

| Film No. | Compound included in film (4 wt% in PMMA) | Maximum emission wavelength (nm) | Emission FWHM (nm) |
|---|---|---|---|
| GD-1 | GD-1 | 537 | 58 |
| GD-2 | GD-2 | 526 | 54 |
| GD-3 | GD-3 | 526 | 55 |
| GD-4 | GD-4 | 515 | 54 |
| GD-5 | GD-5 | 560 | 83 |
| GD-6 | GD-6 | 557 | 80 |
| GD-7 | GD-7 | 525 | 56 |
| GD-8 | GD-8 | 562 | 71 |
| GD-9 | GD-9 | 534 | 55 |
| GD-10 | GD-10 | 531 | 54 |
| GD-11 | GD-11 | 516 | 62 |
| GD-12 | GD-12 | 559 | 81 |

### Evaluation Example 3

The HOMO energy level and LUMO energy level of each of Compounds ET-1 to ET-6 and PET-1 to PET-5 were evaluated in the method shown in Table 1, and results thereof are shown in Table 4.

The hole mobility and electron mobility of each of Compounds ET-1 to ET-6 and PET-1 to PET-5 were evaluated using the space-charge-limited current (SCLC) described in "Hole mobility of N,N'-bis(naphtanlen-1-yl)-N,N'-bis(phenyl)benzidine investigated by using space-charge-limited currents, 'Appl. Phys. Lett. 90, 203512 (2007)", and results obtained therefrom are shown in Table 4.

**Table 4**

| | HOMO Energy level (eV) | LUMO Energy level (eV) | Band gap(eV) | Hole mobility (cm²/Vs) | Electron mobility (cm²/Vs) |
|---|---|---|---|---|---|
| ET-1 | -6.01 | -2.67 | 3.33 | 2.44 × 10⁻⁴ | 1.16 × 10⁻³ |
| ET-2 | -5.98 | -2.69 | 3.29 | 2.70 × 10⁻⁴ | 8.16 × 10⁻⁴ |
| ET-3 | -5.94 | -2.79 | 3.16 | 1.40 × 10⁻⁴ | 3.45 × 10⁻⁴ |
| ET-4 | -5.82 | -2.67 | 3.15 | 1.90 × 10⁻⁴ | 1.56 × 10⁻⁴ |
| ET-5 | -5.86 | -2.68 | 3.19 | 8.88 × 10⁻⁵ | 3.71 × 10⁻⁴ |
| ET-6 | -6.07 | -2.81 | 3.26 | 2.40 × 10⁻⁵ | 2.41 × 10⁻⁴ |
| PET-1 | -5.35 | -2.50 | 2.85 | 1.31 × 10⁻³ | 1.07 × 10⁻³ |
| PET-2 | -6.10 | -2.57 | 3.52 | 5.34 × 10⁻⁴ | 1.00 × 10⁻³ |
| PET-3 | -5.93 | -2.57 | 3.37 | 3.32 × 10⁻⁴ | 5.88 × 10⁻⁴ |
| PET-4 | -5.89 | -2.71 | 3.18 | 3.61 × 10⁻⁶ | 9.75 × 10⁻⁴ |
| PET-5 | -5.67 | -2.38 | 3.29 | 2.35 × 10⁻⁵ | 1.20 × 10⁻³ |

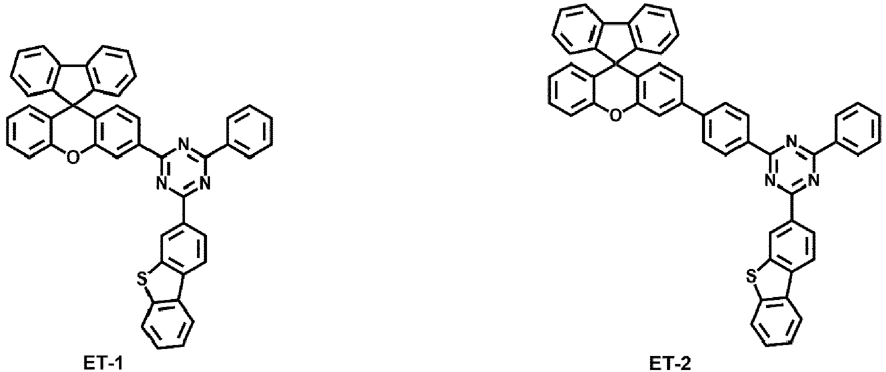

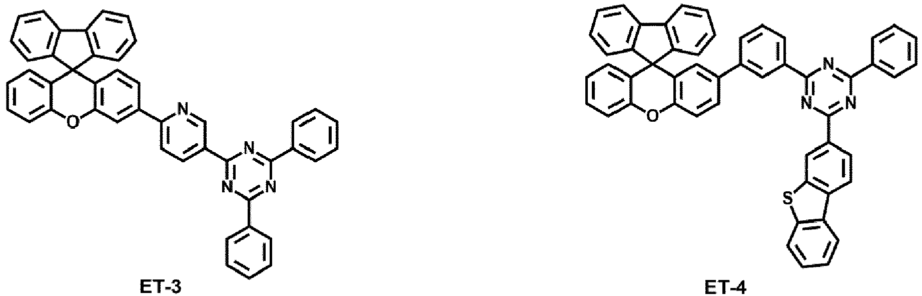

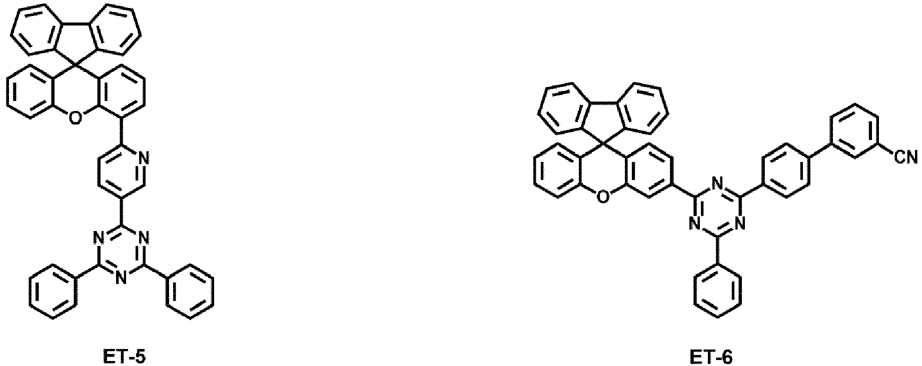

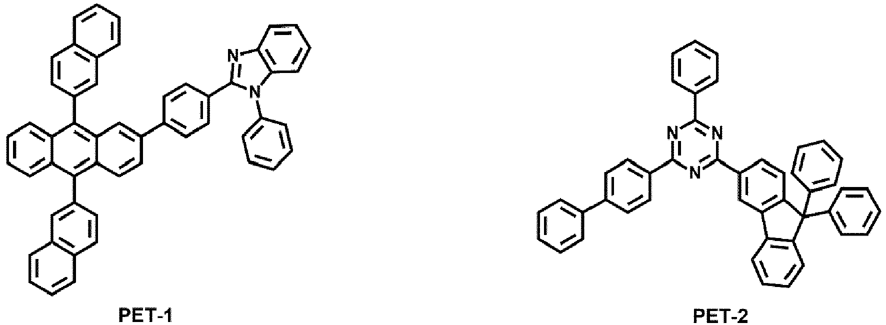

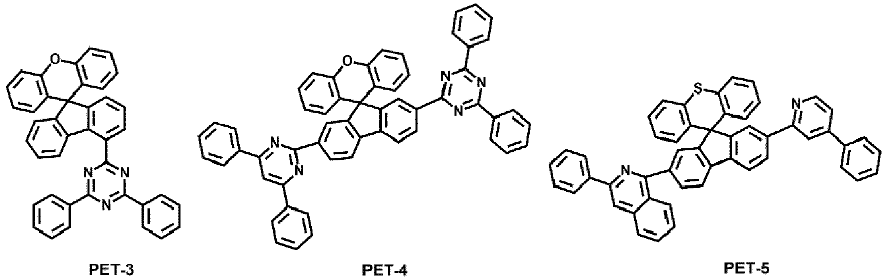

### Example 1

To manufacture an anode, a glass substrate (product of Corning Inc.) with a 15 Ω/cm² (1,200 Å) ITO formed thereon was cut to a size of 50 mm × 50 mm × 0.7 mm, sonicated by using isopropyl alcohol and pure water, each for 5 minutes, washed by irradiation of ultraviolet rays and exposure of ozone thereto for 30 minutes, and then mounted on a vacuum deposition apparatus.

Compound HT3 was vacuum-deposited on the anode to form a hole injection layer having a thickness of 600 Å, and Compound HT40 was vacuum-deposited on the hole injection layer to form an emission auxiliary layer having a thickness of 250 Å.

Compound H125, Compound H126, and Compound GD-1 (first emitter) were vacuum-deposited on the emission auxiliary layer at the weight ratio of 45 : 45 : 10 to form an emission layer having a thickness of 300 Å.

The compound ET37 was vacuum-deposited on the emission layer to form a hole-blocking layer with a thickness of 50 Å, and ET-1 and LiQ were vacuum-deposited at a weight ratio of 5: 5 on the hole-blocking layer to form an electron transport layer with a thickness of 310 Å. Subsequently, Yb was vacuum-deposited on the electron transport layer to form an electron injection layer with a thickness of 15 Å, and then Ag and Mg were vacuum-deposited to form a cathode with a thickness of 100 Å, thereby completing the manufacture of an organic light-emitting device.

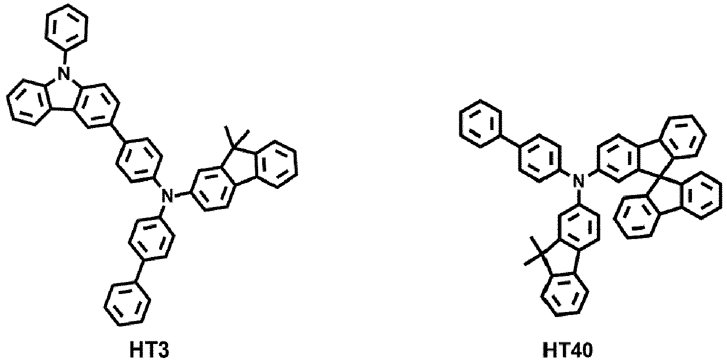

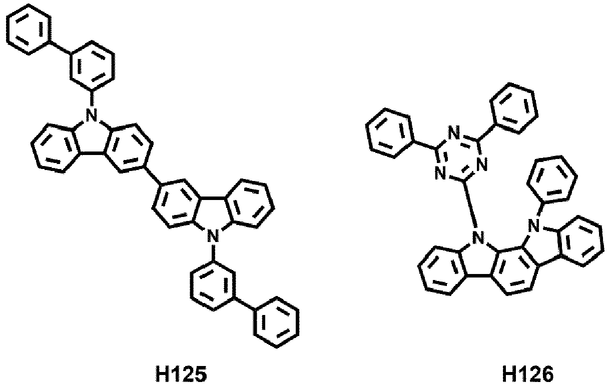

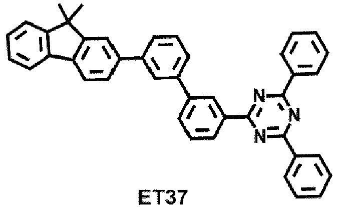

### Other Examples and Comparative Examples

The organic light-emitting devices of Examples and Comparative Examples listed in Tables 5 to 16 were manufactured in the same manner as in Example 1, except that the compounds shown in Tables 5 to 16 were used instead of Compound GD-1 in the emission layer and/or Compound ET-1 in the electron transport layer.

### Evaluation Example 4

The driving voltage (V), maximum power efficiency (cd/W) and color coordinates (ClEx and ClEy) of the organic light-emitting devices manufactured according to Examples and Comparative Examples using materials for the first emitter and the electron transport layer, were measured by using a Keithley MU 236 and a luminance meter PR650, and results thereof are shown in Tables 5 to 16.

**Table 5**

| | First emitter | Material for electron transport layer | Driving voltage (V) (at 1000 cd/m²) | Maximum power efficiency (cd/W) | CIE x | CIE y |
|---|---|---|---|---|---|---|
| Example 1 | GD-1 | ET-1 | 2.9 | 15.40 | 0.41 | 0.58 |
| Example 2 | GD-1 | ET-2 | 2.95 | 15.14 | 0.41 | 0.58 |
| Example 3 | GD-1 | ET-3 | 2.75 | 16.22 | 0.41 | 0.58 |
| Example 4 | GD-1 | ET-4 | 2.95 | 15.13 | 0.41 | 0.58 |
| Example 5 | GD-1 | ET-5 | 2.9 | 15.39 | 0.41 | 0.58 |
| Example 6 | GD-1 | ET-6 | 2.8 | 15.94 | 0.41 | 0.58 |
| Comparati ve Example 1 | GD-1 | PET-1 | 3.5 | 12.72 | 0.41 | 0.58 |
| Comparati ve Example 2 | GD-1 | PET-2 | 3.3 | 13.52 | 0.41 | 0.58 |
| Comparati ve Example 3 | GD-1 | PET-3 | 3.3 | 13.53 | 0.41 | 0.58 |
| Comparati ve Example 4 | GD-1 | PET-4 | 3.0 | 14.88 | 0.41 | 0.58 |
| Comparati ve Example 5 | GD-1 | PET-5 | 5.9 | 7.57 | 0.41 | 0.58 |

**Table 6**

| | First emitter | Material for electron transport layer | Driving voltage (V) | Power Efficiency (cd/W) | CIE x | CIE y |
|---|---|---|---|---|---|---|
| Example 11 | GD-2 | ET-1 | 2.9 | 15.15 | 0.35 | 0.63 |
| Example 12 | GD-2 | ET-2 | 2.95 | 14.90 | 0.35 | 0.63 |
| Example 13 | GD-2 | ET-3 | 2.75 | 15.96 | 0.35 | 0.63 |
| Example 14 | GD-2 | ET-4 | 2.95 | 14.89 | 0.35 | 0.63 |
| Example 15 | GD-2 | ET-5 | 2.9 | 15.15 | 0.35 | 0.63 |
| Example 16 | GD-2 | ET-6 | 2.8 | 15.69 | 0.35 | 0.63 |
| Comparati ve Example 11 | GD-2 | PET-1 | 3.5 | 12.51 | 0.35 | 0.63 |
| Comparati ve Example 12 | GD-2 | PET-2 | 3.3 | 13.31 | 0.35 | 0.63 |
| Comparati ve Example 13 | GD-2 | PET-3 | 3.3 | 13.32 | 0.35 | 0.63 |
| Comparati ve Example 14 | GD-2 | PET-4 | 3.0 | 14.65 | 0.35 | 0.63 |
| Comparati ve | GD-2 | PET-5 | 5.9 | 7.45 | 0.35 | 0.63 |
| Example 15 | | | | | | |

**Table 7**

| | First emitter | Material for electron transport layer | Driving voltage (V) | Power Efficiency (cd/W) | CIE x | CIE y |
|---|---|---|---|---|---|---|
| Example 21 | GD-3 | ET-1 | 2.9 | 15.15 | 0.35 | 0.63 |
| Example 22 | GD-3 | ET-2 | 2.95 | 14.90 | 0.35 | 0.63 |
| Example 23 | GD-3 | ET-3 | 2.75 | 15.96 | 0.35 | 0.63 |
| Example 24 | GD-3 | ET-4 | 2.95 | 14.89 | 0.35 | 0.63 |
| Example 25 | GD-3 | ET-5 | 2.9 | 15.15 | 0.35 | 0.63 |
| Example 26 | GD-3 | ET-6 | 2.8 | 15.69 | 0.35 | 0.63 |
| Comparati ve Example 21 | GD-3 | PET-1 | 3.5 | 12.51 | 0.35 | 0.63 |
| Comparati ve Example 22 | GD-3 | PET-2 | 3.3 | 13.31 | 0.35 | 0.63 |
| Comparati ve Example 23 | GD-3 | PET-3 | 3.3 | 13.32 | 0.35 | 0.63 |
| Comparati ve Example 24 | GD-3 | PET-4 | 3.0 | 14.65 | 0.35 | 0.63 |
| Comparati ve Example 25 | GD-3 | PET-5 | 5.9 | 7.45 | 0.35 | 0.63 |

**Table 8**

| | First emitter | Material for electron transport layer | Driving voltage (V) | Power Efficiency (cd/W) | CIE x | CIE y |
|---|---|---|---|---|---|---|
| Example 31 | GD-4 | ET-1 | 2.9 | 14.91 | 0.31 | 0.65 |
| Example 32 | GD-4 | ET-2 | 2.95 | 14.65 | 0.31 | 0.65 |
| Example 33 | GD-4 | ET-3 | 2.75 | 15.70 | 0.31 | 0.65 |
| Example 34 | GD-4 | ET-4 | 2.95 | 14.65 | 0.31 | 0.65 |
| Example 35 | GD-4 | ET-5 | 2.9 | 14.90 | 0.31 | 0.65 |
| Example 36 | GD-4 | ET-6 | 2.8 | 15.43 | 0.31 | 0.65 |
| Comparati ve Example 31 | GD-4 | PET-1 | 3.5 | 12.31 | 0.31 | 0.65 |
| Comparati ve Example 32 | GD-4 | PET-2 | 3.3 | 13.09 | 0.31 | 0.65 |
| Comparati ve Example 33 | GD-4 | PET-3 | 3.3 | 13.10 | 0.31 | 0.65 |
| Comparati ve Example 34 | GD-4 | PET-4 | 3.0 | 14.41 | 0.31 | 0.65 |
| Comparati ve Example 35 | GD-4 | PET-5 | 5.9 | 7.32 | 0.31 | 0.65 |

**Table 9**

| | First emitter | Material for electron transport layer | Driving voltage (V) | Power Efficiency (cd/W) | CIE x | CIE y |
|---|---|---|---|---|---|---|
| Example 41 | GD-5 | ET-1 | 2.9 | 14.83 | 0.48 | 0.51 |
| Example 42 | GD-5 | ET-2 | 2.95 | 14.58 | 0.48 | 0.51 |
| Example 43 | GD-5 | ET-3 | 2.75 | 15.63 | 0.48 | 0.51 |
| Example 44 | GD-5 | ET-4 | 2.95 | 14.58 | 0.48 | 0.51 |
| Example 45 | GD-5 | ET-5 | 2.9 | 14.83 | 0.48 | 0.51 |
| Example 46 | GD-5 | ET-6 | 2.8 | 15.36 | 0.48 | 0.51 |
| Comparati ve Example 41 | GD-5 | PET-1 | 3.5 | 12.25 | 0.48 | 0.51 |
| Comparati ve Example 42 | GD-5 | PET-2 | 3.3 | 13.02 | 0.48 | 0.51 |
| Comparati ve Example 43 | GD-5 | PET-3 | 3.3 | 13.04 | 0.48 | 0.51 |
| Comparati ve Example 44 | GD-5 | PET-4 | 3.0 | 14.34 | 0.48 | 0.51 |
| Comparati ve Example 45 | GD-5 | PET-5 | 5.9 | 7.29 | 0.48 | 0.51 |

**Table 10**

| | First emitter | Material for electron transport layer | Driving voltage (V) | Power Efficiency (cd/W) | CIE x | CIE y |
|---|---|---|---|---|---|---|
| Example 51 | GD-6 | ET-1 | 2.9 | 14.71 | 0.47 | 0.52 |
| Example 52 | GD-6 | ET-2 | 2.95 | 14.46 | 0.47 | 0.52 |
| Example 53 | GD-6 | ET-3 | 2.75 | 15.50 | 0.47 | 0.52 |
| Example 54 | GD-6 | ET-4 | 2.95 | 14.46 | 0.47 | 0.52 |
| Example 55 | GD-6 | ET-5 | 2.9 | 14.71 | 0.47 | 0.52 |
| Example 56 | GD-6 | ET-6 | 2.8 | 15.23 | 0.47 | 0.52 |
| Comparati ve Example 51 | GD-6 | PET-1 | 3.5 | 12.15 | 0.47 | 0.52 |
| Comparati ve Example 52 | GD-6 | PET-2 | 3.3 | 12.92 | 0.47 | 0.52 |
| Comparati ve Example 53 | GD-6 | PET-3 | 3.3 | 12.93 | 0.47 | 0.52 |
| Comparati ve Example 54 | GD-6 | PET-4 | 3.0 | 14.22 | 0.47 | 0.52 |
| Comparati ve Example 55 | GD-6 | PET-5 | 5.9 | 7.23 | 0.47 | 0.52 |

**Table 11**

| | First emitter | Material for electron transport layer | Driving voltage (V) | Power Efficiency (cd/W) | CIE x | CIE y |
|---|---|---|---|---|---|---|
| Example 61 | GD-7 | ET-1 | 2.9 | 15.02 | 0.34 | 0.64 |
| Example 62 | GD-7 | ET-2 | 2.95 | 14.76 | 0.34 | 0.64 |
| Example 63 | GD-7 | ET-3 | 2.75 | 15.82 | 0.34 | 0.64 |
| Example 64 | GD-7 | ET-4 | 2.95 | 14.75 | 0.34 | 0.64 |
| Example 65 | GD-7 | ET-5 | 2.9 | 15.01 | 0.34 | 0.64 |
| Example 66 | GD-7 | ET-6 | 2.8 | 15.54 | 0.34 | 0.64 |
| Comparati ve Example 61 | GD-7 | PET-1 | 3.5 | 12.40 | 0.34 | 0.64 |
| Comparati ve Example 62 | GD-7 | PET-2 | 3.3 | 13.18 | 0.34 | 0.64 |
| Comparati ve Example 63 | GD-7 | PET-3 | 3.3 | 13.20 | 0.34 | 0.64 |
| Comparati ve Example 64 | GD-7 | PET-4 | 3.0 | 14.51 | 0.34 | 0.64 |
| Comparati ve Example 65 | GD-7 | PET-5 | 5.9 | 7.38 | 0.34 | 0.64 |

**Table 12**

| | First emitter | Material for electron transport layer | Driving voltage (V) | Power Efficiency (cd/W) | CIE x | CIE y |
|---|---|---|---|---|---|---|
| Example 71 | GD-8 | ET-1 | 2.9 | 15.04 | 0.48 | 0.51 |
| Example 72 | GD-8 | ET-2 | 2.95 | 14.78 | 0.48 | 0.51 |
| Example 73 | GD-8 | ET-3 | 2.75 | 15.84 | 0.48 | 0.51 |
| Example 74 | GD-8 | ET-4 | 2.95 | 14.77 | 0.48 | 0.51 |
| Example 75 | GD-8 | ET-5 | 2.9 | 15.03 | 0.48 | 0.51 |
| Example 76 | GD-8 | ET-6 | 2.8 | 15.57 | 0.48 | 0.51 |
| Comparati ve Example 71 | GD-8 | PET-1 | 3.5 | 12.42 | 0.48 | 0.51 |
| Comparati ve Example 72 | GD-8 | PET-2 | 3.3 | 13.20 | 0.48 | 0.51 |
| Comparati ve Example 73 | GD-8 | PET-3 | 3.3 | 13.21 | 0.48 | 0.51 |
| Comparati ve Example 74 | GD-8 | PET-4 | 3.0 | 14.53 | 0.48 | 0.51 |
| Comparati ve Example 75 | GD-8 | PET-5 | 5.9 | 7.39 | 0.48 | 0.51 |

**Table 13**

| | First emitter | Material for electron transport layer | Driving voltage (V) | Power Efficiency (cd/W) | CIE x | CIE y |
|---|---|---|---|---|---|---|
| Example 81 | GD-9 | ET-1 | 2.9 | 15.19 | 0.38 | 0.61 |
| Example 82 | GD-9 | ET-2 | 2.95 | 14.94 | 0.38 | 0.61 |
| Example 83 | GD-9 | ET-3 | 2.75 | 16.00 | 0.38 | 0.61 |
| Example 84 | GD-9 | ET-4 | 2.95 | 14.93 | 0.38 | 0.61 |
| Example 85 | GD-9 | ET-5 | 2.9 | 15.19 | 0.38 | 0.61 |
| Example 86 | GD-9 | ET-6 | 2.8 | 15.73 | 0.38 | 0.61 |
| Comparati ve Example 81 | GD-9 | PET-1 | 3.5 | 12.55 | 0.38 | 0.61 |
| Comparati ve Example 82 | GD-9 | PET-2 | 3.3 | 13.34 | 0.38 | 0.61 |
| Comparati ve Example 83 | GD-9 | PET-3 | 3.3 | 13.35 | 0.38 | 0.61 |
| Comparati ve Example 84m | GD-9 | PET-4 | 3.0 | 14.69 | 0.38 | 0.61 |
| Comparati ve Example 85 | GD-9 | PET-5 | 5.9 | 7.46 | 0.38 | 0.61 |

**Table 14**

| | First emitter | Material for electron transport layer | Driving voltage (V) | Power Efficiency (cd/W) | CIE x | ClEy |
|---|---|---|---|---|---|---|
| Example 91 | GD-10 | ET-1 | 2.9 | 15.36 | 0.37 | 0.62 |
| Example 92 | GD-10 | ET-2 | 2.95 | 15.09 | 0.37 | 0.62 |
| Example 93 | GD-10 | ET-3 | 2.75 | 16.17 | 0.37 | 0.62 |
| Example 94 | GD-10 | ET-4 | 2.95 | 15.09 | 0.37 | 0.62 |
| Example 95 | GD-10 | ET-5 | 2.9 | 15.35 | 0.37 | 0.62 |
| Example 96 | GD-10 | ET-6 | 2.8 | 15.90 | 0.37 | 0.62 |
| Comparati ve Example 91 | GD-10 | PET-1 | 3.5 | 12.68 | 0.37 | 0.62 |
| Comparati ve Example 92 | GD-10 | PET-2 | 3.3 | 13.48 | 0.37 | 0.62 |
| Comparati ve Example 93 | GD-10 | PET-3 | 3.3 | 13.49 | 0.37 | 0.62 |
| Comparati ve Example 94 | GD-10 | PET-4 | 3.0 | 14.84 | 0.37 | 0.62 |
| Comparati ve Example 95 | GD-10 | PET-5 | 5.9 | 7.54 | 0.37 | 0.62 |

**Table 15**

| | First emitter | Material for electron transport layer | Driving voltage (V) | Power Efficiency (cd/W) | CIE x | CIE y |
|---|---|---|---|---|---|---|
| Example 101 | GD-11 | ET-1 | 2.9 | 15.35 | 0.31 | 0.64 |
| Example 102 | GD-11 | ET-2 | 2.95 | 15.09 | 0.31 | 0.64 |
| Example 103 | GD-11 | ET-3 | 2.75 | 16.17 | 0.31 | 0.64 |
| Example 104 | GD-11 | ET-4 | 2.95 | 15.08 | 0.31 | 0.64 |
| Example 105 | GD-11 | ET-5 | 2.90 | 15.35 | 0.31 | 0.64 |
| Example 106 | GD-11 | ET-6 | 2.80 | 15.89 | 0.31 | 0.64 |
| Comparativ e Example 101 | GD-11 | PET-1 | 3.5 | 12.68 | 0.31 | 0.64 |
| Comparativ e Example 102 | GD-11 | PET-2 | 3.3 | 13.48 | 0.31 | 0.64 |
| Comparativ e Example 103 | GD-11 | PET-3 | 3.3 | 13.49 | 0.31 | 0.64 |
| Comparativ e Example 104 | GD-11 | PET-4 | 3.0 | 14.84 | 0.31 | 0.64 |
| Comparativ e Example 105 | GD-11 | PET-5 | 5.9 | 7.54 | 0.31 | 0.64 |

**Table 16**

| | First emitter | Material for electron transport layer | Driving voltage (V) | Power efficiency (cd/W) | CIE x | CIE y |
|---|---|---|---|---|---|---|
| Example 111 | GD-12 | ET-1 | 2.9 | 15.33 | 0.49 | 0.51 |
| Example 112 | GD-12 | ET-2 | 2.95 | 15.07 | 0.49 | 0.51 |
| Example 113 | GD-12 | ET-3 | 2.75 | 16.15 | 0.49 | 0.51 |
| Example 114 | GD-12 | ET-4 | 2.95 | 15.06 | 0.49 | 0.51 |
| Example 115 | GD-12 | ET-5 | 2.9 | 15.33 | 0.49 | 0.51 |
| Example 116 | GD-12 | ET-6 | 2.8 | 15.87 | 0.49 | 0.51 |
| Comparativ e Example 111 | GD-12 | PET-1 | 3.5 | 12.68 | 0.49 | 0.51 |
| Comparativ e Example 112 | GD-12 | PET-2 | 3.3 | 13.48 | 0.49 | 0.51 |
| Comparativ e Example 113 | GD-12 | PET-3 | 3.3 | 13.49 | 0.49 | 0.51 |
| Comparativ e Example 114 | GD-12 | PET-4 | 3.0 | 14.82 | 0.49 | 0.51 |
| Comparativ e Example 115 | GD-12 | PET-5 | 5.9 | 7.53 | 0.49 | 0.51 |

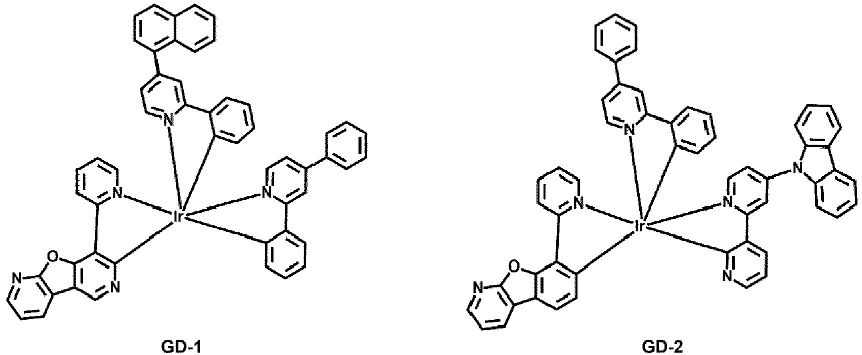

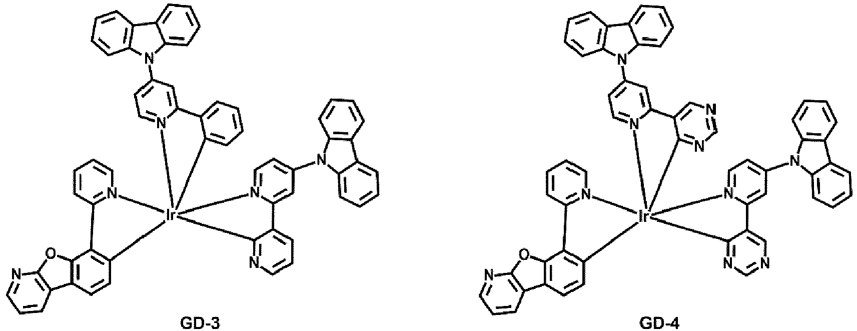

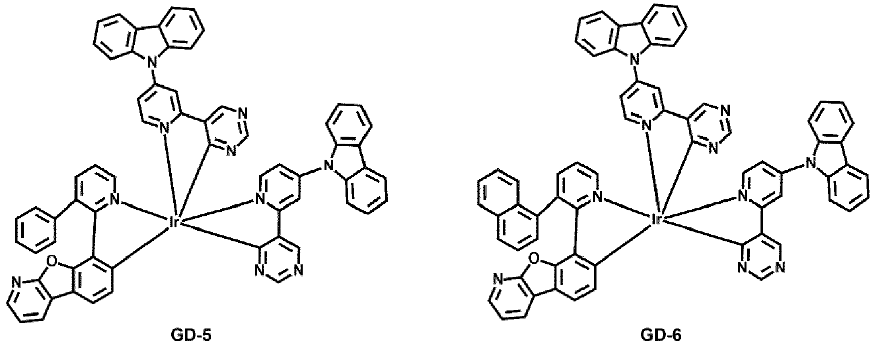

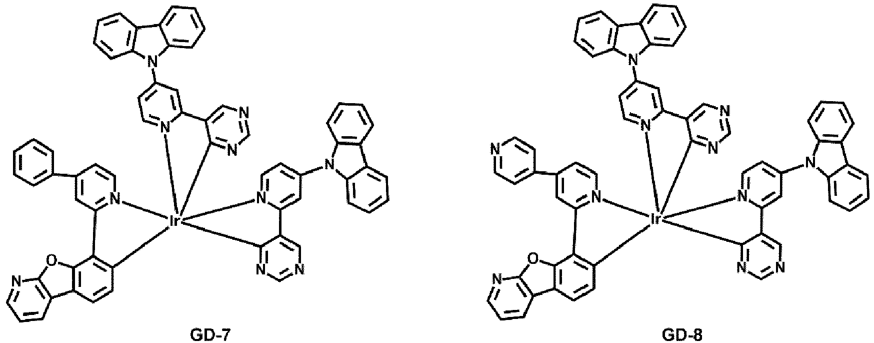

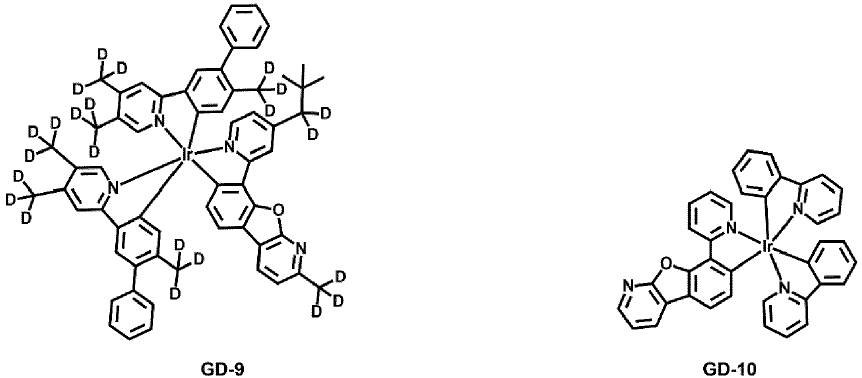

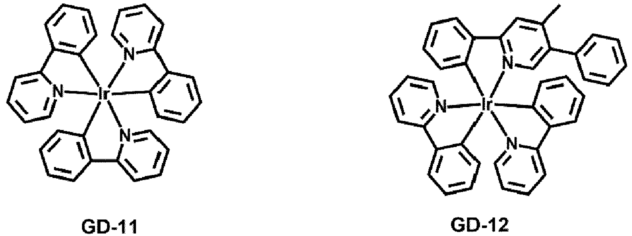

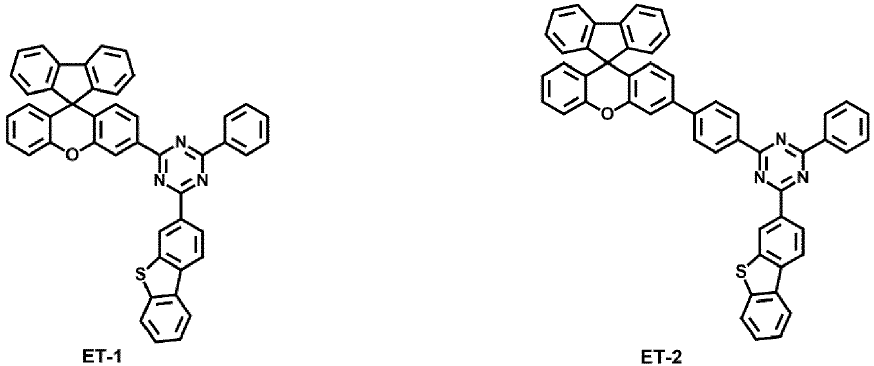

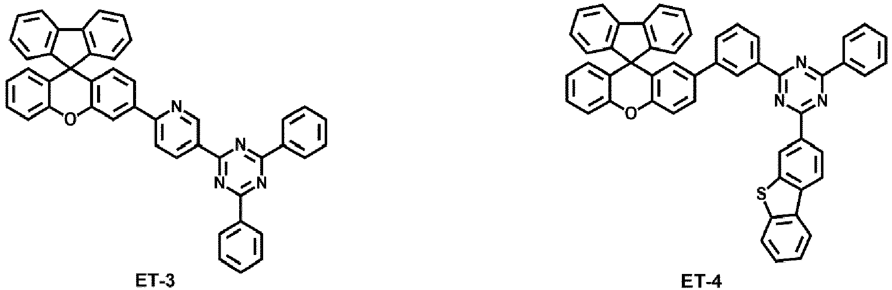

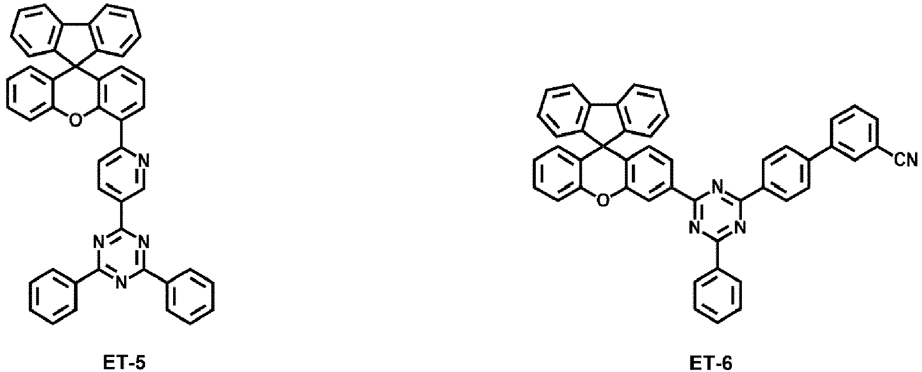

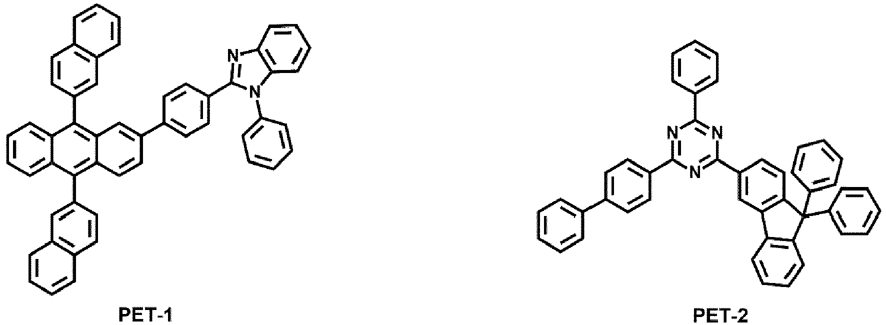

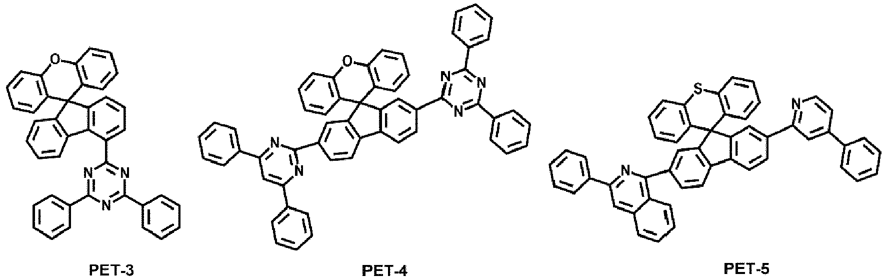

From Tables 5 to 16, it can be confirmed that the light-emitting devices manufactured in Examples have lower driving voltage and higher maximum power efficiency than the light-emitting devices manufactured in Comparative Examples.

According to the one or more embodiments, a light-emitting device may have a low driving voltage and high power efficiency. Accordingly, the light-emitting device may enable the manufacture of a high-quality electronic device and a high-quality consumer product.

It should be understood that embodiments described herein should be considered in a descriptive sense only and not for purposes of limitation. Descriptions of features or aspects within each embodiment should typically be considered as available for other similar features or aspects in other embodiments.

## Claims

1. A light-emitting device (10) comprising:
a first electrode (110);
a second electrode (150) facing the first electrode (110);
an interlayer (130) located between the first electrode (110) and the second electrode (150),
wherein the interlayer (130) comprises an emission layer and an electron transport region,
the electron transport region is located between the emission layer and the second electrode,
the emission layer comprises a first emitter,
the first emitter emits first light having a first emission spectrum,
the first emitter comprises iridium,
the first emitter comprises a first ligand, a second ligand, and a third ligand, each of which is bonded to the iridium,
the first ligand is a bidentate ligand comprising Y₁-containing ring B₁ and Y₂-containing ring B₂,
the second ligand is a bidentate ligand comprising Y₃-containing ring B₃ and Y₄-containing ring B₄,
the third ligand is a bidentate ligand comprising Y₅-containing ring B₅ and Y₆-containing ring B₆,
each of Y₁, Y₃, and Y₅ is nitrogen (N),
each of Y₂, Y₄, and Y₆ is carbon (C),
the electron transport region comprises a heterocyclic compound, and
the heterocyclic compound comprises:
a first moiety comprising a group represented by one of Formulae 8-1 to 8-4; and
a second moiety comprising a diazine group, a triazine group, or a combination thereof;
wherein
the first moiety and the second moiety are linked to each other through a single bond or a first linking group: 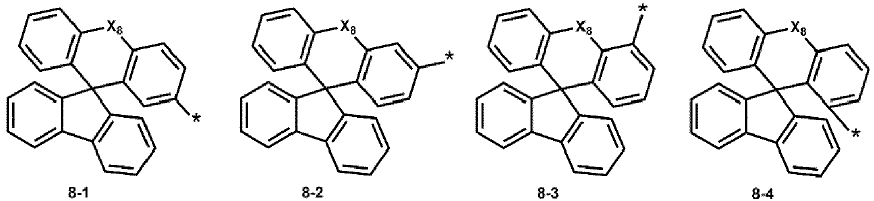
wherein, in Formulae 8-1 to 8-4,
X₈ is O, S, or Se, and
* indicates a binding site to a single bond bonded to the second moiety or a first linking group bonded to the second moiety.

2. The light-emitting device of claim 1, wherein an emission peak wavelength of the first light is 510 nm to 570 nm.

3. The light-emitting device of claim 1 or 2, wherein a full width at half maximum of the first light is 15 nm to 85 nm.

4. The light-emitting device of any one of the preceding claims, wherein
the first light is green light.

5. The light-emitting device of any one of the preceding claims, wherein the Y₂-containing ring B₂ is a polycyclic group.

6. The light-emitting device of any one of the preceding claims, wherein the first emitter is a heteroleptic complex.

7. The light-emitting device of any one of the preceding claims, wherein the third ligand is the same as the second ligand.

8. The light-emitting device of any one of claims 1 to 6, wherein the third ligand is the same as the first ligand.

9. The light-emitting device of any one of claims 1 to 6, wherein the third ligand is different from each of the first ligand and the second ligand.

10. The light-emitting device of any one of the preceding claims, wherein the electron transport region comprises an electron transport layer, and the heterocyclic compound is comprised in the electron transport layer.

11. The light-emitting device of claim 10, wherein
the electron transport layer is in direct contact with the emission layer.

12. The light-emitting device of any one of claims 1 to 9, wherein
the electron transport region comprises a hole-blocking layer and an electron transport layer,
the hole-blocking layer is located between the emission layer and the electron transport layer,
the hole-blocking layer does not comprise the heterocyclic compound, and
the heterocyclic compound is comprised in the electron transport layer.

13. The light-emitting device of any one of the preceding claims, wherein
the heterocyclic compound is a compound represented by Formula 8: 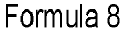 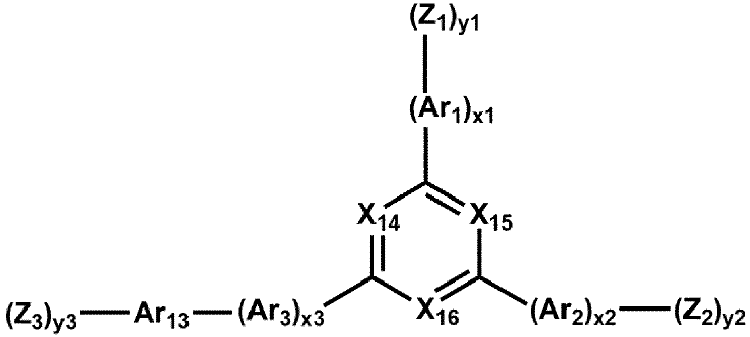
wherein, in Formula 8,
X₁₄ is N or C(Z₄), X₁₅ is N or C(Z₅), and X₁₆ is N or C(Z₆),
two or all of X₁₄ to X₁₆ are each N,
Ar₁ to Ar₃ are each independently a C₃-C₆₀ carbocyclic group unsubstituted or substituted with R₁₀ₐ, or a C₁-C₆₀ heterocyclic group unsubstituted or substituted with R₁₀ₐ,
x1 to x3 are each independently one of an integer from 0 to 10,
i) when x1 is 0, *-(Ar₁)ₓ₁-*' is a single bond, ii) when x2 is 0, *-(Ar₂)ₓ₂-*' is a single bond, and iii) when x3 is 0, *-(Ar₃)ₓ₃-*' is a single bond, each of * and *' indicates a binding site to a neighboring atom,
Ar₁₃ is a group represented by one of Formulae 8-1 to 8-4,
Z₁ to Z₆ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂),
y1 to y3 are each independently an integer from 0 to 5, and
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), -P(=O)(Q₁₁)(Q₁₂), or a combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇₋C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or a combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
wherein Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or a combination thereof, 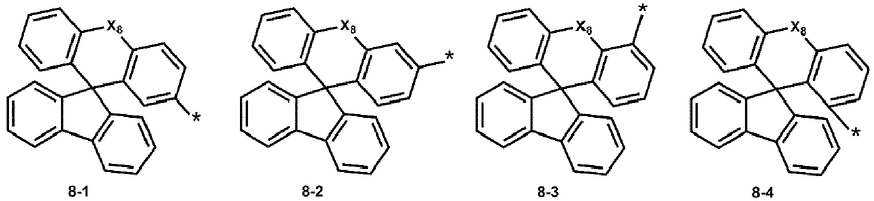
wherein, in Formulae 8-1 to 8-4,
X₈ is O, S, or Se, and
* indicates a binding site to Ar₃ in Formula 8.

14. The light-emitting device of claim 13, wherein at least one of x1 and x2 is 2 or more.

15. The light-emitting device of claim 13 or 14, wherein
x1 and x2 are each independently an integer from 0 to 10,
x3 is 0, 1, or 2, and
Ar₁ to Ar₃ are each independently a benzene group, a naphthalene group, a phenanthrene group, an anthracene group, a dibenzofuran group, a dibenzothiophene group, a carbazole group, a fluorene group, or a pyridine group, each unsubstituted or substituted with at least one R₁₀ₐ.

16. The light-emitting device of any one of claims 13 to 15, wherein
at least one of Ar₁(s) in the number of x1, at least one of Ar₂(s) in the number of x2, or a combination thereof is each independently a dibenzofuran group, a dibenzothiophene group, a carbazole group, a fluorene group, or a pyridine group, each unsubstituted or substituted with R₁₀ₐ.

17. An electronic device comprising the light-emitting device of any one of claims 1 to 16.

18. The electronic device of claim 17, further comprising:
a color filter, a color conversion layer, a touch screen layer, a polarizing layer, or a combination thereof.

19. An electronic apparatus comprising the light-emitting device of any one of claims 1 to 16.

20. The electronic apparatus of claim 19, wherein
the electronic apparatus is one of a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant (PDA), a wearable device, a laptop computer, a digital camera, a camcorder, a viewfinder, a micro display, a three-dimensional (3D) display, a virtual reality or augmented reality display, a vehicle, a video wall with multiple displays tiled together, a theater or stadium screen, a phototherapy device, and a signboard.
